# EUROPEAN PATENT APPLICATION

(11) **EP 4 675 624 A1**
(43) Date of publication of application: **07.01.2026**
(21) Application number: 24217106.4
(22) Date of filing: 03.12.2024
(51) Int. Cl.: G11C 7/12, G11C 7/18, G11C 16/04, G11C 16/24, H10B 41/47, H10B 41/48

(54) **NON-VOLATILE SEMICONDUCTOR MEMORY DEVICE**

(30) Priority: 01.07.2024 JP 2024106265
(71) Applicant: Kioxia Corporation, Tokyo 108-0023 (JP)
(72) Inventor: Takashima, Daisaburo, Tokyo, 108-0023 (JP)
(74) Representative: Hoffmann Eitle

(57) **Abstract**

According to one embodiment, a non-volatile semiconductor memory device includes a plurality of first interconnect layers stacked apart from each other, a memory pillar passing through the plurality of first interconnect layers, a local bit line electrically coupled to the memory pillar, a bit line, a plurality of second interconnect layers stacked apart from each other, a first pillar passing through the plurality of second interconnect layers and electrically coupled to the local bit line, a second pillar passing through the plurality of second interconnect layers and electrically coupled to the bit line and the first pillar, a plurality of third interconnect layers stacked apart from each other, and a third pillar passing through the plurality of third interconnect layers and electrically coupled to the bit line. At least one of the plurality of third interconnect layers is electrically coupled to the local bit line.

## Description

### CROSS-REFERENCE TO RELATED APPLICATIONS

This application is based upon and claims the benefit of priority from Japanese Patent Application No. 2024-106265.

### FIELD

Embodiments described herein relate generally to a non-volatile semiconductor memory device.

### BACKGROUND

One type of non-volatile semiconductor memory device known is three-dimensional stacked NAND flash memory in which memory cells are arranged in a three-dimensional structure.

### BRIEF DESCRIPTION OF DRAWINGS

FIG. 1 is an equivalent circuit diagram of a gain block according to a first embodiment.
FIG. 2 is a block diagram illustrating an example of a configuration of a memory cell array according to the first embodiment.
FIG. 3 is a cross-sectional view of the gain block in a bit line direction according to the first embodiment.
FIG. 4 is a plan view illustrating an example of a planar layout of a write port block according to the first embodiment.
FIG. 5A is a plan view illustrating a first example of a planar layout of a read port block according to the first embodiment.
FIG. 5B is a plan view illustrating a second example of a planar layout of the read port block according to the first embodiment.
FIG. 6A is a cross-sectional view of the write port block taken along lines A1-A2 and B1-B2 in FIG. 4.
FIG. 6B is a cross-sectional view of the read port block taken along lines C1-C2 and D1-D2 in FIG. 5A.
FIG. 7A is a layout diagram illustrating an example of a chip configuration of a non-volatile semiconductor memory device according to the first embodiment.
FIG. 7B is a cross-sectional view of a WL terrace corresponding to a cell block according to the first embodiment.
FIG. 7C is a diagram illustrating an example of bonding an array chip and a CMOS chip in the non-volatile semiconductor memory device according to the first embodiment.
FIG. 7D is a diagram illustrating an example of a cross-sectional configuration of a memory cell array process layer and a transistor portion below it in the non-volatile semiconductor memory device according to the first embodiment.
FIG. 8 is a graph illustrating a relationship among the number of gain blocks (the number of bit line divisions) per bit line layer of the memory cell array, the number of stacked word lines that can be stacked, and a proportion of overhead for the memory cell array due to the gain block.
FIG. 9 is a diagram illustrating a comparison of chip sizes between a comparative example and a present example in a case where a processing speed is increased by four times.
FIG. 10 is a diagram illustrating a comparison of chip sizes between a comparative example and a present example in a case where a memory capacity is increased by four times.
FIG. 11 is a diagram illustrating a relationship among the number of gain blocks per bit line layer of the memory cell array, (a) read latency (tR), and (b) chip size.
FIG. 12 is a diagram illustrating a relationship between a memory capacity and a chip size under constant speed conditions in a case where word lines of 3D-NAND flash memory are stacked to increase memory capacity.
FIG. 13 is a diagram illustrating a relationship between a memory capacity and a cost per gigabyte (GB) in a case where the memory capacity is increased by stacking word lines of the 3D-NAND flash memory.
FIG. 14A is a plan view illustrating a first example of a planar layout of a read port block according to a second embodiment.
FIG. 14B is a plan view illustrating a second example of a planar layout of the read port block according to the second embodiment.
FIG. 14C is a cross-sectional view of the read port block in the bit line direction according to the second embodiment.
FIG. 15 is an equivalent circuit diagram of a gain block according to a third embodiment.
FIG. 16 is a cross-sectional view of the gain block in the bit line direction according to the third embodiment.
FIG. 17A is a cross-sectional view of a write port block in a word line direction according to the third embodiment.
FIG. 17B is a cross-sectional view of a read port block in the word line direction according to the third embodiment.
FIG. 18 is an equivalent circuit diagram of a gain block according to a fourth embodiment.
FIG. 19 is a cross-sectional view of the gain block in the bit line direction according to the fourth embodiment.
FIG. 20A is a cross-sectional view of a write port block in the word line direction according to the fourth embodiment.
FIG. 20B is a cross-sectional view of a read port block in the word line direction according to the fourth embodiment.
FIG. 21A is a simplified equivalent circuit diagram of a gain block according to a fifth embodiment.
FIG. 21B is a timing chart illustrating an example of a voltage of each interconnect during a write operation of a non-volatile semiconductor memory device according to the fifth embodiment.
FIG. 21C is a timing chart illustrating an example of the voltage of each interconnect during the read operation of the non-volatile semiconductor memory device according to the fifth embodiment.
FIG. 22A is a timing chart illustrating an example of a voltage of each interconnect in a case of performing a read operation in which coupling noise between local bit lines is reduced in a non-volatile semiconductor memory device according to a sixth embodiment.
FIG. 22B is a cross-sectional view illustrating an example of a cross-sectional structure that reduces coupling noise between local bit lines in the non-volatile semiconductor memory device according to the sixth embodiment.
FIG. 23 is a plan view illustrating an example of a planar layout of a write port block according to the sixth embodiment.
FIG. 24 is a timing chart illustrating an example of a voltage of each interconnect in a case of performing a read operation in which coupling noise between local bit lines is reduced in a non-volatile semiconductor memory device according to a seventh embodiment.
FIG. 25A is a timing chart illustrating an example of a method to measure a threshold voltage of an amplification transistor according to an eighth embodiment.
FIG. 25B is a timing chart illustrating a method to increase the threshold voltage of the amplification transistor according to the eighth embodiment.
FIG. 25C is a timing chart illustrating a method to decrease the threshold voltage of the amplification transistor according to the eighth embodiment.
FIG. 26A is a timing chart illustrating a first example of a method to increase the threshold voltage of an amplification transistor according to a ninth embodiment.
FIG. 26B is a timing chart illustrating a second example of a method to increase the threshold voltage of the amplification transistor according to the ninth embodiment.
FIG. 27A is a timing chart illustrating a method to increase the threshold voltage of the amplification transistor according to a tenth embodiment.
FIG. 27B is a timing chart illustrating a method to decrease the threshold voltage of the amplification transistor according to the tenth embodiment.
FIG. 28A is a plan view illustrating a first example of a planar layout of a read port block according to an eleventh embodiment.
FIG. 28B is a plan view illustrating a second example of a planar layout of a read port block according to the eleventh embodiment.
FIG. 29 is a cross-sectional view of a gain block in the bit line direction according to a twelfth embodiment.
FIG. 30 is a cross-sectional view of a gain block in the bit line direction according to a thirteenth embodiment.
FIG. 31 is a diagram illustrating an example of a cross-sectional structure in the bit line direction of a gain block in an array chip included in a non-volatile semiconductor memory device and an example of a circuit configuration of a CMOS chip coupled to a local bit line, according to a fourteenth embodiment.
FIG. 32A is a cross-sectional view of a memory cell array applicable to an embodiment.
FIG. 32B is a cross-sectional view taken along a line E1-E2 in FIG. 32A.
FIG. 32C is a plan view illustrating a first example of a planar layout of a memory cell array applicable to an embodiment.
FIG. 32D is a plan view illustrating a second example of a planar layout of a memory cell array applicable to an embodiment.
FIG. 33A is a graph illustrating a comparison between a comparative example and a present example of mobilities in silicon required in a case where the number of stacked word lines in 3D-NAND flash memory is increased.
FIG. 33B is a circuit diagram illustrating an example of a circuit configuration of a memory cell string used in the calculation of FIG. 33A.

### DETAILED DESCRIPTION

In general, according to one embodiment, a non-volatile semiconductor memory device includes a plurality of first interconnect layers extending in a first direction and stacked apart from each other in a second direction intersecting the first direction, a memory pillar extending in the second direction and passing through the plurality of first interconnect layers, a local bit line provided apart from the plurality of first interconnect layers at one end side in the second direction of the plurality of first interconnect layers, extending in a third direction intersecting the first direction and the second direction, and electrically coupled to the memory pillar at the one end side in the second direction of the memory pillar, a bit line provided apart from the local bit line at the one end side in the second direction of the local bit line and extending in the third direction, a plurality of second interconnect layers extending in the first direction, stacked apart from each other in the second direction, and arranged side by side with the plurality of first interconnect layers in the third direction, a first pillar extending in the second direction, passing through the plurality of second interconnect layers, and electrically coupled to the local bit line at the one end side in the second direction, a second pillar extending in the second direction and passing through the plurality of second interconnect layers, the second pillar being electrically coupled to the bit line at the one end in the second direction and being electrically coupled to the first pillar, a plurality of third interconnect layers extending in the first direction, stacked apart from each other in the second direction, and arranged side by side with the plurality of first interconnect layers in the third direction, and a third pillar extending in the second direction, passing through the plurality of third interconnect layers, and electrically coupled to the bit line at the one end in the second direction. At least one of the plurality of third interconnect layers is electrically coupled to the local bit line.

The following describes embodiments with reference to the drawings. Moreover, in the following description, components with the same function and configuration are denoted by common reference numerals. In addition, in a case where multiple components with common reference numerals are to be distinguished, subscripts are added to the common reference numerals for differentiation. Moreover, in a case where it is not necessary to particularly distinguish between multiple components, only the common reference numerals are used for the multiple components, and no subscript is added. The subscripts herein are not limited to a subscript or a superscript but includes, for example, a lowercase letter added to the end of a reference numeral or an index indicating sequence.

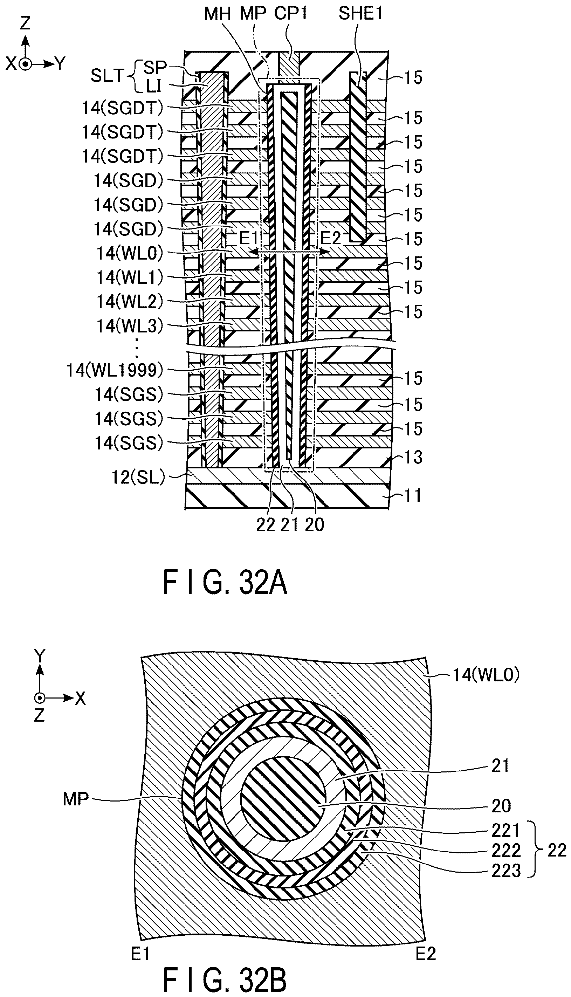

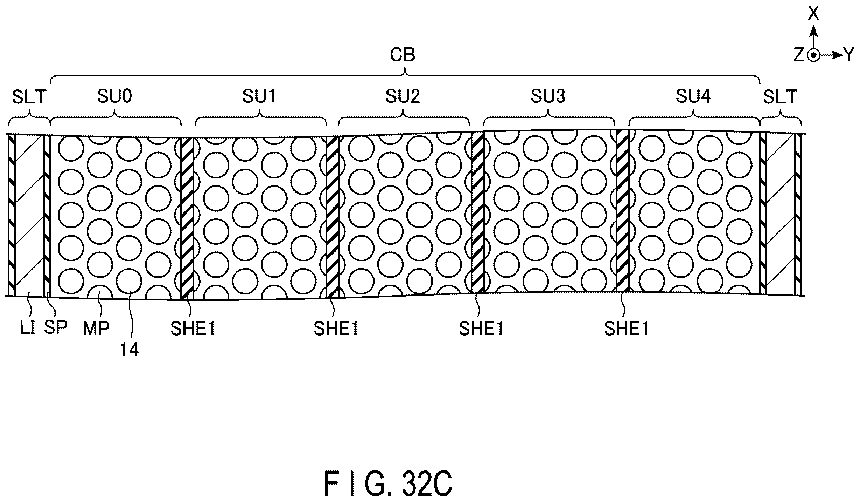

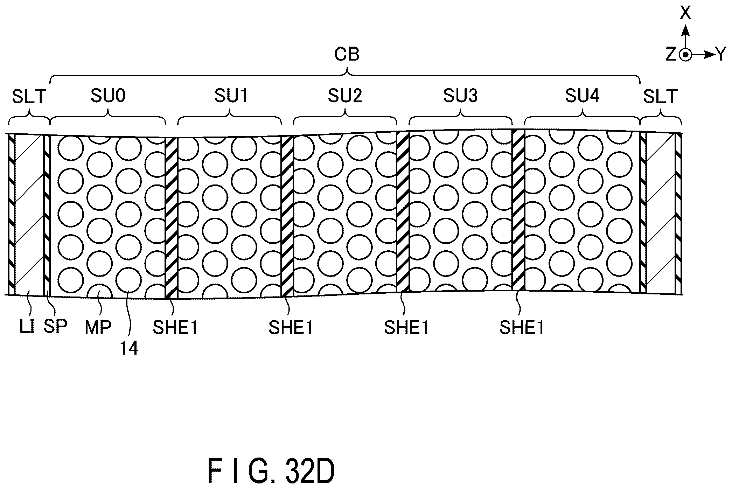

An example of a structure of a memory cell assumed to be applied to embodiments will now be described with reference to FIGS. 32A, 32B, 32C, and 32D, and then the embodiments of the present invention are described. FIG. 32A is a cross-sectional view illustrating an example of a memory cell array applicable to an embodiment. FIG. 32B is a cross-sectional view taken along a line E1-E2 in FIG. 32A. The example given in FIG. 32B illustrates a cross-sectional structure of a memory cell taken along a word line. FIG. 32C is a plan view illustrating a first example of a planar layout of a memory cell array applicable to an embodiment. FIG. 32D is a plan view illustrating a second example of a planar layout of a memory cell array applicable to an embodiment. In the following description, a direction that is parallel to a substrate (silicon substrate) and corresponds to an extension direction of a word line, which will be described later, is referred to as an "X direction" or a "word line direction". A direction parallel to the substrate, intersecting an X direction, and corresponding to an extension direction of a bit line, which will also be described later, is referred to as a "Y direction" or a "bit line direction". A direction perpendicular to an XY plane parallel to the substrate is referred to as a "Z direction". A plurality of word lines are stacked in the Z direction, so the Z direction is also referred to as a "stacked layer direction". In a case of specifying a direction from the substrate to a stacked layer in the Z direction, it is also referred to as an "upward direction" or "one end side of the Z direction", and in a case of specifying a direction from the stacked layer to the substrate in the Z direction, it is also referred to as a "downward direction" or "other end side of the Z direction".

The cross-sectional configuration of the memory cell will now be described with reference to FIG. 32A and FIG. 32B.

As illustrated in FIG. 32A, the memory cell array includes insulating layers 11, 13, and 15, a semiconductor layer 12, interconnect layers 14, a memory pillar MP, a contact plug CP1, a member SLT, and a member SHE1.

The semiconductor layer 12 is provided on the insulating layer 11. The semiconductor layer 12 has a plate-like shape extending along the XY plane. The semiconductor layer 12 contains, for example, silicon (Si) as a material. The semiconductor layer 12 also contains, for example, phosphorus (P) as a semiconductor impurity. The semiconductor layer 12 functions, for example, as a source line SL, which will be described later.

The insulating layer 13 is provided on the semiconductor layer 12. A plurality of interconnect layers 14 and a plurality of insulating layers 15 are alternately stacked on the insulating layer 13, one layer at a time. In other words, a plurality of interconnect layers 14 are stacked apart from each other in the Z direction. A plurality of interconnect layers 14 are also collectively referred to as a "stacked layer".

In the example illustrated in FIG. 32A, the stacked layer includes 2009 interconnect layers 14. A plurality of interconnect layers 14 functions as follows: starting from the side farther away (upper layer) from the semiconductor layer 12 (source line SL), there are three string selection signal lines SGDT, three string selection signal lines SGD, 2000 word lines WL0 to WL1999, and three string selection signal lines SGS.

The word line WL is a gate line of the memory cell. In a case of specifying the interconnect layer 14 that functions as the word line WL, the interconnect layer 14 is also hereinafter referred to as a "word line layer". The number of the word lines WL can be set optionally. It is sufficient that one or more word lines WL are provided.

The string selection signal lines SGS, SGD, and SGDT are gate lines of string selection transistors. In a case of specifying the interconnect layer 14 that functions as the string selection signal lines SGS, SGD, or SGDT, the interconnect layer 14 is also hereinafter referred to as a "string selection signal layer". The string selection signal lines SGS, SGD, and SGDT are optional. It is sufficient to have one or more layers for each of the string selection signal lines SGS, SGD, and SGDT.

The insulating layers 13 and 15 contain, for example, silicon oxide (SiO) as a material. For example, a stacked structure of titanium nitride (TiN) and tungsten (W) is used as the conductive material of the interconnect layer 14. In this case, the titanium nitride is formed to cover the tungsten. Titanium nitride has a function as a barrier layer for suppressing oxidation of tungsten or an adhesion layer for improving adhesion of tungsten in a case where tungsten is deposited by, for example, chemical vapor deposition (CVD). In addition, the interconnect layer 14 can also contain a high dielectric constant material such as aluminum oxide (AlO). In this case, the high dielectric constant material is formed to cover the conductive material. The high dielectric constant material is provided at least between the memory pillar MP specifically described later and the conductive material of the interconnect layer 14.

In the example illustrated in FIG. 32A, a memory hole MH is formed that penetrates (passes through) the 2009 interconnect layers 14 (i.e., the stacked layer). The bottom surface of the memory hole MH (i.e., the memory pillar MP) reaches the semiconductor layer 12. For example, the memory hole MH has a substantially cylindrical shape extending in the Z direction. The memory pillar MP is formed by filling the memory hole MH. That is, the memory pillar MP has a substantially columnar shape extending in the Z direction.

The combination of the memory pillar MP and the interconnect layer 14 (i.e., the word line layer) that functions as the word line WL constitutes a memory cell. In other words, the memory cell is formed with the word line layer acting as the gate electrode. Similarly, the combination of the memory pillar MP and the interconnect layer 14 (i.e., the string selection signal layer) that functions as the string selection signal line SGS, SGD, or SGDT constitutes the string selection transistor. In other words, the string selection transistor is formed with the string selection signal layer acting as a gate electrode. A plurality of memory cells MC and a plurality of string selection transistors configured by one memory pillar MP are coupled in series to form a memory cell string. Thus, one memory pillar MP functions as one memory cell string. It is sufficient that the memory pillar MP has a structure in which a plurality of pillars are connected in the Z direction.

The memory pillar MP includes a core film 20, a silicon channel layer 21, and a stacked film 22.

The core film 20 extends in the Z direction. For example, the core film 20 has a substantially columnar shape extending in the Z direction. For example, the upper end of the core film 20 is located above the uppermost interconnect layer 14, while the lower end thereof is located below the lowermost interconnect layer 14. The core film 20 includes an insulator such as silicon oxide.

The silicon channel layer 21 extends in the Z direction and covers a lateral side, top (surface facing one end in the Z direction), and bottom of the core film 20. For example, the bottom surface of the silicon channel layer 21 is in contact with the semiconductor layer 12. The silicon channel layer 21 is used as a channel (electrical current path) of the memory cells and the string selection transistors. The silicon channel layer 21 includes silicon.

The stacked film 22 extends in the Z direction and covers a lateral side of the silicon channel layer 21. For example, the stacked film 22 has a substantially cylindrical shape extending in the Z direction. An outer lateral side of the stacked film 22 is in contact with the memory hole MH. An inner lateral side of the stacked film 22 is in contact with the silicon channel layer 21.

As illustrated in FIG. 32B, the stacked film 22 includes, for example, a tunnel-insulating layer 221, a charge-trapping layer 222, and a block-insulating layer 223.

In a cross section including the interconnect layer 14 along the XY plane, the core film 20 is provided, for example, in the central part of the memory pillar MP. The silicon channel layer 21 surrounds an outer periphery (lateral side) of the core film 20. The tunnel-insulating layer 221 surrounds an outer periphery (lateral side) of the silicon channel layer 21. The charge-trapping layer 222 surrounds an outer periphery (lateral side) of the tunnel-insulating layer 221. The block-insulating layer 223 surrounds an outer periphery (lateral side) of the charge-trapping layer 222. The interconnect layer 14 surrounds the outer periphery of the block-insulating layer 223. An outer periphery (lateral side) of the block-insulating layer 223 is in contact with the interconnect layer 14.

The tunnel-insulating layer 221 and the block-insulating layer 223 include, for example, silicon oxide. The charge-trapping layer 222 has a function of accumulating charges. The memory cell may be a floating-gate (FG) or a metal-oxide-nitride-oxide-silicon (MONOS) type. The FG type uses a conductor for the charge-trapping layer 222. The MONOS type uses an insulating layer (containing, for example, silicon nitride (SiN)) for the charge-trapping layer 222. For example, in a case of using aluminum oxide as the high dielectric constant material for the interconnect layer 14, the memory cell is also referred to as a metal-aluminum-nitride-oxide-silicon (MANOS) type. The memory cell stores information based on a threshold voltage by emitting or injecting electrons into the charge-trapping layer 222 through Fowler-Nordheim (FN) tunneling.

As illustrated in FIG. 32A, the contact plug CP1 is provided on the silicon channel layer 21 of the memory pillar MP. The contact plug CP1 has, for example, a substantially columnar shape extending in the Z direction. The contact plug CP1 contains, for example, tungsten or copper (Cu) as a conductive material.

The member SLT separates the multiple interconnect layers 14 (i.e., stacked layer) in the Y direction. The interconnect layers 14 divided by the member SLT extend in the X direction. That is, both the word line layers and the string selection signal layers extend in the X direction. The member SLT includes a conductor LI and a spacer SP. The conductor LI has a plate-like shape extending along the XZ plane. For example, a bottom surface of the conductor LI is in contact with the semiconductor layer 12. That is, the conductor LI is coupled to a source line SL. The spacer SP is provided to cover a lateral side of the conductor LI. That is, the spacer SP is provided between the conductor LI and the interconnect layer 14. The conductor LI and the interconnect layer 14 are insulated by the spacer SP. The conductor LI contains, for example, tungsten as a conductive material. The spacer SP contains, for example, an insulator such as silicon oxide. The conductor LI may be omitted. That is, the member SLT may be embedded with an insulator.

The member SHE1 separates the interconnect layers 14, which functions as the string selection signal line SGD or SGDT, in the Y direction and extends in the X direction. The member SHE1 separates at least the interconnect layer 14 provided at the position (topmost layer) farthest from the semiconductor layer 12 among the plurality of interconnect layers 14. The lower end of the member SHE1 is located between the interconnect layer 14 that functions as the string selection signal line SGD and the interconnect layer 14 that functions as the word line WL. The height of the member SHE1 in the Z direction is based on the number of the interconnect layers 14 that function as the string selection signal lines SGDT and SGD. The member SHE1 contains an insulator, for example, such as silicon oxide.

As described above, a plurality of word line layers and a plurality of string selection signal layers are stacked above the semiconductor layer 12 (spaced apart from the semiconductor layer 12 at one end side in the Z direction). The memory hole MH is opened, extending in the Z direction perpendicular to the substrate and penetrating (passing through) the plurality of word line layers and the plurality of string selection signal layers. The formation of the block-insulating layer 223, the charge-trapping layer 222, the tunnel-insulating layer 221, and the silicon channel layer 21 on the lateral wall of each word line layer inside the memory hole MH makes it possible to form individual memory cells that store a threshold voltage via electron injection or emission. The storage principle of the memory cell can utilize not only the injection and emission of charges but also ferroelectric polarization. In this case, the block-insulating layer 223 contains a ferroelectric material and performs a polarization operation. Alternatively, both the block-insulating layer 223 and the charge-trapping layer 222 are replaced with a ferroelectric layer.

This memory cell forms the memory cell string in which the plurality of memory cells with the plurality of word line layers as the gate electrode and the plurality of string selection transistors with the plurality of string selection signal layers as the gate electrode are coupled in series in the stacked layer direction (Z direction). Batch processing of the plurality of memory holes MH enables serial coupling of a plurality of memory cells in the Z direction at a low cost. This enables the implementation of a low-cost, non-volatile semiconductor memory device.

The following describes a first example of the planar layout of the memory cell array.

As illustrated in FIG. 32C, in the region between two adjacent members SLT in the Y direction, a plurality of memory pillars MP are arranged side by side with a total width of, for example, 24 columns in the X direction. The memory pillars MP across 24 columns are arranged in a staggered pattern in such a manner that the positions in the X direction of the memory pillars MP adjacent in the Y direction are different from each other. A plurality of memory pillars MP (a plurality of memory cells) provided between two adjacent members SLT are included in one cell block CB. The cell block CB is, for example, a set of a plurality of memory cell strings (memory pillars MP) from which data is collectively erased. The number of cell blocks CB can be set optionally.

Between two members SLT, multiple members SHE1 extending in the X direction are arranged side by side in the Y direction. In the example illustrated in FIG. 32C, four members SHE1 are provided between two members SLT. The region between two members SLT or SHE1 adjacent in the Y direction corresponds to one string unit SU. That is, the cell block CB includes multiple string units SU. In the example illustrated in FIG. 32C, the cell block CB includes five string units SU0 to SU4. The string unit SU includes, for example, a set of multiple memory cell strings (memory pillars MP) that are collectively selected in a write operation or a read operation. The number of string units SU in the cell block CB can be set optionally.

In the example illustrated in FIG. 32C, in the string unit SU, a plurality of memory pillars MP are arranged side by side in the X direction with a total width of four columns. Then, the four columns of memory pillars MP are arranged in a staggered pattern in such a manner that the X-directional positions of the memory pillars MP adjacent in the Y direction are different from each other. The members SHE1 are provided on the memory pillars MP in the fifth, tenth, fifteenth, and twentieth columns from the left side in FIG. 32C. The member SHE1 is provided to pass through the center of the memory pillar MP in the XY plane to intersect the upper part of the memory pillar MP. For this reason, the memory pillars MP in the fifth, tenth, fifteenth, and twentieth columns do not function as the memory cell strings.

The following describes a second example of the planar layout of the memory cell array.

As illustrated in FIG. 32D, in the region between two members SLT adjacent in the Y direction, a plurality of memory pillars MP are arranged side by side in the X direction with a total width of, for example, 20 columns. Then, the memory pillars MP across 20 columns are arranged in a staggered pattern in such a manner that the X-direction positions of the memory pillars MP adjacent in the Y direction are different from each other.

In the example illustrated in FIG. 32D, between the memory pillar MP in the fourth column and the memory pillar MP in the fifth column from the left side in FIG. 32D, the member SHE1 is provided. Similarly, between the memory pillar MP in the eighth column and the memory pillar MP in the ninth column, the member SHE1 is provided. Between the memory pillar MP in the 12th column and the memory pillar MP in the 13th column, the member SHE1 is provided. Between the memory pillar MP in the 16th column and the memory pillar MP in the 17th column, the member SHE1 is provided. In this case, some of the memory pillars MP in the 4th, 5th, 8th, 9th, 12th, 13th, 16th, and 17th columns can be configured to be cut by the member SHE1. These memory pillars MP function as memory cell strings.

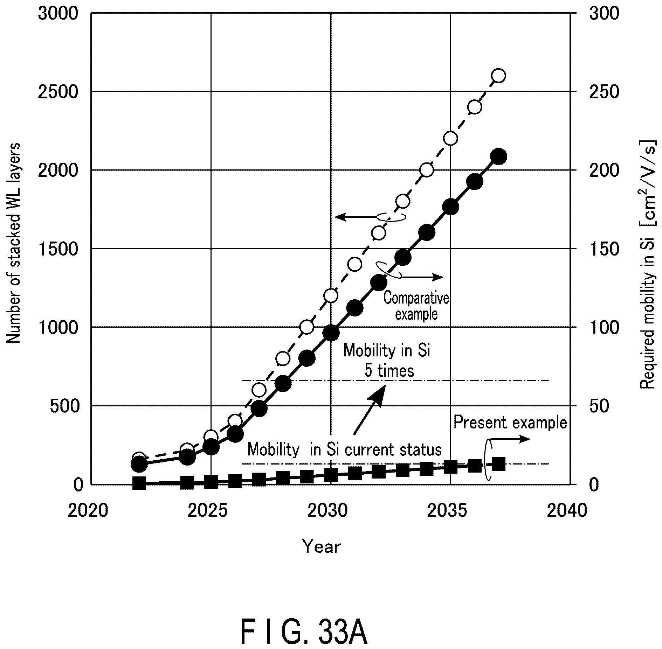

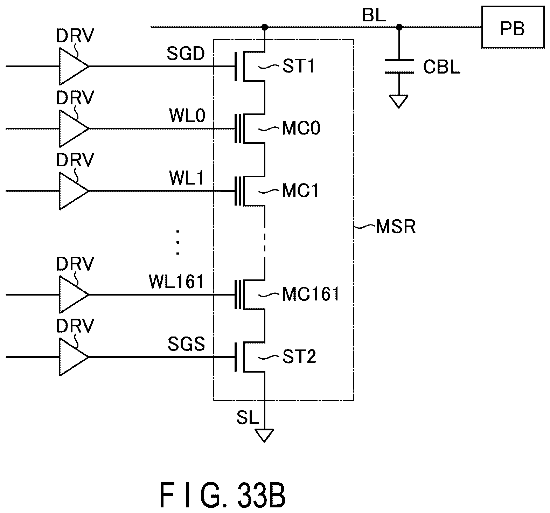

The following describes the relationship between the number of stacked word lines WL in three-dimensional stacked NAND flash memory (also referred to as "3D-NAND flash memory") and a mobility in silicon required for the memory cell with reference to FIGS. 33A and 33B. FIG. 33A is a graph comparing the mobility in silicon required in a case where the number of stacked word lines WL in the 3D-NAND flash memory is increased between a comparative example and one example of the embodiment. FIG. 33B is a circuit diagram illustrating an exemplary circuit configuration of the memory cell string used in a calculation of FIG. 33A. In the following description, unless specifically referring to either a source or a drain of a transistor, one of the source and the drain is referred to as "one end of the transistor", and the other is referred to as "the other end of the transistor".

The following now describes an exemplary circuit configuration of a memory cell string with reference to FIG. 33B.

As illustrated in FIG. 33B, a memory cell string MSR includes a plurality of memory cells MC and string selection transistors ST1 and ST2. In the example illustrated in FIG. 33B, the memory cell string MSR includes 162 memory cells MCO to MC161. The electrical current paths of the string selection transistor ST1, the memory cells MC0 to MC161, and the string selection transistor ST2 in the memory cell string MSR are coupled in series. The string selection transistor ST1 has a drain coupled to the bit line BL. The string selection transistor ST2 has a source coupled to the source line SL. The memory cells MCO to MC161 have their control gates coupled to the respective corresponding word lines WL0 to WL161. The string selection transistor ST1 has a gate coupled to the string selection signal line SGD. The string selection transistor ST2 has a gate coupled to the string selection signal line SGS.

The word lines WL and the string selection signal lines SGD and SGS are coupled to different drivers DRV. The driver DRV applies voltages used for various operations across the corresponding word line WL, string selection signal line SGD, or string selection signal line SGS.

The bit line BL has one end coupled to a page buffer PB. The page buffer PB is a read/write circuit. The page buffer PB also temporarily stores data used in the write operation or the read operation. The load capacitance of the bit line BL is denoted as CBL.

The following describes the relationship between the number of word line layers and the required mobility in silicon with reference to FIG. 33A.

Nowadays, semiconductor memories are used everywhere, including cloud servers, mainframes, personal computers, home appliances, and mobile phones. Types of semiconductor memory available on the market include volatile memories, such as a dynamic read-only memory (DRAM) or a static read-only memory (SRAM), and non-volatile memories, such as a mask read-only memory (MROM), a NAND flash memory, or a flash electrically erasable programmable read-only memory (EEPROM) (trademark) using a NOR flash memory, or the like. In the three-dimensional stacked NAND flash memory (3D-NAND flash memory), a plurality of memory pillars MP (memory cells) are collectively formed after stacking a large number of word line layers, which allows for reduced manufacturing costs. For this reason, high memory capacity 3D-NAND flash memory of 1 Tb is currently being fabricated, and it has become mainstream in the market, with smartphones at the forefront.

However, currently, the number of word line layers range from approximately 150 to 250 layers, and if further stacking is done, the number of serial cells (the number of memory cells MC in series in the memory cell string MSR) increases, leading to a decrease in the cell current (Icell) flowing through the memory cell string MSR. In a case where the size of the memory cell array remains constant, the total number of memory cell strings coupled to the bit line BL during the read operation remains the same. That is, the load capacitance CBL is constant, so the increase in the number of serial cells leads to a decrease in the electrical current driving the load capacitance, causing a severe problem of a significant slowdown in the read operation.

FIG. 33A is a diagram illustrating an overview of the effect of the embodiment. FIG. 33A illustrates a trend of the mobility in silicon required to maintain constant read performance with a constant load capacitance CBL of the bit line (hereinafter referred to as "required mobility in Si") in a case where the number of stacked word lines (hereinafter referred to as "number of stacked WLs") continues to increase for cost reduction, with respect to the generation (Year) on the horizontal axis. As illustrated in FIG. 33A, the required mobility in Si increases in proportion to the number of stacked word lines. However, there is a limit to techniques like a metal-induced crystallization (Mic) or a metal-induced lateral crystallization (Milc) used to reduce high-temperature silicon crystallization or mobility degradation at grain boundaries in polycrystalline silicon, and it is estimated that the maximum achievable mobility in silicon is around five times a current level. For this reason, the comparative example of the conventional approach will face a limit in the number of stacked word lines, i.e., in terms of cost reduction. In contrast, a present example to which the present invention is applied can achieve a word line stack number of 2000 layers or more, even if the mobility in silicon is at the current level. Thus, in the read operation, the time required to drive the load capacitance can be maintained at conventional levels.

The following describes embodiments of the present invention with reference to the drawings.

### 1. First Embodiment

### 1.1 Configuration of Memory Cell Array

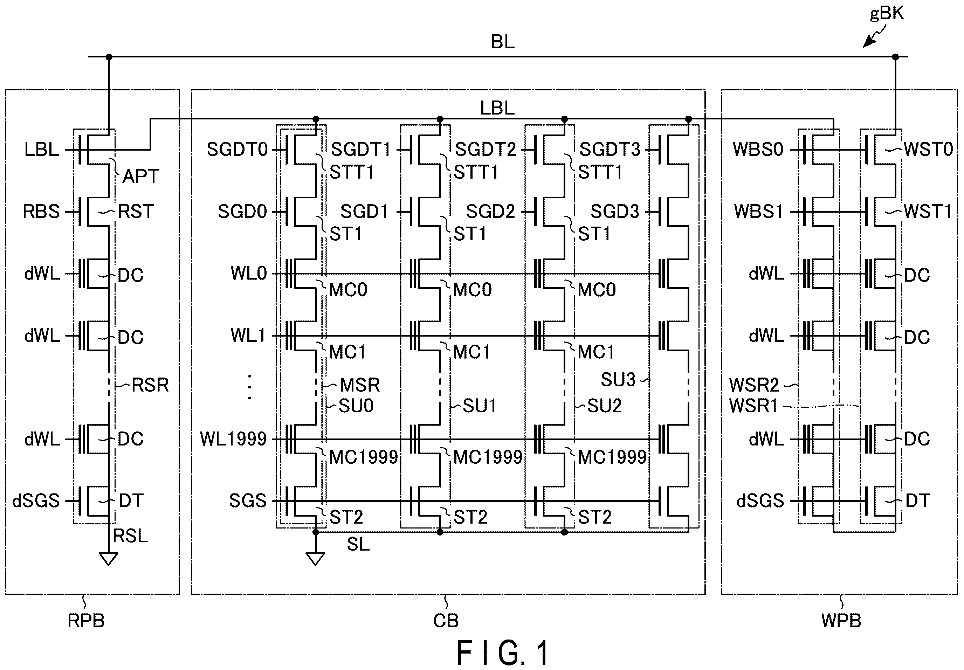

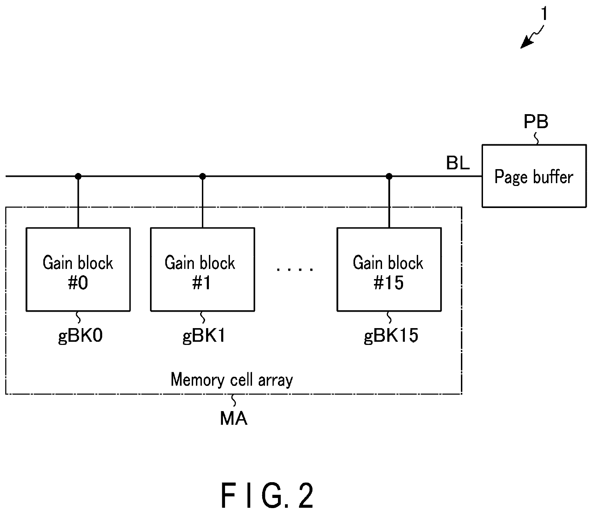

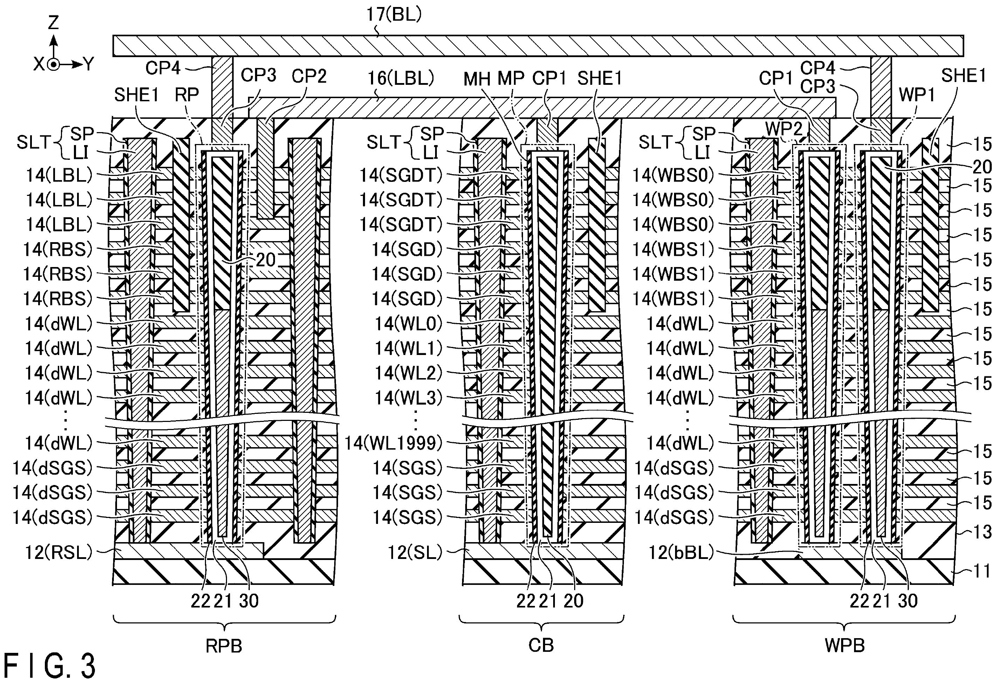

An exemplary configuration of the memory cell array will now be described with reference to FIGS. 1 to 3. FIG. 1 illustrates an example of an equivalent circuit diagram of a gain block gBK according to a first embodiment. FIG. 1 illustrates an example of a cell block CB that includes a plurality of memory cell strings MSR coupled to one local bit line LBL, a write port block WPB that transmits the potential of the bit line BL to the local bit line LBL, and a read port block RPB that amplifies the potential of the local bit line LBL and transmits it to the bit line BL. FIG. 1 illustrates one cell block CB and four string units SU, but in practice, multiple cell blocks CB and multiple string units SU are arranged within each cell block CB. FIG. 2 is a block diagram illustrating an example of a configuration of the memory cell array MA according to the first embodiment. In the example illustrated in FIG. 2, a bit line BL is coupled to a page buffer PB, and a plurality of gain blocks gBK are coupled to the bit line BL. FIG. 3 illustrates an example of a cross-sectional view of the gain block gBK in the bit line direction (Y direction) according to the first embodiment. FIG. 3 illustrates an example of a cross-sectional structure of a part of the cell block CB including a plurality of memory cell strings MSR (memory pillars MP) coupled to one local bit line LBL, the write port block WPB that transmits the potential of the bit line BL to the local bit line LBL, and the read port block RPB that amplifies the potential of the local bit line LBL and transmits it to the bit line BL.

As illustrated in FIG. 1, the gain block gBK includes the cell block CB, the read port block RPB, and the write port block WPB.

The configuration of the cell block CB will now be described. The cell block CB is, for example, a set of a plurality of memory cells from which data is collectively erased. The cell block CB includes a plurality of string units SU. The string unit SU is a set of a plurality of memory cell strings MSR that are collectively selected in the write operation or the read operation. In the example illustrated in FIG. 1, the cell block CB includes four string units SU0 to SU3.

The memory cell string MSR includes a plurality of memory cells MC and string selection transistors STT1, ST1, and ST2. In the example illustrated in FIG. 1, the memory cell string MSR includes 2000 memory cells MCO to MC1999, each of which has the string selection transistor STT1, ST1, and ST2. The electrical current paths of the string selection transistors STT1 and ST1, the memory cells MCO to MC1999, and the string selection transistor ST2 in the memory cell string MSR are coupled in series in this order. A plurality of memory cells MC, which are coupled in series, form a memory cell string configuration. The string selection transistor STT1 has a drain coupled to the local bit line LBL. The string selection transistor ST2 has a source coupled to the source line SL. The number of the string selection transistors STT1 and the string selection signal lines SGDT can vary depending on changes in a process or an operating mode.

Gates of the memory cells MCO to MC1999 in the cell block CB are coupled to the word lines WL0 to WL1999, respectively. More specifically, the gates of a plurality of memory cells MCO in the cell block CB are commonly coupled to the word line WL0. The same applies to the memory cells MC1 to MC1999.

The string selection transistors ST1, ST2, and STT1 are switching elements. The string selection transistors ST1, ST2, and STT1 are used to select the string unit SU. Gates of the string selection transistors ST1, ST2, and STT1 are coupled to the string selection signal lines SGD, SGS, and SGDT, respectively.

More specifically, gates of a plurality of string selection transistors STT1 included in a string unit SU0 are coupled to a string selection signal line SGDT0. Gates of a plurality of string selection transistors ST1 included in the string unit SU0 are coupled to a string selection signal line SGD0. Similarly, gates of the string selection transistors STT1 and ST1 included in the string unit SU1 are coupled to string selection signal lines SGDT1 and SGD1, respectively. Gates of the string selection transistors STT1 and ST1 included in a string unit SU2 are coupled to string selection signal lines SGDT2 and SGD2, respectively. Gates of the string selection transistors STT1 and ST1 included in a string unit SU3 are coupled to string selection signal lines SGDT3 and SGD3, respectively. In addition, gates of a plurality of string selection transistors ST2 in the cell block CB are coupled to a string selection signal line SGS. In order to reduce power consumption, the string selection signal line SGS, similar to the string selection signal line SGD, can be controlled by a separate signal for each string unit SU, for example, like the string selection signal lines SGS0 to SGS3.

A plurality of local bit lines LBL are provided in the gain block gBK. The local bit line LBL is coupled to one memory cell string MSR of each string unit SU in the cell block CB. In the example illustrated in FIG. 1, the local bit line LBL is coupled to one memory cell string MSR in the string unit SU0, one memory cell string MSR in the string unit SU1, one memory cell string MSR in the string unit SU2, and one memory cell string MSR in the string unit SU3. The other local bit lines (LBL), not illustrated in the figure, are coupled in a similar manner. The local bit line LBL has one end coupled to the write port block WPB, and the other end is coupled to the read port block RPB.

The source line SL may be shared, for example, among a plurality of cell blocks CB in one gain block gBK.

The following describes the configuration of the write port block WPB. The write port block WPB functions as a circuit that transmits the charge of the bit line BL to the local bit line LBL. For example, in the write operation, a voltage of the bit line BL based on write data is applied to the local bit line LBL via the write port block WPB. The write port block WPB includes a plurality of strings WSR. More specifically, two strings WSR1 and WSR2 are provided for one local bit line LBL. These two strings WSR1 and WSR2 are coupled in series. The bit line BL is electrically coupled to the local bit line LBL via the two strings WSR1 and WSR2 coupled in series. Unless specifically referring to either WSR1 or WSR2, they are collectively hereinafter simply referred to as a "string WSR".

More specifically, each string WSR in a present embodiment includes transistors WSTO and WST1, a plurality of dummy cells DC, and a dummy transistor DT. The transistor WST0, the transistor WST1, a plurality of dummy cells DC, and the dummy transistor DT in the string WSR1, and the dummy transistor DT, a plurality of dummy cells DC, the transistor WST1, and the transistor WSTO in the string WSR2 are coupled in series in this order. The transistor WSTO in the string WSR1 has one end (drain) coupled to the bit line BL. The transistor WSTO in the string WSR2 has one end (drain) coupled to the local bit line LBL. The dummy transistor DT in the string WSR1 has a source coupled to a source of the dummy transistor DT in the string WSR2.

The transistors WSTO and WST1 function as switch transistors. The transistors WSTO each have their gates coupled to a write control signal line WBSO. Similarly, the respective transistors WST1 have their gates coupled to a write control signal line WBS1. The dummy cell DC has a gate coupled to a dummy word line dWL. The dummy transistor DT has a gate coupled to a dummy string selection signal line dSGS. The dummy cell DC and the dummy transistor DT each have their drains and sources electrically coupled regardless of a gate voltage.

The configuration of the read port block RPB will now be described. The read port block RPB functions as a circuit that amplifies the potential of the local bit line LBL and transmits it to the bit line BL. For example, in the read operation, the read port block RPB amplifies a voltage of the local bit line LBL based on the data stored in the memory cell MC and transmits it to the bit line BL. The read port block RPB includes a plurality of strings RSR. One string RSR is provided for one local bit line LBL.

More specifically, the string RSR in the present embodiment includes transistors APT and RST, a plurality of dummy cells DC, and the dummy transistor DT. The transistor APT, the transistor RST, a plurality of dummy cells DC, and the dummy transistor DT in the string RSR are coupled in series in this order. The transistor APT has one end (drain) coupled to the bit line BL. The dummy transistor DT has a source coupled to a read source line RSL. The order of the transistor APT and the transistor RST can be reversed.

The transistor APT functions as an amplification transistor that amplifies the voltage of the local bit line LBL. The transistor APT has a gate coupled to the local bit line LBL. The transistor RST functions as a switch transistor. The transistor RST has a gate coupled to a read control signal line RBS. A gate of the dummy cell DC has a gate coupled to the dummy word line dWL, which is similar to the write port block WPB. The dummy transistor DT has a gate coupled to the dummy string selection signal line dSGS. The dummy cell DC and the dummy transistor DT each have their drains and sources electrically coupled regardless of a gate voltage.

For example, in non-volatile semiconductor memory devices in the conventional art, one end of the memory cell string MSR is coupled to a bit line BL for reading/writing, and the other end is coupled to a source line SL. For this reason, a memory cell array MA is configured in which a large number of memory cell strings MSR are coupled to a single bit line BL. In this case, the capacitance of the bit line BL increases in proportion to the number of the memory cell strings MSR coupled to it. If, for example, the number of stacked word lines is doubled to reduce costs, the number of serial cells in the memory cell string MSR also doubles. In this case, the cell current (Icell) flowing through the memory cell string MSR is halved, and a driving time of the bit line BL, which is the load capacitance, is doubled. As a result, the processing speed will slow down. On the other hand, to keep the speed constant, it is necessary to, for example, halve the size of the memory cell array to halve the load capacitance. However, this approach would result in doubling the number of page buffers PB across the entire chip, leading to a significant increase of the chip size.

In contrast, in a non-volatile semiconductor memory device 1 according to the present embodiment, as illustrated in FIG. 1, each of a plurality of memory cell strings MSR has one end coupled to one local bit line LBL, and the other end is coupled to the source line SL. This forms a group of memory cell strings corresponding to one local bit line LBL. That is, a gain block gBK is constituted in which the local bit line LBL is coupled to a single bit line BL via the read port block RPB and the write port block WPB.

As illustrated in FIG. 2, the non-volatile semiconductor memory device 1 includes the memory cell array MA and the page buffer PB.

The memory cell array MA includes a plurality of gain blocks gBK coupled to the same bit line BL. In other words, the memory cell array MA is divided into a plurality of gain blocks gBK. Then, the plurality of gain blocks gBK are coupled to a common bit line BL. In the example illustrated in FIG. 2, the memory cell array MA includes 16 gain blocks gBKO to gBK15. The bit line BL is coupled to the 16 gain blocks gBKO to gBK15 and the page buffer PB which is the read/write circuit (i.e., the page buffer PB includes a sense amplifier circuit and a write circuit).

The number of memory cell strings MSR coupled to each local bit line LBL in the gain block gBK decreases as the number of gain blocks gBK increases. For example, if the number of gain blocks gBK is increased from 1 to 16, the number of memory cell strings MSR coupled to the local bit line LBL decreases to one-sixteenth (1/16). As a result, a load capacitance of the local bit line LBL driven by the cell current is significantly reduced to 1/16. This allows the read operation to the local bit line LBL to be 16 times faster. Thus, even if the number of stacked memory cells MC (the number of stacked word lines) is increased to 16 times, the load on the local bit line LBL is reduced to 1/16, so the same speed as conventional speed can be maintained.

As illustrated in FIG. 1, in a case where a high-level voltage is applied to the write control signal lines WBSO and WBS1 in the write port block WPB, the transistors WSTO and WST1 are turned on. This allows the write port block WPB to transmit the potential of the bit line BL to the local bit line LBL via the transistors WSTO and WST1 of each of the two strings WSR1 and WSR2.

Bit information from the page buffer PB is transferred to the memory cell string MSR via the transistors WSTO and WST1 and the local bit line LBL. The local bit line LBL is shorter and has a smaller load than the bit line BL, so a write speed similar to that of the conventional approach is achievable. A write speed follows an FN-tunnel current rule, so it does not deteriorate even if the number of series cells in the memory cell string MSR increases..

In addition, in the read port block RPB, the local bit line LBL is coupled to the amplification transistor APT, which uses the local bit line LBL as its gate input and the bit line BL as its drain. The transistor APT has a source coupled to the read source line RSL via the transistor RST, which uses the read control signal line RBS as its gate input.

For example, in the read operation, in the selected gain block gBK, a high-level voltage is applied to non-selected word lines WL to turn on non-selected memory cells MC. In this condition, a selected word line WL is set to a threshold voltage determination potential. In other words, a read voltage is applied to the selected word line WL. If the threshold voltage of a selected memory cell MC is higher than the determination potential, the selected memory cell MC is turned off. For this reason, the voltage of the local bit line LBL remains at a high level. On the other hand, if the threshold voltage of the selected memory cell MC is lower than the determination potential, the selected memory cell MC is turned on. For this reason, the voltage of the local bit line LBL drops to a low level. In this case, a capacitance of the local bit line LBL is relatively small, so the potential of the local bit line LBL drops relatively quickly. In this condition, in a case where a high-level voltage is applied to the read control signal line RBS, the bit line BL, which has a large load capacity, is driven by the amplification transistor APT, which uses the local bit line LBL as its gate, and the determination result is transmitted to the page buffer PB.

The number of series couplings between the amplification transistor APT and the transistor RST, which uses the read control signal line RBS as its gate input, will be illustrated later, but since a plurality of dummy cells DC and dummy transistors DT in the read port block RPB are process-wise (structurally) optimized for low resistance, they effectively operate at only a few transistor levels. For this reason, even in a case where the amplification transistor APT drives the bit line BL, it is possible to achieve speeds over ten times faster than the driving using the conventional memory cell string MSR in which 150 to 250 memory cells MC are coupled in series, allowing for high-speed operation regardless of the number of cells coupled in series.

The following describes a cross-sectional structure of the gain block gBK. The cell block CB will now be described.

As illustrated in FIG. 3, a plurality of word line layers (WL0 to WL1999) and string selection signal layers (SGDi, SGDTi, and SGS) (where "i" is an integer equal to or greater than 0) are stacked apart from each other in the Z direction. A memory hole MH, which extends in the Z direction and penetrates (passes through) the plurality of word line layers and the string selection signal layers, is opened. A bottom surface of the memory hole MH reaches the semiconductor layer 12. The formation of the stacked film 22 (the block-insulating layer 223, the charge-trapping layer 222, and the tunnel-insulating layer 221) and the silicon channel layer 21 on the lateral wall of each word line layer inside the memory hole MH allows individual memory cells MC that store the threshold voltage through injection/emission of electrons to be formed. The memory cell MC forms the memory cell string MSR in which a plurality of memory cells MC each using a word line layer as a gate electrode and a plurality of string selection transistors STT1, ST1, and ST2 each using a string selection signal layer as a gate electrodes are coupled in series in the Z direction. The in-batch processing of the memory holes MH makes it possible for a series coupling of a large number of memory cells MC in the Z direction to be achieved at low costs. That is, a low-cost, non-volatile semiconductor memory device 1 is implementable.

Furthermore, as illustrated in FIG. 3, a stacked layer of a plurality of interconnect layers 14 is formed by stacking the word line layers and the string selection signal layers. The read port block RPB and the write port block WPB also utilize the interconnect layers 14 stacked by the same film formation process.

For example, the transistors WSTO and WST1 of the write port block WPB use the write control signal lines WBSO and WBS1 as gate inputs and the string selection signal layers (SGDT and SGD) used in the cell block CB as gate electrodes. The interconnect layer 17, which functions as the bit line BL, is electrically coupled to one end of the semiconductor layer 12 located below (separated from the other end side in the Z direction) via the contact plugs CP4 and CP3 and the transistors WSTO and WST1 provided below the interconnect layer 17. The semiconductor layer 12 provided in the write port block WPB functions as a bottom bit line bBL that couples two strings WSR1 and WSR2, that is, electrically couples the bit line BL and the local bit line LBL. The semiconductor layer 12 that functions as the bottom bit line bBL is in the same layer as a source line layer of the cell block CB. The other end of the semiconductor layer 12 is electrically coupled to the interconnect layer 16, which functions as the local bit line LBL, via the transistors WST1 and WSTO and a contact plug CP1 provided above the semiconductor layer 12. In this case, to reduce the resistance of the pillars WP1 and WP2 that pass through the dummy word lines dWL of the write port block WPB, a conductor 30 is provided, for example, inside the silicon channel layer 21 as illustrated in FIG. 3. The suitable materials of the conductor 30 include metal materials such as tungsten or low-resistance silicon doped with high-concentration impurities.

In the read port block RPB, the interconnect layer 14, which functions as the local bit line LBL, is coupled as a gate input of the transistor APT, where the string selection signal layer is used as the gate electrode. In the example illustrated in FIG. 3, the interconnect layer 16, which functions as the local bit line LBL, is electrically coupled via a contact plug CP2 to three upper layers of the stacked layer, which function as the string selection signal layers (the interconnect layers 14 that function as the local bit lines LBL). For the read control signal lines RBS, three string selection signal layers underlying the upper three layers (the interconnect layer 14 that functions as the read control signal line RBS) are used. A source of the control transistor RST, which uses the read control signal line RBS to its gate input, is coupled to the read source line RSL (semiconductor layer 12) through the conductor 30 (such as tungsten or low-resistance silicon doped with high-concentration impurities), which passes through the dummy word line layers in the read port block RPB and reduces a resistance of the pillar RP. In this manner, if the processes of the read port block RPB and the write port block WPB are constructed using the stacked layer that constitute the cell block CB, significant reductions in manufacturing costs can be achieved. Furthermore, if tens to hundreds of memory cell strings MSR are coupled per unit local bit line LBL, an increase in chip area by the read port block RPB and the write port block WPB can be suppressed. Thus, even if the number of stacked word lines is increased to enhance a memory capacity, other costs except the cost associated with increasing the number of stacked word lines and the increase in chip area can be suppressed, resulting in a substantial reduction in the cost per bit.

The following describes in detail the cross-sectional configuration of a memory cell array MA of the present embodiment, focusing on differences from the structure of the memory cell array described with reference to FIGS. 32A and 32B.

As illustrated in FIG. 3, the gain block gBK includes insulating layers 11, 13, and 15, semiconductor layers 12, interconnect layers 14, 16, and 17, memory pillars MP, pillars WP1, WP2, and RP, contact plugs CP1 to CP4, members SLT, and members SHE1.

The semiconductor layer 12 is provided on the insulating layer 11. The semiconductor layer 12 provided in a cell block CB functions as a source line SL. A plurality of the memory pillars MP is provided on the semiconductor layer 12 that functions as the source line SL. Each memory pillar MP functions as one memory cell string MSR.

A plurality of the semiconductor layers 12 provided in a write port block WPB function as a bottom bit line bBL. Two pillars WP1 and WP2, which electrically couple a bit line BL and a local bit line LBL, are provided on the semiconductor layer 12 that functions as the bottom bit line bBL. That is, the two pillars WP are electrically coupled via one bottom bit line bBL. The pillars WP1 and WP2 function as strings WSR1 and WSR2, respectively. Unless specifically referring to either the pillars WP1 or WP2, they are collectively hereinafter simply referred to as a "pillar WP".

The semiconductor layer 12 provided in a read port block RPB functions as a read source line RSL. The plurality of pillars RP are provided on the semiconductor layer 12 that functions as the read source line RSL. Each pillar RP functions as one string RSR.

The insulating layer 13 is provided on the semiconductor layer 12. A plurality of the interconnect layers 14 and a plurality of the insulating layers 15 are stacked alternately one by one on the insulating layer 13. In the example illustrated in FIG. 3, 2009 layers of the interconnect layers 14 are provided, similar to FIG. 32A. Each interconnect layer 14 is divided into the cell block CB, the write port block WPB, and the read port block RPB by the member SLT extending in the X direction.

The 2009 interconnect layers 14 provided in the cell block CB function, from the side (upper layer) farthest from the semiconductor layer 12 (source line SL), as three string selection signal lines SGDT, three string selection signal lines SGD, 2000 word lines WL0 to WL1999, and three string selection signal lines SGS. The interconnect layers 14 that function as the string selection signal line SGDT or the string selection signal line SGD are divided into string units SU by the members SHE1 extending in the X direction.

The 2009 interconnect layers 14 provided in the write port block WPB function, from the side (upper layer) farthest from the semiconductor layer 12 (bottom bit line bBL), as three write control signal lines WBS0, three write control signal lines WBS1, 2000 dummy word lines dWL, and three dummy string selection signal lines dSGS. The interconnect layers 14, which function as the write control signal line WBSO or the write control signal line WBS1, can also be divided by the member SHE1 extending in the X direction.

The 2009 interconnect layers 14 provided in the read port block RPB function, from the side (upper layer) farthest from the semiconductor layer 12 (read source line RSL), as three local bit lines LBL, three read control signal lines RBS, 2000 dummy word lines dWL, and three dummy string selection signal lines dSGS. The interconnect layers 14, which function as the local bit line LBL or the read control signal line RBS, can also be divided by the member SHE1 extending in the X direction.

Thus, in the example illustrated in FIG. 3, the interconnect layer 14 that functions as the string selection signal line SGDT, the interconnect layer 14 that functions as the write control signal line WBS0, and the interconnect layer 14 that functions as part of the local bit line LBL are provided in the same layer. The interconnect layer 14 that functions as the string selection signal line SGD, the interconnect layer 14 that functions as the write control signal line WBS1, and the interconnect layer 14 that functions as the read control signal line RBS are provided in the same layer. The interconnect layer 14 that functions as the word line WL and the interconnect layer 14 that functions as the dummy word line dWL are provided in the same layer. The interconnect layer 14 that functions as the string selection signal line SGS and the interconnect layer 14 that functions as the dummy string selection signal line dSGS are provided in the same layer.

A plurality of memory pillars MP are provided in the cell block CB. The structure of the memory pillar MP is the same as that described in FIGS. 32A and 32B.

The memory pillar MP is combined with the interconnect layer 14 that functions as the word line WL to form a memory cell MC. The memory pillar MP is combined with the interconnect layer 14 that functions as the string selection signal line SGDT to form a string selection transistor STT1. The memory pillar MP is combined with the interconnect layer 14 that functions as the string selection signal line SGD to form a string selection transistor ST1. The memory pillar MP is combined with the interconnect layer 14 that functions as the string selection signal line SGS to form a string selection transistor ST2. In other words, the memory cell MC with the word line WL as its gate electrode is formed. The string selection transistor STT1 with the string selection signal line SGDT as its gate electrode is formed. The string selection transistor ST1 with the string selection signal line SGD as its gate electrode is formed. The string selection transistor ST2 with the string selection signal line SGS as its gate electrode is formed.

A plurality of pillars WP is provided in the write port block WPB. The pillar WP includes a core film 20, the silicon channel layer 21, the stacked film 22 (block-insulating layer 223, charge-trapping layer 222, and tunnel-insulating layer 221), and the conductor 30. The pillar WP of the present embodiment has a structure in which the lower part of the core film 20 of the memory pillar MP is replaced with the conductor 30. The conductor 30 extends in the Z direction. An upper end of the conductor 30 is located between the interconnect layer 14 that functions as the dummy word line dWL and the interconnect layer 14 that functions as the write control signal line WBS1. The core film 20 is provided on the conductor 30. An upper end of the core film 20 is located above the uppermost interconnect layer 14. The silicon channel layer 21 extends in the Z direction, covering the core film 20 and the conductor 30.That is, a bottom side and a lateral side of the conductor 30 are in contact with the silicon channel layer 21. The stacked film 22 is formed to cover a lateral side of the silicon channel layer 21. The suitable material of the conductor 30 includes a metal material such as tungsten or low-resistance silicon doped with a high concentration of impurities.

The pillar WP is combined with the interconnect layer 14 that functions as the write control signal line WBSO to constitute the transistor WSTO. The pillar WP is combined with the interconnect layer 14 that functions as the write control signal line WBS1 to constitute the transistor WST1. The pillar WP is combined with the interconnect layer 14 that functions as the dummy word line dWL to constitute the dummy cell DC. The pillar WP is combined with the interconnect layer 14 that functions as the dummy string selection signal line dSGS to constitute the dummy transistor DT. In other words, the transistor WSTO with the write control signal line WBSO as its gate electrode is constituted. The transistor WST1 with the write control signal line WBS1 as its gate electrode is constituted. The dummy cell DC with the dummy word line dWL as its gate electrode is constituted. The dummy transistor DT with the dummy string selection signal line dSGS as its gate electrode is constituted.

In the read port block RPB, a plurality of pillars RP are provided. The structure of the pillar RP is the same as that of the pillar WP. For example, the memory hole MH and the holes corresponding to the pillars WP and RP are collectively processed.

The pillar RP is combined with the interconnect layer 14, which functions as the local bit line LBL, to constitute the transistor APT. The pillar RP is combined with the interconnect layer 14, which functions as the read control signal line RBS, to form the transistor RST. The pillar RP is combined with the interconnect layer 14, which functions as the dummy word line dWL, to constitute the dummy cell DC. The pillar RP is combined with the interconnect layer 14, which functions as the dummy string selection signal line dSGS, to constitute the dummy transistor DT. In other words, the transistor APT with the local bit line LBL as its gate electrode is constituted. The transistor RST with the read control signal line RBS as its gate electrode is constituted. The dummy cell DC with the dummy word line dWL as its gate electrode is constituted. The dummy transistor DT with the dummy string selection signal line dSGS as its gate electrode is constituted.

The dummy cells DC and the dummy transistors DT of the write port block WPB and the read port block RPB have their drains and sources electrically coupled by the conductor 30. Thus, the electrical current paths of the dummy cells DC and dummy transistors DT are low resistance, resulting in there being a conductive state regardless of a gate voltage.

In the cell block CB, the contact plug CP1 is provided on the memory pillar MP. The interconnect layer 16 extending in the Y direction is provided on the contact plug CP1. The memory pillar MP is electrically coupled to the interconnect layer 16 via the contact plug CP1. The interconnect layer 16 functions as the local bit line LBL. The interconnect layer 16 and the contact plug CP1 contain, for example, copper or tungsten as a conductive material. The contact plugs CP1 to CP4 can partially include an N⁺ diffusion layer or a P⁺ diffusion layer.

In the write port block WPB, of the two pillars WP1 and WP2 provided on the bottom bit line bBL, the contact plug CP1 is provided on the pillar WP2 corresponding to the string WSR2. The pillar WP2 is electrically coupled to the interconnect layer 16 (local bit line LBL) via the contact plug CP1. The contact plug CP3 is provided on the pillar WP1 corresponding to the string WSR1. Furthermore, the contact plug CP4 is provided on the contact plug CP3. The interconnect layer 17 extending in the Y direction is provided on the contact plug CP4. The interconnect layer 17 is provided above the interconnect layer 16. The pillar WP1 is electrically coupled to the interconnect layer 17 via the contact plugs CP3 and CP4. The interconnect layer 17 functions as the bit line BL. The interconnect layer 17 and the contact plugs CP3 and CP4 contain, for example, copper or tungsten as a conductive material.

In the read port block RPB, the contact plug CP2 is provided, which is electrically coupled to the three upper interconnect layers 14 that function as the local bit line LBL. The contact plug CP2 passes through the two upper interconnect layers 14 and has its bottom surface in contact with the third interconnect layer 14. The three upper interconnect layers 14 are electrically coupled to the interconnect layer 16 (local bit line LBL) via the contact plug CP2. The contact plug CP3 is provided on the pillar RP. Furthermore, the contact plug CP4 is provided on the contact plug CP3. The interconnect layer 17 is provided on the contact plug CP4. The pillar RP is electrically coupled to the interconnect layer 17 via the contact plugs CP3 and CP4. The contact plug CP2 contains, for example, copper or tungsten as a conductive material.

### 1.2 Planar Layout of Write Port Block

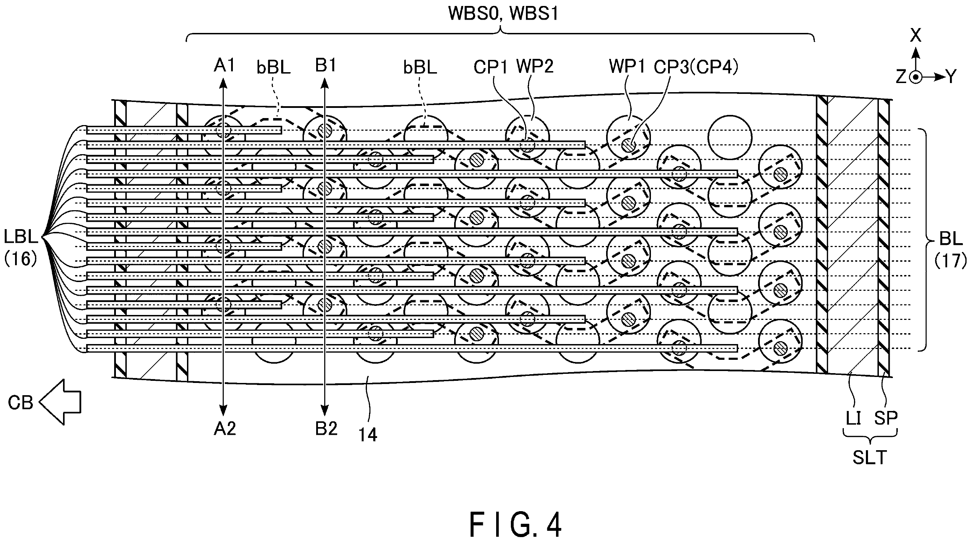

The following describes an example of a planar layout of the write port block WPB with reference to FIG. 4. FIG. 4 is a plan view illustrating an example of a planar layout of the write port block WPB.

As illustrated in FIG. 4, a plurality of local bit lines LBL (interconnect layer 16) extending in the Y direction is arranged side by side in the X direction. Each of the local bit lines LBL extends from the cell block CB (not illustrated) located on the left side of the drawing toward the write port block WPB. The local bit line LBL is electrically coupled to the pillar WP2 provided below via the contact plug CP1. The length of the local bit line LBL varies depending on the position of the pillar WP2 (contact plug CP1) to which it is coupled. The local bit line LBL is electrically coupled, via the pillar WP2, to the bottom bit line bBL (semiconductor layer 12) provided below the pillar WP2. For example, the pillar WP1 that is located at the same position in the X direction and adjacent in the Y direction is coupled to the bottom bit line bBL. That is, two pillars WP1 and WP2 are coupled to one bottom bit line bBL. The pillar WP1 coupled to the bottom bit line bBL is electrically coupled to the bit line BL (interconnect layer 17) provided above the local bit line LBL via the contact plugs CP3 and CP4. The edge portion of the local bit line LBL on the right side of the figure does not extend above the contact plug CP3. Thus, the contact plug CP3 is formed on the pillar WP1 without being obstructed by the local bit line LBL.

The pillars WP are arranged, for example, in a staggered arrangement, similar to the memory pillars MP.

In the example illustrated in FIG. 4, the bottom bit line bBL is shaped with bends toward either the upper or lower side of the figure. The shape of the bottom bit line bBL is not limited to this configuration. In the example illustrated in FIG. 4, two pillars WP in the first and third columns from the left side of the figure that are at the same position in the X direction and adjacent in the Y direction are coupled to one bottom bit line bBL. For example, the local bit line LBL is electrically coupled to the bit line BL via the contact plug CP1 provided on the pillar WP2 in the first column, the pillar WP2 in the first column, the bottom bit line bBL, the pillar WP1 in the third column, the contact plug CP3 provided on the pillar WP1 in the third column, and the contact plug CP4 provided on the contact plug CP3. Another pillar WP in a different position in the X direction in the second column from the left side of the figure is also coupled to the bottom bit line bBL, but the pillar WP in the second column is a dummy (floating state) and does not contribute to the electrical coupling. Similarly, two pillars WP in the fourth and sixth columns from the left side of the figure that are in the same position in the X direction and adjacent in the Y direction, as well as one pillar WP (dummy) in the fifth column, are coupled to one bottom bit line bBL. Two pillars WP in the seventh and ninth columns from the left side of the figure that are in the same position in the X direction and adjacent in the Y direction, as well as one pillar WP (dummy) in the eighth column, are coupled to one bottom bit line bBL. Two pillars WP in the tenth and twelfth columns from the left side of the figure that are in the same position in the X direction and adjacent in the Y direction, as well as one pillar WP (dummy) in the eleventh column are coupled to one bottom bit line bBL.

The bottom bit line bBL requires pitch relaxation due to random processing. As illustrated in FIG. 4, the local bit lines LBL are coupled in four stages in the Y direction. More specifically, for example, four local bit lines LBL arranged in the X direction are coupled to the pillars WP2 in the first, seventh, fourth, and tenth columns from the left side of the figure in that order. In addition, upon being viewed in the X direction, the coupling positions of the local bit lines LBL in the Y direction are repeated in units of four lines. More specifically, for example, the first, fifth, ninth, and thirteenth local bit lines LBL from the top of the figure are coupled to the four pillars WP2 arranged in the first column from the left side of the figure. The edge portions of the local bit lines LBL on the right side of the figure are different for each line, so it is preferable to form the local bit lines LBL (interconnect layer 16) by angled sidewall patterning process (SAP) or nano-imprint lithography (NIL) processing.

### 1.3 Planar Layout of Read Port Block

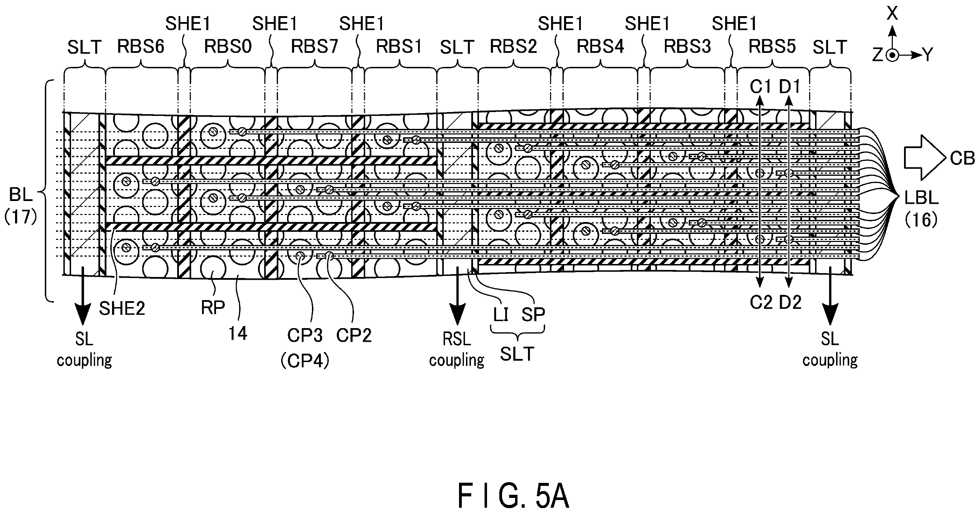

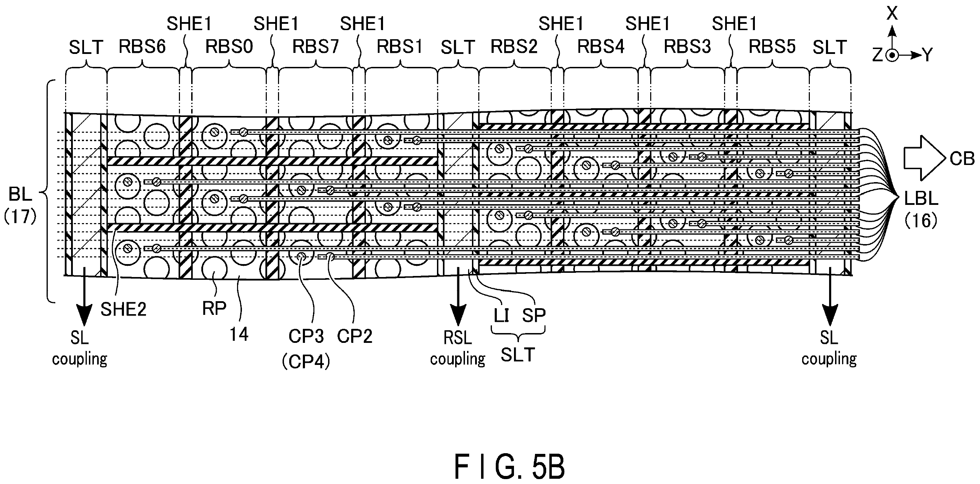

The following now describes two examples of the planar layout of the read port block RPB with reference to FIGS. 5A and 5B. FIG. 5A is a plan view illustrating a first example of the planar layout of the read port block RPB. FIG. 5B is a plan view illustrating a second example of the planar layout of the read port block RPB.

The first example of the planar layout of the read port block RPB will now be described with reference to FIG. 5A.

As illustrated in FIG. 5A, in the read port block RPB, the amplification transistor APT with each local bit line LBL (interconnect layer 16) as its gate is formed. In addition, for each read control signal line RBS extending in the X direction, a plurality of transistors RST are formed, using it as a gate. To form the gate electrode (interconnect layer 14) of the amplification transistor APT, which is an island-like structure separated in the X and Y directions, first, the member SHE1 extending in the X direction is formed to separate six upper interconnect layers 14, which function as the local bit line LBL or the read control signal line RBS, in the Y direction.

In the example illustrated in FIG. 5A, a plurality of pillars RP provided between three members SLT are included in one read port block RPB. In the region between two members SLT adjacent in the Y direction, a plurality of pillars RP are arranged side by side in the X direction, for example, with a width of 11 columns. Then, the 11 columns of memory pillars MP are arranged in a staggered pattern in such a manner that the X-directional positions of memory pillars MP adjacent in the Y direction are different from each other.

Between two members SLT, a plurality of members SHE1 extending in the X direction are arranged side by side in the Y direction. In the example illustrated in FIG. 5A, three members SHE1 are provided between two members SLT. More specifically, the members SHE1 are provided on the pillars RP in the third, sixth, ninth, fourteenth, seventeenth, and twentieth columns from the left side in FIG. 5A in such a manner as to divide the upper part of the pillar RP. The region between two members SLT or the member SHE1 adjacent in the Y direction corresponds to one read control signal line RBS. That is, the read port block RPB includes a plurality of read control signal lines RBS. In the example illustrated in FIG. 5A, the six upper interconnect layers 14 of the read port block RPB are divided into eight in the Y direction by the member SLT and the member SHE1. That is, the interconnect layers 14, which function as local bit lines LBL or read control signal lines RBS, are divided into eight in the Y direction. The eight read control signal lines RBS0 to RBS7 are arranged, for example, in the order of read control signal lines RBS6, RBS0, RBS7, RBS1, RBS2, RBS4, RBS3, and RBS5 from the left side of the figure.

Then, a member SHE2 extending in the Y direction is formed to separate the three upper interconnect layers 14 that function as local bit lines LBL in the X direction. As a result, the three upper interconnect layers 14 become floating gates that are separated in the X and Y directions (vertical and horizontal separation). The electrical coupling of the interconnect layer 16 (local bit line LBL) to these layers enables the amplification transistor APT to be formed. The interconnect layers 14, which are the three lower layers out of the six upper layers, function as read control signal lines RBS that are input to a gate of the transistor RST that is coupled in series to the amplification transistor APT, enabling or disabling the drive of the amplification transistor APT.

For example, each local bit line LBL (interconnect layer 16) is electrically coupled to any of the vertically and horizontally separated interconnect layers 14 in the region of any of the read control signal lines RBS0 to RBS7. Specifically, the vertically and horizontally separated interconnect layer 14 corresponding to the region of a read control signal line RBSk (where "k" is an integer from 0 to 7) is electrically coupled to the local bit line LBL(8j + k) (where "j" is an integer equal to or greater than 0). The number of the read control signal lines RBS divided in the Y direction and the order of their arrangement are set to be optional.

The isolation gate (gate of the amplification transistor APT), i.e., the interconnect layer 14 that functions as the local bit line LBL separated vertically and horizontally by the members SHE1 and SHE2 has an area of 2 x 2 pillars RP, i.e., two RP vertically (two pillars RP in the X direction) and two RP horizontally (two pillars RP in the Y direction). The isolation gate is formed for each interconnect layer 16 that functions as the local bit line LBL, so it is formed in eight stages in the horizontal direction (Y direction) of the figure. The local bit line LBL (interconnect layer 16) extending from the cell block CB (not illustrated) located on the right side of the figure toward the left side of the figure is electrically coupled to the interconnect layer 14 that functions as a gate of the amplification transistor APT via the contact plug CP2. The bit line BL (interconnect layer 17) is coupled to the pillar RP via the contact plugs CP3 and CP4. The pillar RP reaches the read source line RSL (semiconductor layer 12) via the amplification transistor APT and the transistor RST to which the read control signal line RBS is coupled. The read source line RSL is electrically coupled to an upper interconnect layer (not illustrated) via the conductor LI of the member SLT provided in the center of the read port block RPB (between the read control signal lines RBS1 and RBS2).

The signal (voltage) applied to the read source line RSL can be a different signal (different voltage) from the signal (voltage) applied to the source line SL, or it can be the same signal (same voltage). In a case of the different signal, a source potential of the amplification transistor APT can be adjusted independently from a potential of the source line SL. For this reason, in a case where a potential of the local bit line LBL fluctuates in a range of 0 V (data "0") to 0.7 V (data "1"), it is desirable that a threshold voltage Vt of the amplification transistor APT be within a range of 0 V < Vt < 0.7 V. For example, in a case where the threshold voltage Vt is 0.7 V or higher, the potential of the read source line RSL can be adjusted by lowering it. In addition, to adjust a variation in the threshold voltage Vt of the amplification transistor APT, in a case of adjusting the threshold voltage Vt by injecting/emitting electrons to/from the amplification transistor APT, it is desirable to apply an independent signal to the read source line RSL.

In FIG. 5A, there is an unused pillar RP near the contact plug CP2, but the contact plug CP2 is not electrically coupled to the silicon channel layer 21 in the pillar RP. The contact plug CP2 is electrically coupled only to the interconnect layer 14 that functions as the local bit line LBL. If the contact plug CP2 happens to be electrically coupled to the silicon channel layer 21 in the pillar RP, the semiconductor layer 12 directly below a bottom of the pillar RP can be removed, leaving the corresponding pillar RP floating.

The following describes a second example of the planar layout of the read port block RPB with reference to FIG. 5B. The description focuses on differences from the first example.

As illustrated in FIG. 5B, in this example, the unused pillar RP located near the contact plug CP2 described with reference to FIG. 5A is removed to make it easier to couple the contact plug CP2 and the interconnect layer 14. There is a concern that the uniformity of the hole processing corresponding to the pillar RP is likely to be disrupted. In that case, after forming a plurality of holes corresponding to the planar layout described with reference to FIG. 5A, only unnecessary holes can be filled with an insulator before forming the contact plug CP2 as illustrated in FIG. 5B.

### 1.4 Cross-sectional Structure of Write Port Block and Read Port Block in Word Line Direction

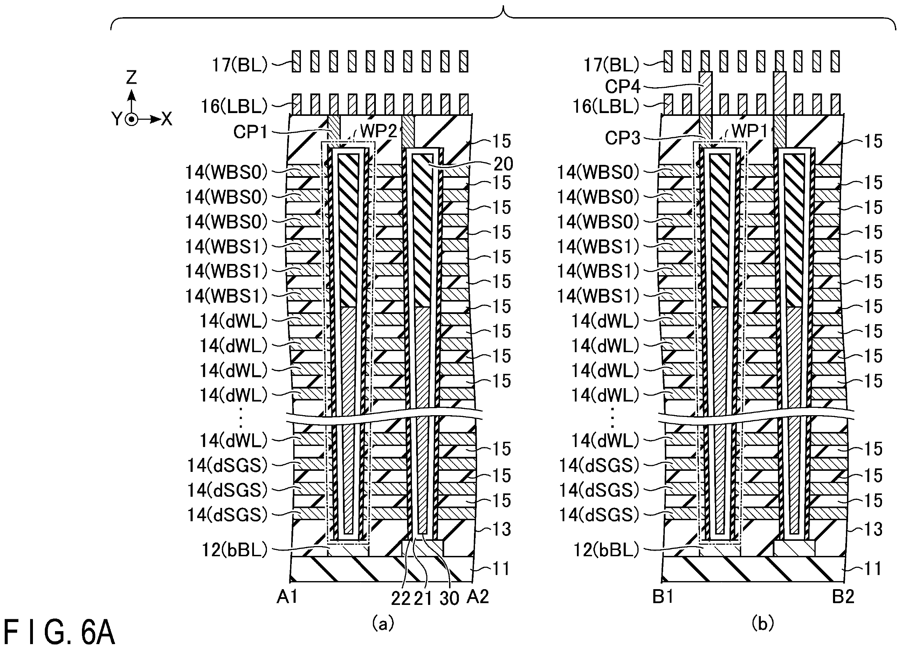

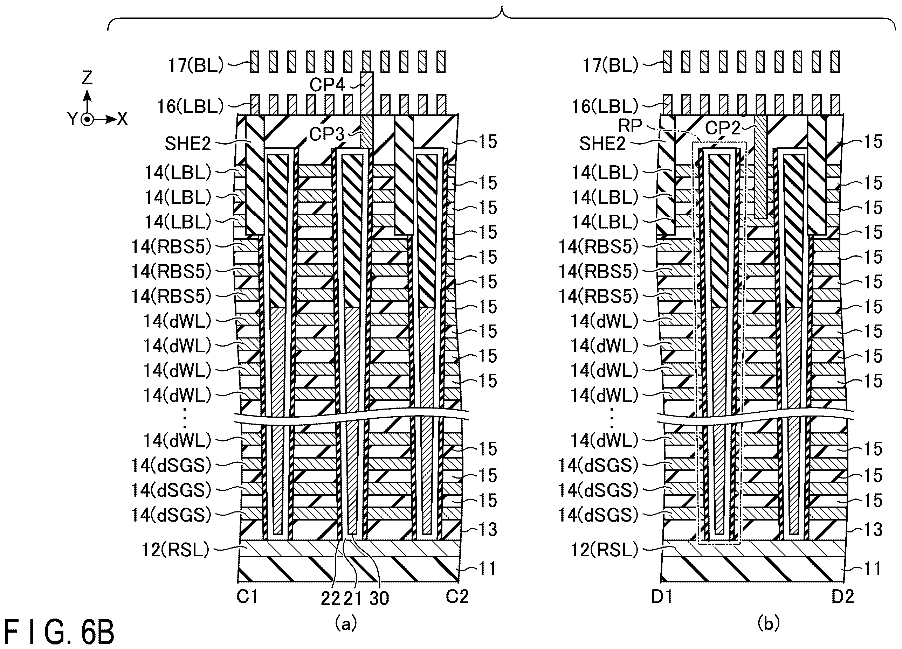

The following describes an example of the cross-sectional structure of the write port block WPB and the read port block RPB in the word line direction (X direction) with reference to FIG. 6A and FIG. 6B. FIG. 6A illustrates a cross-sectional view of the write port block WPB in the word line direction (X direction) taken along lines A1-A2 and B1-B2 in FIG. 4. FIG. 6B illustrates a cross-sectional view of the read port block RPB in the word line direction (X direction) taken along lines C1-C2 and D1-D2 in FIG. 5A. The description using FIG. 6A and FIG. 6B focuses on the difference from the cross-sectional structure in the bit line direction of the gain block gBK described with reference to FIG. 3.

The cross-sectional structure in the word line direction of the write port block WPB will now be described with reference to FIG. 6A.

The part (a) of FIG. 6A illustrates a cross-portion taken along line A1-A2 in FIG. 4, and the part (b) of FIG. 6A illustrates a cross-portion taken along line B1-B2 in FIG. 4. In other words, the part (a) of FIG. 6A illustrates the coupling between the interconnect layer 16 (local bit line LBL) and the pillar WP2, and the part (b) of FIG. 6A illustrates the coupling between the interconnect layer 17 (bit line BL) and the pillar WP1.

As illustrated in the part (a) of FIG. 6A, the interconnect layer 16 that functions as the local bit line LBL is coupled to the semiconductor layer 12 that functions as the bottom bit line bBL via the contact plug CP1 and the pillar WP2.

The semiconductor layer 12 on a right side in the part (a) of FIG. 6A is the same as the semiconductor layer 12 on a right side in the part (b) of FIG. 6A. Similarly, the semiconductor layer 12 on a left side in the part (a) of FIG. 6A is the same as the semiconductor layer 12 on a left side in the part (b) of FIG. 6A. Thus, the pillar WP2 on the right side in the part (a) of FIG. 6A is electrically coupled to the pillar WP1 on the right side in the part (b) of FIG. 6A via the semiconductor layer 12. In addition, the pillar WP2 on the left side in the part (a) of FIG. 6A is electrically coupled to the pillar WP1 on the left side in the part (b) of FIG. 6A via the semiconductor layer 12.

As illustrated in the part (b) of FIG. 6A, the pillar WP1 is electrically coupled to the interconnect layer 17 that functions as the bit line BL provided above it via the contact plugs CP3 and CP4. Thus, the local bit line LBL is electrically coupled to the bit line BL via the contact plug CP1, the pillar WP2 in the part (a) of FIG. 6A, the bottom bit line bBL, the pillar WP1 in the part (b) of FIG. 6A, and the contact plugs CP3 and CP4.

The following describes the cross-sectional structure of the read port block RPB in the word line direction with reference to FIG. 6B.

The part (a) of FIG. 6B illustrates a cross section taken along line C1-C2 in FIG. 5A, and the part (b) of FIG. 6B illustrates a cross section taken along line D1-D2 in FIG. 5A.

As illustrated in the part (b) of FIG. 6B, the interconnect layer 16 that functions as the local bit line LBL is coupled to the gate of the amplification transistor APT via the contact plug CP2, and is electrically coupled to the three upper interconnect layers 14 that function as the local bit line LBL. The interconnect layer 14 that functions as the local bit line LBL is separated in the X direction by the member SHE2 extending in the Y direction (bit line direction). The member SHE2 contains, for example, silicon oxide as an insulating material.

As illustrated in the part (a) of FIG. 6B, the pillar RP is electrically coupled to the interconnect layer 17 that functions as the bit line BL provided above it via the contact plugs CP3 and CP4. The amplification transistor APT with the local bit line LBL as its gate drives the bit line BL, and the electrical current is passed through the read source line RSL.

The semiconductor layer 12 of the write port block WPB (bottom bit line bBL) is divided for each local bit line LBL to which it is electrically coupled. In contrast, the semiconductor layer 12 of the read port block RPB (read source line RSL) is a common interconnect throughout the entire read port block RPB. In this manner, sharing a number of process steps with the manufacturing process of the memory cells MC (memory pillar MP) makes it possible to reduce costs.

### 1.5 Chip Configuration of Non-volatile Semiconductor Memory Device

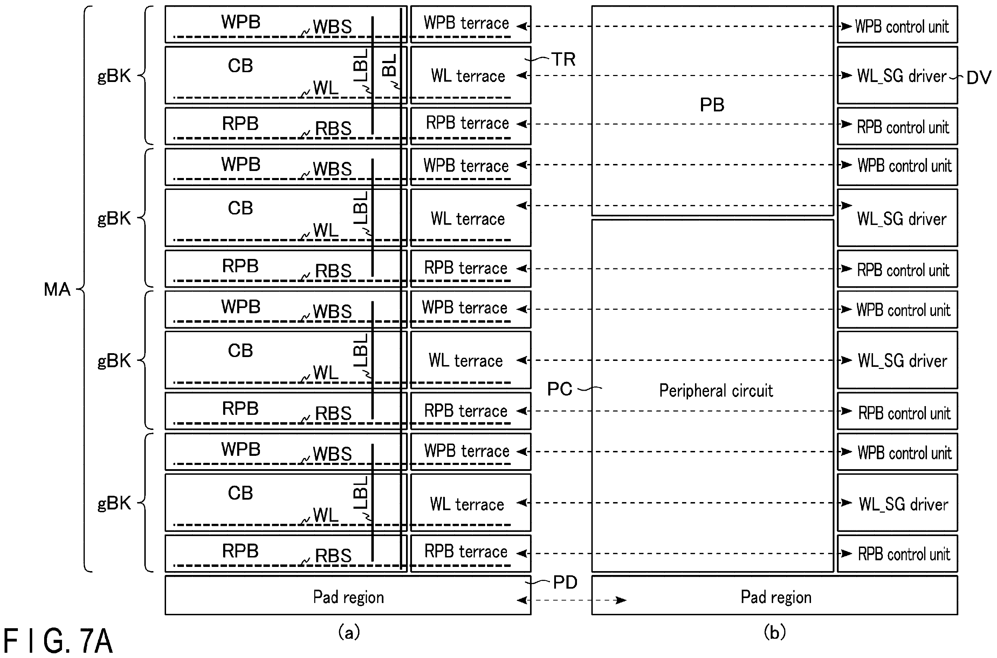

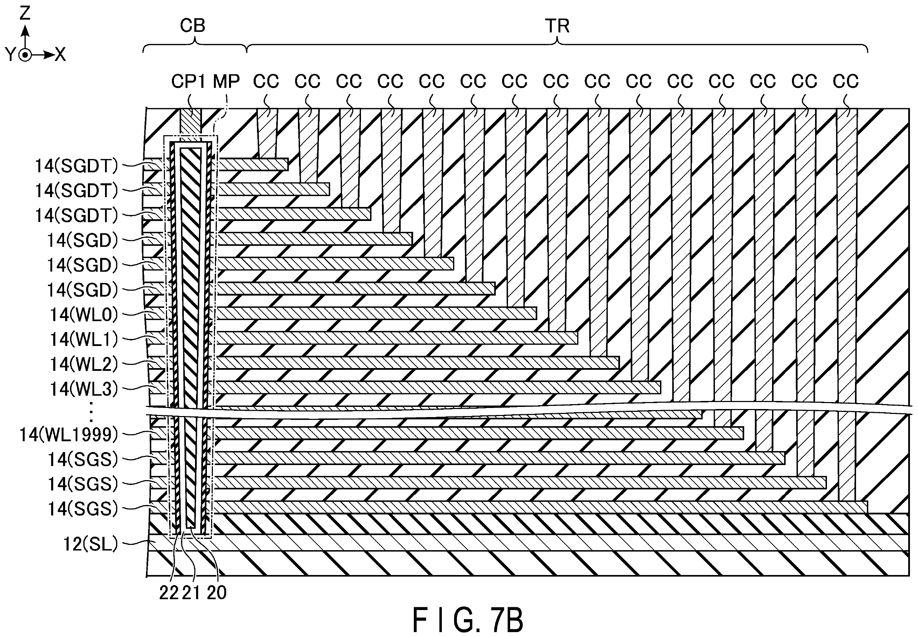

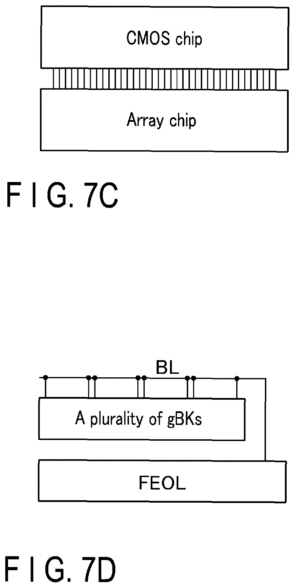

The following describes an example of a chip configuration of the non-volatile semiconductor memory device 1 with reference to FIG. 7A, FIG. 7B, FIG. 7C, and FIG. 7D. FIG. 7A is a layout diagram illustrating an example of a chip layout of the non-volatile semiconductor memory device 1. The part (a) of FIG. 7A illustrates a layout of a memory cell array process layer. The part (b) ofFIG. 7A illustrates a layout of a complementary metal-oxide semiconductor (CMOS) chip side in a transistor portion below the memory cell array or in a wafer bonding. FIG. 7B illustrates an example of a cross-sectional view of a WL terrace TR corresponding to the cell block CB. FIG. 7C illustrates an example of a bonding of an array chip and a CMOS chip. FIG. 7D illustrates an example of a cross-sectional configuration of the memory cell array process layer and the transistor portion below it.

The configuration of the non-volatile semiconductor memory device 1 will now be described with reference to FIG. 7C and FIG. 7D.

As illustrated in FIG. 7C, the gain block gBK, which includes the cell block CB, the read port block RPB, and the write port block WPB, is formed in an array chip. In addition, the page buffer PB, a WL_SG driver DV, and a peripheral circuit PC are formed in a CMOS chip. The array chip and the CMOS chip can be bonded to form a bonding structure.

As illustrated in FIG. 7D, a plurality of gain blocks gBK can be formed in a memory cell array process layer, and the page buffer PB, the WL_SG driver DV, and the peripheral circuit PC can be formed in a lower transistor portion (region of front-end-of-line (FEOL)).

As illustrated in the part (a) of FIG. 7A, for example, in the memory cell array process layer, the memory cell array MA is constituted by arranging a plurality of gain blocks gBK, each of which has the read port block RPB and the write port block WPB arranged on both sides of the cell block CB, in the up-down direction of the figure. A plurality of gain blocks gBK are commonly coupled to the bit line BL. In addition, the bit line BL is also coupled to the page buffer PB provided in the CMOS chip (or in the FEOL region below the memory cell array). The local bit line LBL is arranged in each of the gain blocks gBK, and each of the word lines WL and the string selection signal lines SGDT, SGD, and SGS, which control a plurality of memory cell strings MSR, is coupled to a WG_SG driver DV provided in the CMOS chip via a contact plug CC provided in the WL terrace TR. The read control signal line RBS and the write control signal lines WBSO and WBS1 are coupled to an RPB control unit and a WPB control unit, which are provided in the CMOS chip, via the contact plugs CC provided in the RPB terrace and the WPB terrace, respectively. As illustrated in FIG. 7A, the bit line BL runs across the entire vertical direction of the figure, so it can reduce the number of page buffers PB and suppress the increase in chip area, and a high-speed operation can be achieved even if a memory cell string MSR has 1000 to 2000 serial cells.

More specifically, as illustrated in the part (a) of FIG. 7A, the memory cell array MA and a pad region PD are provided in the memory cell array process layer. In the example illustrated in the part (a) of FIG. 7A, the memory cell array MA includes four gain blocks gBK. Each of the gain blocks gBK includes the cell block CB, the write port block WPB, the read port block RPB, the WL terrace TR, the WPB terrace, and the RPB terrace.

A plurality of gain blocks gBK in the memory cell array MA are commonly coupled to the bit line BL. The cell block CB, the write port block WPB, and the read port block RPB in the respective gain blocks gBK are commonly coupled to the local bit line LBL.

In the respective gain blocks gBK, the read port block RPB and the write port block WPB are arranged on both sides of the cell block CB in the up-down direction of the figure. Then, for example, four gain blocks gBK are arranged side by side in the up-down direction of the figure.

The WL terrace TR is a coupling region between the interconnect layers 14 of the cell block CB and the contact plugs CC provided corresponding thereto. The WPB terrace is a coupling region between the interconnect layers 14 of the write port block WPB and the contact plugs CC provided corresponding thereto. The RPB terrace is a coupling region between the interconnect layers 14 of the read port block RPB and the contact plugs CC provided corresponding thereto.

As illustrated in FIG. 7B, for example, in the WL terrace TR, edge portions in the X direction of the interconnect layers 14 provided in the cell block CB are drawn out in a stepped shape. The contact plug CC extending in the Z direction is coupled to the top of each interconnect layer 14 drawn out in a stepped shape. The contact plug CC is electrically coupled to an interconnect layer (not illustrated) provided in the upper layer. The contact plug CC contains, for example, tungsten or copper as a conductive material. The same applies to the WPB terrace and the RPB terrace. The WL terrace TR is also referred to as a "word line stepped portion".

As illustrated in the parts (a) and (b) of FIG. 7A, the pad region PD is a region where a pad used to couple, for example, a power supply line is formed.

As illustrated in the part (b) of FIG. 7A, the CMOS chip side (FEOL side) is provided with the page buffer PB, the peripheral circuit PC, the WL_SG driver DV, the WPB control unit, the RPB control unit, and the pad region PD.

The peripheral circuit PC includes components such as a sequencer, a voltage generator, and an input/output circuit, which are not illustrated. For example, the sequencer controls the overall operation of the non-volatile semiconductor memory device 1. For example, the sequencer executes a write operation, a read operation, an erase operation. The voltage generator generates voltages used for the write operation, the read operation, the erase operation, and the like. The input/output circuit is a circuit that inputs and outputs various signals to and from external devices.

The WL_SG driver DV includes a driver that supplies voltages to the word lines WL and the string selection signal lines SGDT, SGD, and SGS of the cell block CB. The WL_SG driver DV is electrically coupled to the WL terrace TR via the contact plug CC. That is, the WL_SG driver DV is electrically coupled to the word line WL and the string selection signal lines SGDT, SGD, and SGS. In the example illustrated in the part (b) of FIG. 7A, four WL_SG drivers DV are provided corresponding to four cell blocks CB.

The WPB control unit is a circuit that controls the write control signal lines WBSO and WBS1. The WPB control unit is electrically coupled to the WPB terrace via the contact plugs CC. That is, the WPB control unit is electrically coupled to the write control signal lines WBSO and WBS1. In the example illustrated in the part (b) of FIG. 7A, four WPB control units are provided corresponding to four write port blocks WPB.

The RPB control unit is a circuit that controls the read control signal line RBS. The RPB control unit is electrically coupled to the RPB terrace via the contact plugs CC. That is, the RPB control unit is electrically coupled to the read control signal lines RBS. In the example illustrated in the part (b) of FIG. 7A, four RPB control units are provided corresponding to four read port blocks RPB.

### 1.6 Effects of present Embodiment

The effects of the present embodiment will now be described.

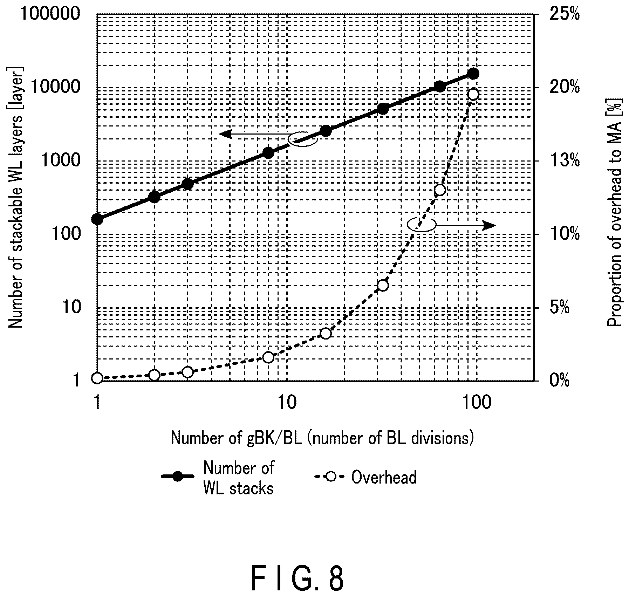

FIG. 8 is a graph illustrating the effects of the first embodiment by indicating the relationship among the number of gain blocks per bit line (the number of bit line divisions) of the memory cell array MA, the number of stackable word line layers, and the proportion of overhead for the memory cell array MA due to the gain block gBK.

The gain block gBK includes the cell block CB, and includes the read port block RPB and the write port block WPB provided on both sides of the cell block CB. Thus, an area of the memory cell array MA includes an area of the read port block RPB and a write port block WPB (hereinafter also referred to as an "overhead").

As illustrated in FIG. 8, as the number of gain blocks gBK per bit line increases, the number of read port blocks RPB and the write port blocks WPB (overhead) also increases in proportion to the number of gain blocks gBK. However, for example, even if the gain block gBK is divided into 16 segments, the proportion of overhead to the memory cell array MA is suppressed to approximately 3.3%. In this case, the number of stackable word lines layers is 2,592 layers, which easily exceeds 2,000 layers. For example, in a case where the bit line length/local bit line length ratio is 64 (64 divisions), a word line stack number of 10,000 layers can be implementable with a 13% increase in the area of the memory cell array MA. This makes it possible to solve the problem of low speed and the problem of increased chip area at a constant speed caused by a shortage of cell current Icell. The inventors of the present invention refer to this 3D-NAND flash memory as "gNAND" (gain NAND Flash, or gain Block NAND Flash Memory). Alternatively, the inventors also refer to it as "gBiCS Flash".

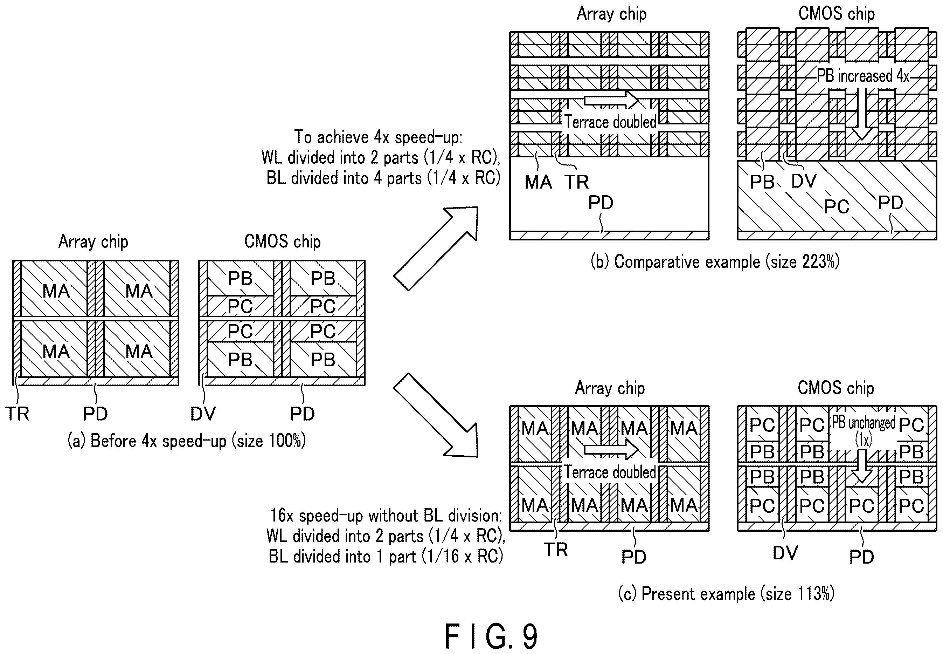

FIG. 9 is a diagram illustrating the effect of the first embodiment by comparing chip sizes between a comparative example and an example of the present embodiment in which the processing speed is increased by four times. For example, a high-speed version of NAND flash memory can be used as a cache with a memory such as compute express link (CXL) (trademark). The part (a) of FIG. 9 illustrates an example of the chip size of 3D-NAND flash memory (e.g., BiCS Flash (trademark)) before the four-fold increase in speed. The part (b) of FIG. 9 illustrates, as a comparative example, the chip size in a case where the speed is increased by four times using the conventional approach. The part (c) of FIG. 9 illustrates, as a present example, the chip size in a case where the speed is increased by four times by applying the present embodiment.

For example, to reduce an access time tR to the memory cell array MA to one quarter, each delay needs to be reduced to one quarter. If the memory cell array MA is divided into two parts in the word line direction (horizontal direction of the chip), because the word line length is halved, causing both a resistance and a capacitance to be halved, resulting in a total of the word line delay can be reduce to one quarter. However, the bit line length determines the speed by resistance R and bit line capacitance C in relation to the cell current Icell. Thus, the driving time of bit line BL fails to be increased by four times unless the bit line length is reduced to one quarter. Thus, as illustrated in the part (b) of FIG. 9, even if the bit line BL is divided into four parts, an area of the page buffer PB for each bit line BL remains unchanged, so the page buffer PB in the chip vertical direction increases from two stages to eight stages, the CMOS chip extends beyond the array chip, and the chip size increases by 223% compared to the part (a) of FIG. 9. On the other hand, as illustrated in the part (c) of FIG. 9, in the present example, even if the memory cell array MA is divided into two parts in the word line direction, the area occupied by the WL terrace TR (word line stepped part) in the chip is smaller than that of the page buffer PB, resulting in only small increase in the area. In the bit line direction, it is sufficient to form the local bit line LBL with a length that is one quarter of the bit line BL length, without dividing the bit line BL itself. In this case, as illustrated in FIG. 8, the overhead due to the read port block RPB and the write port block WPB is kept to just 0.4%. In the end, in a case where the present embodiment is applied, it is possible to achieve a fourfold faster chip while limiting the chip size to 113%.

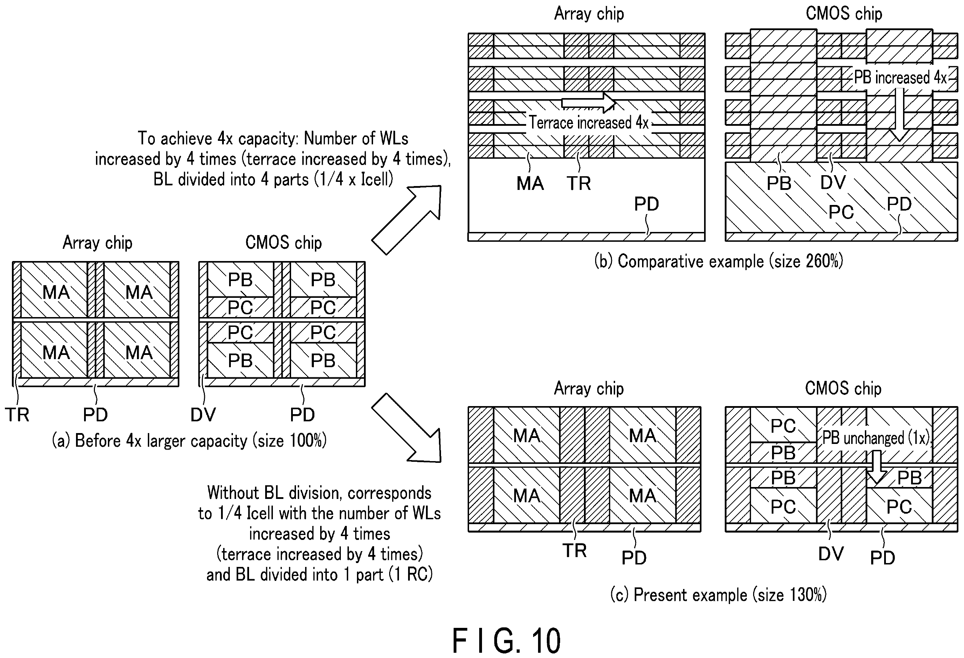

FIG. 10 is a diagram illustrating the effects of the first embodiment by exemplifying a comparison of chip sizes between a comparative example and an example of the present embodiment in which the memory capacity is increased four times. The part (a) of FIG. 10 illustrates an example of the chip size of 3D-NAND flash memory (e.g., BiCS Flash (trademark)) before the capacity is increased four times. The part (b) of FIG. 10 illustrates the chip size in a case where the capacity is increased four times by the conventional approach as a comparative example. The part (c) of FIG. 10 illustrates the chip size in a case where the capacity is increased four times by applying the present embodiment as a present example.

The chip size in the part (a) of FIG. 10 is set to 100%. As illustrated in the part (b) of FIG. 10, in a case of increasing the capacity four times by the conventional approach under a constant speed condition, the number of divisions of the word line WL remains the same as in the part (a) of FIG. 10, but the number of stacked word lines increases fourfold. Thus, the area of the WL terrace TR (word line stepped portion) is required to be four times larger. Furthermore, the number of stacked word lines is four times larger, so the cell current Icell is reduced to one quarter. Thus, to reduce the bit line capacity to one quarter, the bit line BL needs to be divided into four parts. As a result, the page buffer PB extends beyond the size of the array chip, causing the chip size to increase to 260%. On the other hand, in the present example of the part (c) of FIG. 10, in a case of increasing the capacity by four times, the area of the WL terrace TR in the word line direction becomes four times larger, but in the bit line direction, four gain blocks gBK are coupled to each bit line BL, resulting in only a slight increase in the chip size. As a result, it is possible to implement the 3D-NAND flash memory with four times the memory capacity at a chip size of 1300.

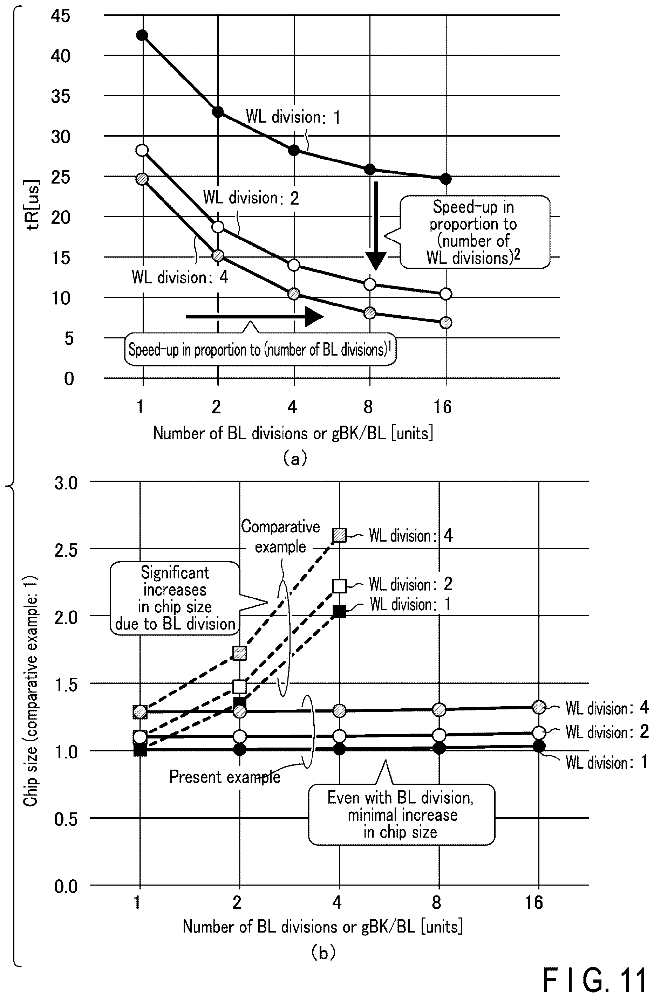

FIG. 11 illustrates more detailed effects of the first embodiment by using the relationship among the number of gain blocks per bit line of the memory cell array MA, the part (a) indicates read latency (tR), and the part (b) indicates the chip size.

As illustrated in the part (a) of FIG. 11, as the number of word line divisions increases to 2 and 4, the word line delay decreases to one-quarter and one-eighth, respectively, and the read latency (tR) becomes determined by the delay rule of the bit line BL. In addition, as the number of bit line divisions or the number of gain blocks increases to 2, 4, 8, and 16, the delay of the bit line BL decreases proportionally to 1/2, 1/4, 1/8, and 1/16, respectively.

As illustrated in the part (b) of FIG. 11, in the comparative example (conventional approach), as the bit line division proceeds, the area of the page buffer PB becomes significantly larger, leading to a rapidly increase in the chip size. In contrast, in the present example, even as the number of bit line divisions increases, the chip size increases only slightly.

As illustrated in the parts (a) and (b) of FIG. 11, in the comparative example (conventional approach), to achieve a read latency of tR = 10 µs, it is necessary to divide both the word line WL and the bit line BL into four parts. In that case, the chip size will be 2.6 times larger. In contrast, in the present example, the combination of the conditions of 16 divisions of the bit line and 2 divisions of the word line, which results in minimal chip size increase, makes it possible to achieve the same read latency tR = 10 µs with only a 1.1 times increase in chip area.

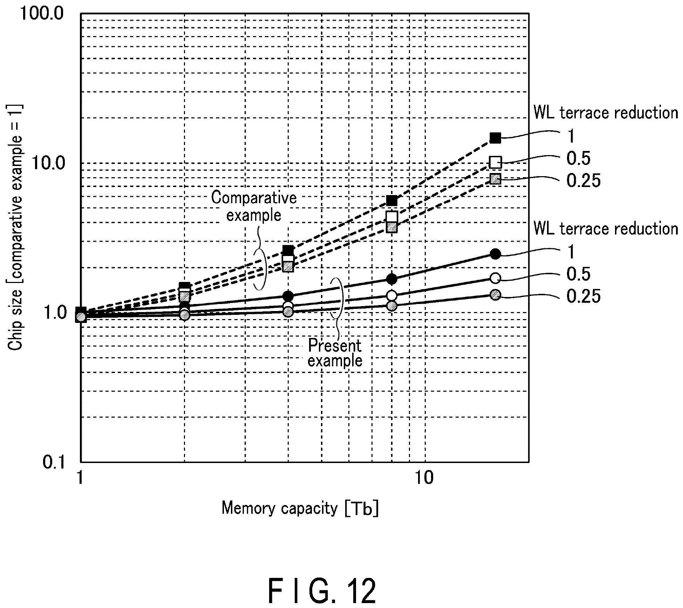

FIG. 12 illustrates the effects of the first embodiment by using the relationship between memory capacity and the chip size under a constant speed condition in a case where the word lines WL of the 3D-NAND flash memory are stacked to increase the memory capacity. In the comparative example (conventional approach) and the present example, as the number of stacked word lines increases, an area occupied by the WL terrace TR (word line stepped portion) and the WL_SG driver (drive circuit) increases. Reducing this area requires additional techniques, and the only way to minimize an area of the WL terrace TR (word line step portion) is by shrinking it. In the bit line direction, the area of the page buffer PB increases (by N times) in the comparative example (conventional approach) due to an increase in the number of stacked word lines (by N times), but in the present example, the page buffer area hardly increases.

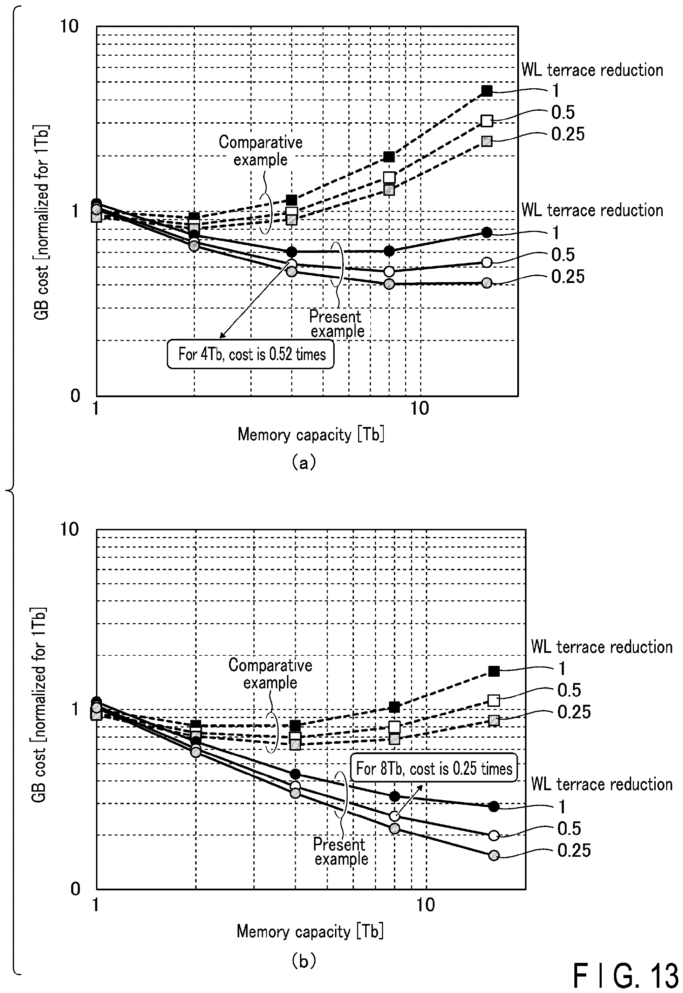

FIG. 13 illustrates the effects of the first embodiment by using the relationship between memory capacity and cost per gigabyte (GB) in a case where the word lines WL of the 3D-NAND flash memory are stacked to increase the memory capacity from 1 Tb. In this context, the mobility in silicon and the speed are constant. The part (a) of FIG. 13 illustrates a case where the number of stacked word lines per layer (per 1 tier) is constant. In this context, 1 tier refers to a unit in which the memory holes (MH) are opened using reactive ion etching (RIE). The part (b) of FIG. 13 illustrates a case where the number of stacked word lines per tier can be increased gradually by increasing the number of stacked word lines.

As illustrated in the part (a) of FIG. 13, in the comparative example (conventional approach), in a case of increasing the number of stacked word lines, the area of the page buffer PB increases to compensate for a decrease in cell current Icell, so the cost saturates at 2 Tb. On the other hand, in the present example, if the WL terrace TR (word line stepped portion) can be gradually reduced, increasing the number of stacked word lines to expand the memory capacity to 4 through 16 Tb will continuously lower the cost per gigabyte (Gb).

For example, in a conventional structure, a large number of memory cell strings are coupled to the bit line BL, which reduces the cell current and critically slows down an operation. In contrast, with a configuration according to the present embodiment, the number of memory cell strings MSR coupled to each local bit line LBL can be reduced, significantly lowering the load capacitance driven by the cell current, which in turn speeds up the read operation to the local bit line LBL. Thus, even if the number of serial cells of the memory cell string MSR is doubled by stacking the word lines WL highly, the load on the local bit line LBL is reduced, allowing for the same or even faster speed compared to the conventional speed. In addition, the potential of the local bit line LBL is amplified by the amplification transistor APT, enabling it to drive the larger capacitance of the bit line BL, but the number of transistors in series in the amplifier portion is small, and so this portion can also operate at high speed.

### 2. Second Embodiment

The following describes a second embodiment. In the second embodiment, a case where a read source line RSL and a source line SL are shared by one semiconductor layer 12 is described. The read source line RSL and the source line SL can be electrically coupled via other interconnect. The following description focuses on differences from the first embodiment.

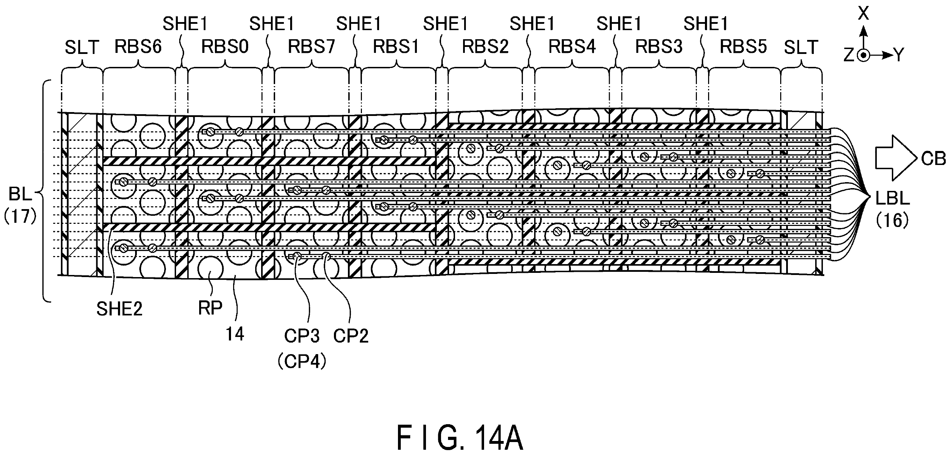

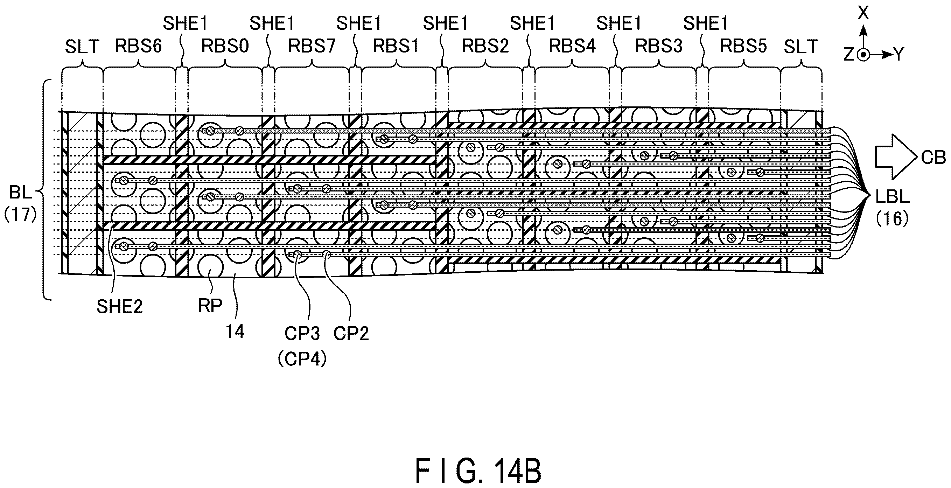

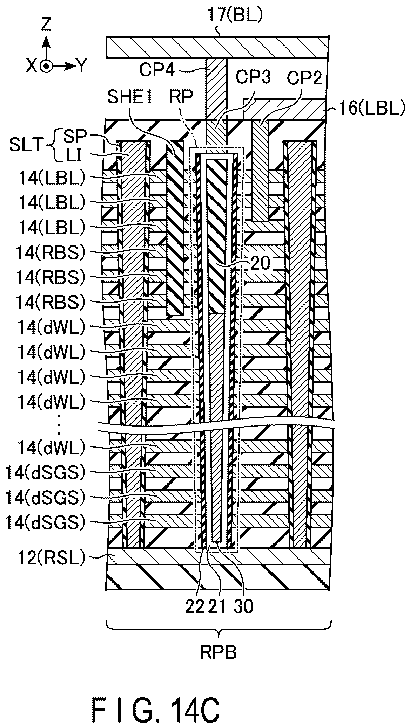

An exemplary configuration of a read port block RPB is described with reference to FIGS. 14A, 14B, and 14C. FIG. 14A is a plan view illustrating a first example of a planar layout of the read port block RPB according to the second embodiment. FIG. 14B is a plan view illustrating a second example of the planar layout of the read port block RPB according to the second embodiment. FIG. 14C illustrates an example of a cross-sectional view in the bit line direction (Y direction) of the read port block RPB according to the second embodiment.

Referring to FIG. 14C, the cross-sectional structure of the read port block RPB according to the second embodiment will now be described.

As illustrated in FIG. 14C, a semiconductor layer 12 that functions as the read source line RSL is not divided in the Y direction in the read port block RPB. The semiconductor layer 12 that functions as the read source line RSL extends in the Y direction and is shared with the semiconductor layer 12 that functions as the source line SL. In other words, a pillar RP is coupled to the semiconductor layer 12 that functions as the source line SL. The other configurations are similar to those in FIG. 3 of the first embodiment.

Referring to FIG. 14A, the first example of the planar layout of the read port block RPB according to the second embodiment will now be described.

As illustrated in FIG. 14A, in this example, the member SLT arranged between the read control signal lines RBS1 and RBS2 in FIG. 5A of the first embodiment is replaced with a member SHE1. The other .layouts are similar to those in FIG. 5A of the first embodiment.

Then, with reference to FIG. 14B, the second example of the planar layout of the read port block RPB according to the second embodiment will now be described.

As illustrated in FIG. 14B, in this example, the unused pillar RP located near the contact plug CP2 described using FIG. 14A is removed. That is, in this example, the member SLT arranged between the read control signal lines RBS1 and RBS2 in FIG. 5B of the first embodiment is replaced with the member SHE1.

The basic effect of the present embodiment is the same as that of the first embodiment, where the amplification transistor APT using the stacked layer and the pillar RP is implemented using the process structure of the cell block CB. The difference from the first embodiment is that the electrical current flowing through the electrical current path of the amplification transistor APT is shared with the source line SL of the cell block CB via the transistor RST to which the read control signal line RBS is coupled. The read source line RSL is shared with the source line SL coupled to the member SLT at the edge portion of the read port block RPB.

### 3. Third Embodiment

The following describes a third embodiment. In the third embodiment, the description is given for a case in which a coupling positions of two pillars WP1 and WP2 and a coupling position between a pillar RP and a read source line RSL are different from those in the first embodiment. The following description focuses on differences from the first and second embodiments.

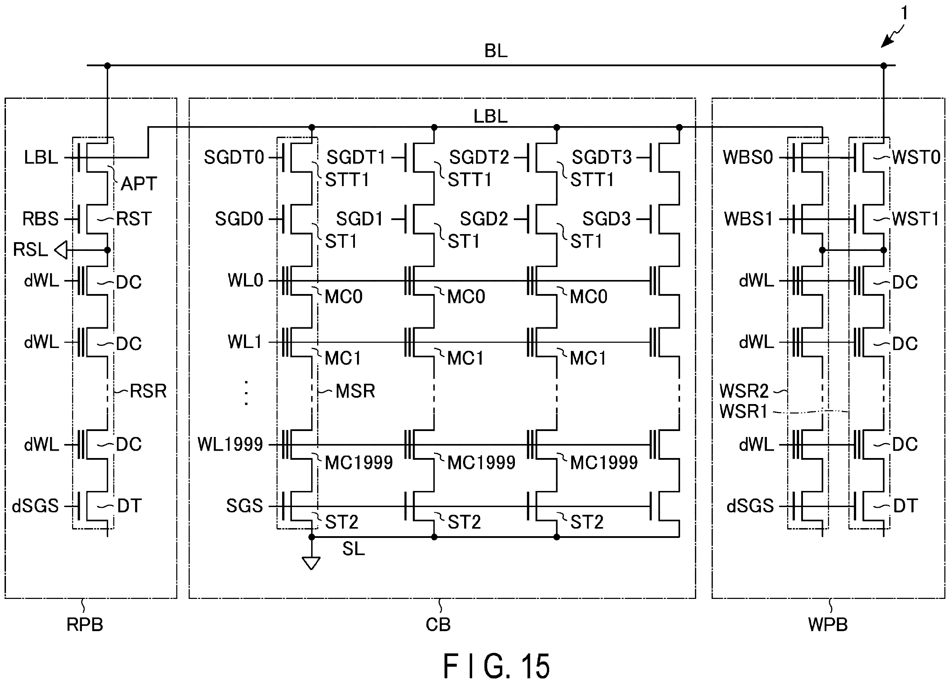

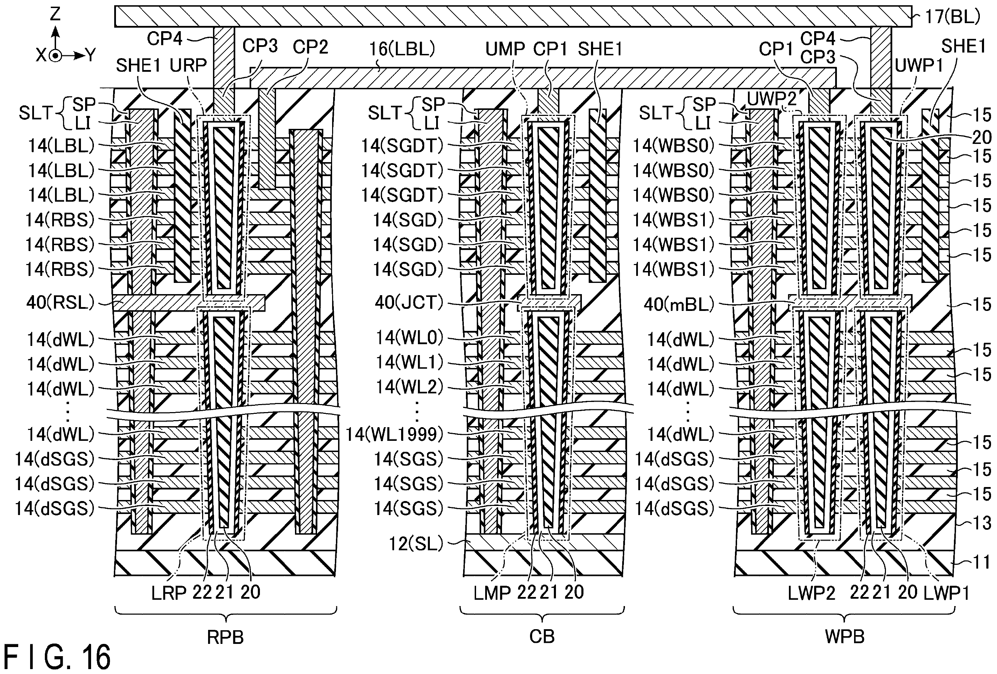

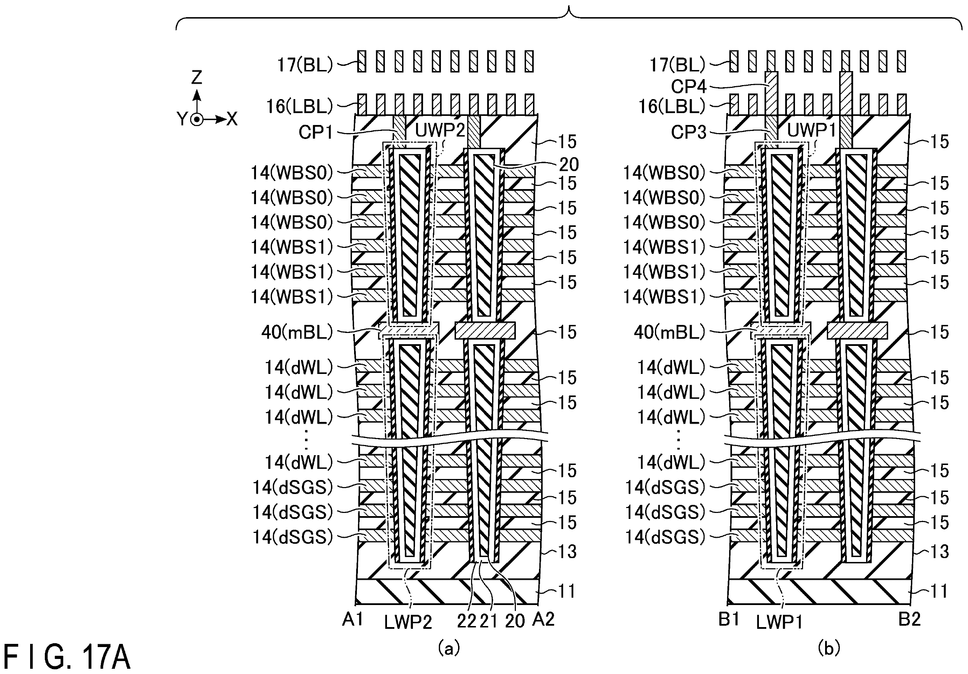

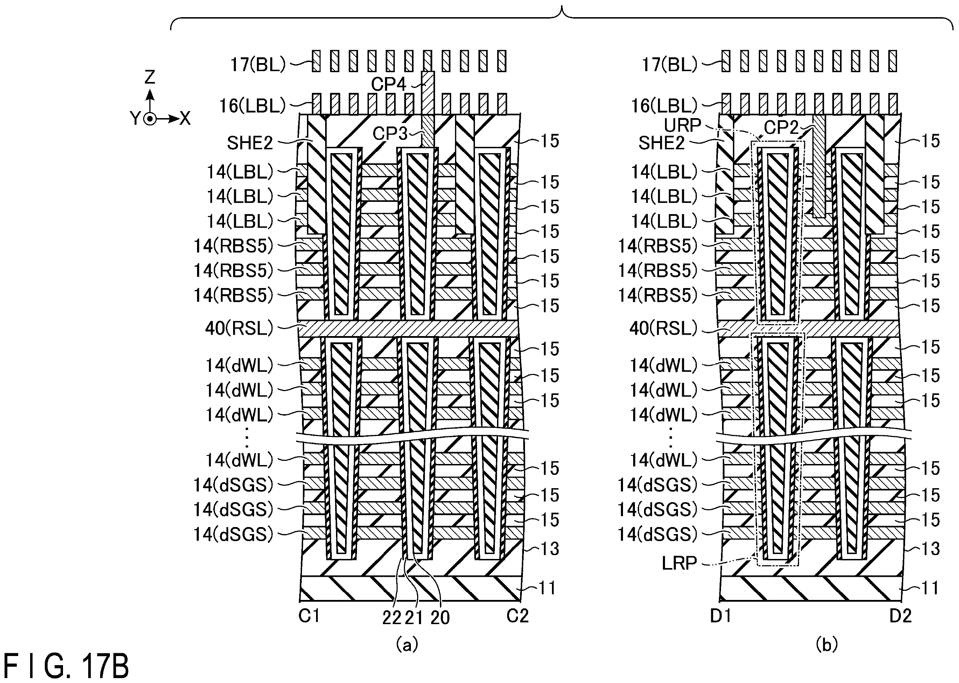

The following describes an example of a configuration of a gain block gBK according to the third embodiment with reference to FIGS. 15, 16, 17A, and 17B. FIG. 15 illustrates an example of an equivalent circuit diagram of the gain block gBK according to the third embodiment. FIG. 15 illustrates an example of a cell block CB including a plurality of memory cell strings MSR coupled to a local bit line LBL, a write port block WPB that transmits a potential of a bit line BL to the local bit line LBL, and a read port block RPB that amplifies a potential of the local bit line LBL and transmits it to the bit line BL. FIG. 16 illustrates an example of a cross-sectional view of the gain block gBK according to the third embodiment in the bit line direction (Y direction). FIG. 16 illustrates an example of a cross-sectional structure of a part of the cell block CB including a plurality of memory cell strings MSR coupled to the local bit line LBL, the write port block WPB that transmits the potential of the bit line BL to the local bit line LBL, and the read port block RPB that amplifies the potential of the local bit line LBL and transmits it to the bit line BL. The parts (a) and (b) of FIG. 17A illustrate cross-sectional views of the write port block WPB in the word line direction (X direction). The parts (a) and (b) of FIG. 17B illustrate cross-sectional views of the read port block RPB in the word line direction (X direction).

As illustrated in FIG. 15, the circuit configuration of the cell block CB is similar to that of the first embodiment.

In the write port block WPB, a source of a transistor WST1 of a string WSR1 coupled to the bit line BL is coupled to a source of a transistor WST1 of a string WSR2 coupled to the local bit line LBL. In the present embodiment, a source of a dummy transistor DT of the string WSR1 and a source of the dummy transistor DT of the string WSR2 are not coupled to each other.

In the read port block RPB, a source of a transistor RST is coupled to a read source line RSL. A source of the dummy transistor DT is not coupled to the read source line RSL. According to a present embodiment, dummy cells DC and dummy transistor DT of the write port block WPB and the read port block RPB are not used as an electrical current path.

As illustrated in FIG. 16, a memory pillar MP of the present embodiment includes a lower memory pillar LMP and an upper memory pillar UMP provided above the lower memory pillar LMP. Structures of the lower memory pillar LMP and the upper memory pillar UMP are the same as the structure of the memory pillar MP described using FIG. 3 of the first embodiment. The lower memory pillar LMP penetrates a plurality of interconnect layers 14 that function as a word line WL or a string selection signal line SGS, and its bottom surface is in contact with a semiconductor layer 12. The upper memory pillar UMP penetrates a plurality of interconnect layers 14 that function as a string selection signal line SGDT or SGD. On the upper memory pillar UMP, a contact plug CP1 is provided. In the Z direction, an interconnect layer 40 is provided between the interconnect layer 14 that functions as a word line WL0 and the interconnect layer 14 that functions as the string selection signal line SGD. An upper surface of the lower memory pillar LMP and a lower surface (surface facing the other end in the Z direction) of the upper memory pillar UMP are in contact with the interconnect layer 40. The interconnect layer 40 in the cell block CB functions as a junction JCT that couples the lower memory pillar LMP and the upper memory pillar UMP included in a single memory pillar MP. Thus, the interconnect layer 40 is provided for each memory pillar MP. The interconnect layer 40 provided in the cell block CB is not in contact with a conductor LI of a member SLT. The interconnect layer 40 in the cell block CB may be omitted. In this case, the upper memory pillar UMP is provided on the lower memory pillar LMP.

As illustrated in FIGS. 16 and 17A, in the write port block WPB, the pillar WP has a similar structure to the memory pillar MP. In the Z direction, the interconnect layer 40 is provided between the interconnect layer 14 that functions as a dummy word line dWL and the interconnect layer 14 that functions as a write control signal line WBS1.

The pillar WP1 includes a lower pillar LWP1 and an upper pillar UWP1. Similarly, the pillar WP2 includes a lower pillar LWP2 and an upper pillar UWP2. Unless specifically referring to either the lower pillar LWP1 or LWP2, they are collectively hereinafter simply referred to as a "lower pillar LWP". Unless specifically referring to either the upper pillar UWP1 or UWP2, they are collectively hereinafter simply referred to as an "upper pillar UWP". The semiconductor layer 12 is not provided under the lower pillars LWP1 and LWP2. That is, the semiconductor layer 12 is not provided in the write port block WPB. The upper surfaces of the lower pillars LWP1 and LWP2 and the lower surfaces of the upper pillars UWP1 and UWP2 are in contact with the interconnect layer 40. On the upper pillar UWP1 that is coupled to the bit line BL (interconnect layer 17), a contact plug CP3 is provided. A contact plug CP1 is provided on the upper pillar UWP2 coupled to the local bit line LBL (interconnect layer 16). The upper pillar UWP1 coupled to the bit line BL via the contact plugs CP3 and CP4 and the upper pillar UWP2 coupled to the local bit line LBL via the contact plug CP1 are provided on one interconnect layer 40. The interconnect layer 40 provided in the write port block WPB functions as a middle bit line mBL that electrically couples the two upper pillars UWP1 and UWP2, i.e., the bit line BL and the local bit line LBL.

As illustrated in FIGS. 16 and 17B, in the read port block RPB, the pillar RP has a structure similar to that of the memory pillar MP. In the Z direction, the interconnect layer 40 is provided between the interconnect layer 14 that functions as the dummy word line dWL and the interconnect layer 14 that functions as a read control signal line RBS.

Each of the pillars RP includes a lower pillar LRP and an upper pillar URP. As in the write port block WPB, the semiconductor layer 12 is not provided under the lower pillar LRP. That is, the semiconductor layer 12 is not provided in the read port block RPB. The upper surface of the lower pillar LRP and the lower surface of the upper pillar URP are in contact with the interconnect layer 40. The contact plug CP3 is provided on the upper pillar URP. The interconnect layer 40 provided in the read port block RPB functions as the read source line RSL that electrically couples the upper pillar URP and the conductor LI of the member SLT. A plurality of upper pillars URP are provided on one interconnect layer 40.

The third embodiment provides the same effect as the first embodiment. A capacitance of the local bit line LBL is reduced, so the driving time of the local bit line LBL can be shortened even if the number of stacked word lines increases and the cell current Icell is reduced. Furthermore, a signal from the local bit line LBL can be used as an input of the amplification transistor APT of the read port block RPB to drive the bit line BL at high speed. The write operation is performed by setting a voltage of the write control signal lines WBS0 and WBS1 of the write port block WPB to a high level, thereby electrically coupling the local bit line LBL and the bit line BL. The difference from the first embodiment is that the semiconductor layer 12 is not provided in the read port block RPB and the write port block WPB. In the write port block WPB, the interconnect layer 40 that functions as the middle bit line mBL is provided between the interconnect layer 14 that functions as the dummy word line dWL and the interconnect layer 14 located above and functioning as the write control signal line WBS1. Similarly, in the read port block RPB, the interconnect layer 40 that functions as the read source line RSL is provided between the interconnect layer 14 that functions as the dummy word line dWL and the interconnect layer 14 located above and functioning as the read control signal line RBS.

In the write port block WPB, the bit line BL is electrically coupled to the local bit line LBL via transistors WSTO and WST1 of the string WSR1, the interconnect layer 40 (middle bit line mBL), and transistors WST1 and WSTO of the string WSR2.

In the read port block RPB, the bit line BL is electrically coupled to the interconnect layer 40 (read source line RSL) via the amplification transistor APT and the transistor RST.

In the present embodiment, unlike the first embodiment, the dummy cells DC and the dummy transistors DT of the strings WSR and RSR are not used as an electrical current path. In the present embodiment, providing the interconnect layer 40 in the stacked layers makes it possible to suppress the deterioration of parasitic resistance in the write operation and the read operation. In the read port block RPB and the write port block WPB, the dummy cells DC corresponding to the dummy word lines dWL located below the interconnect layer 40 and the dummy transistor DT corresponding to a dummy string selection signal line dSGS are placed in a floating state by removing the semiconductor layer 12, so there is no problem in operations. If the uniformity of the processing of the memory holes MH and the holes corresponding to the pillars WP and RP is important, it is sufficient to leave the dummy holes below the interconnect layer 40.

### 4. Fourth Embodiment

The following describes a fourth embodiment. In the fourth embodiment, a structure is described in which the lower memory pillars LMP and the lower pillars LWP and LRP described in the third embodiment are removed. The following description focuses on differences from the first through third embodiments.

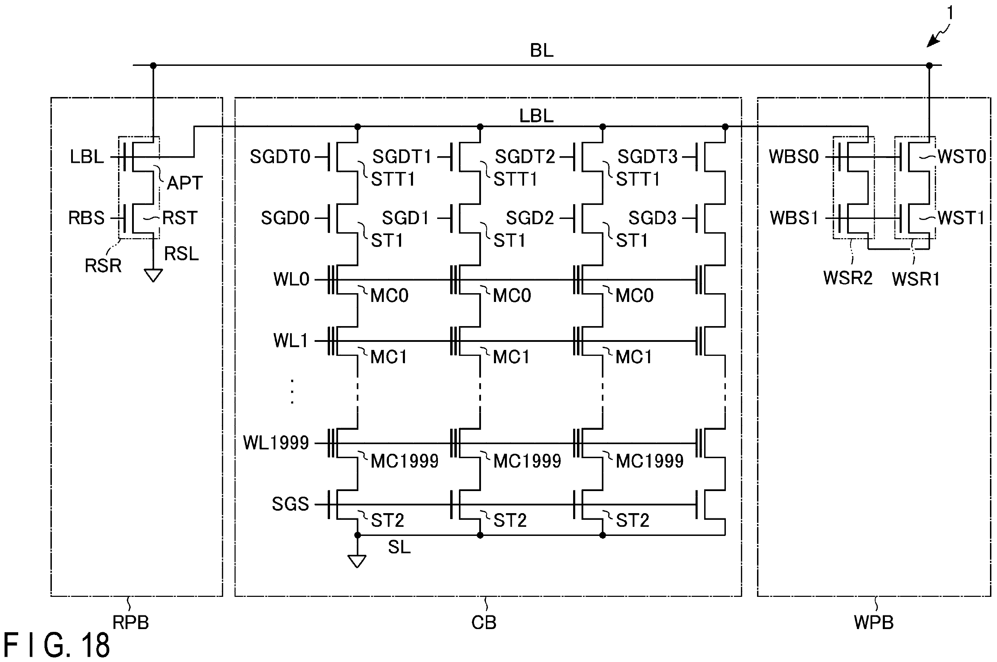

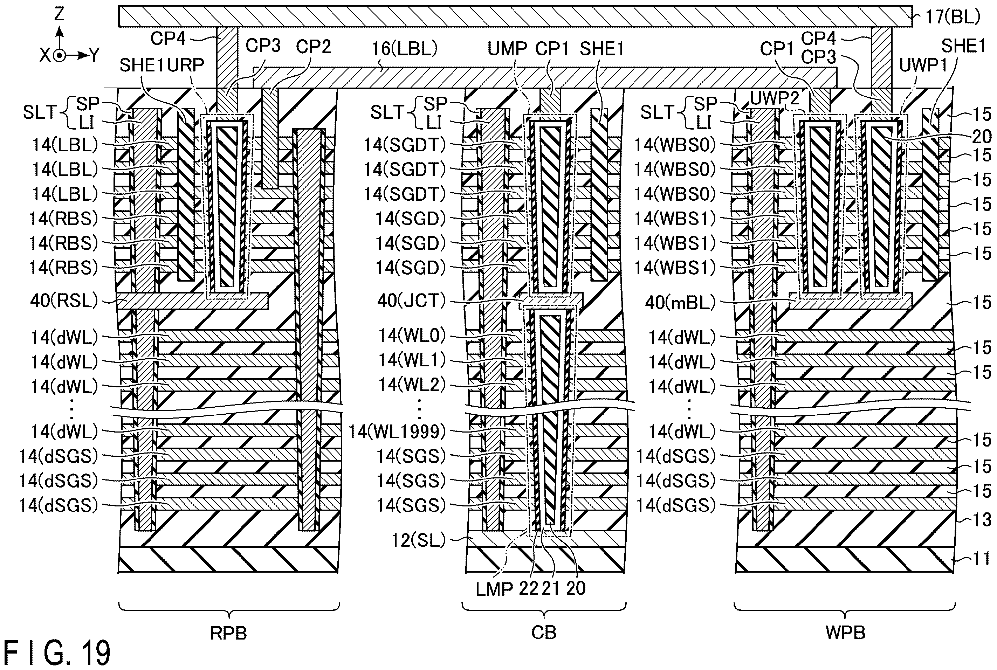

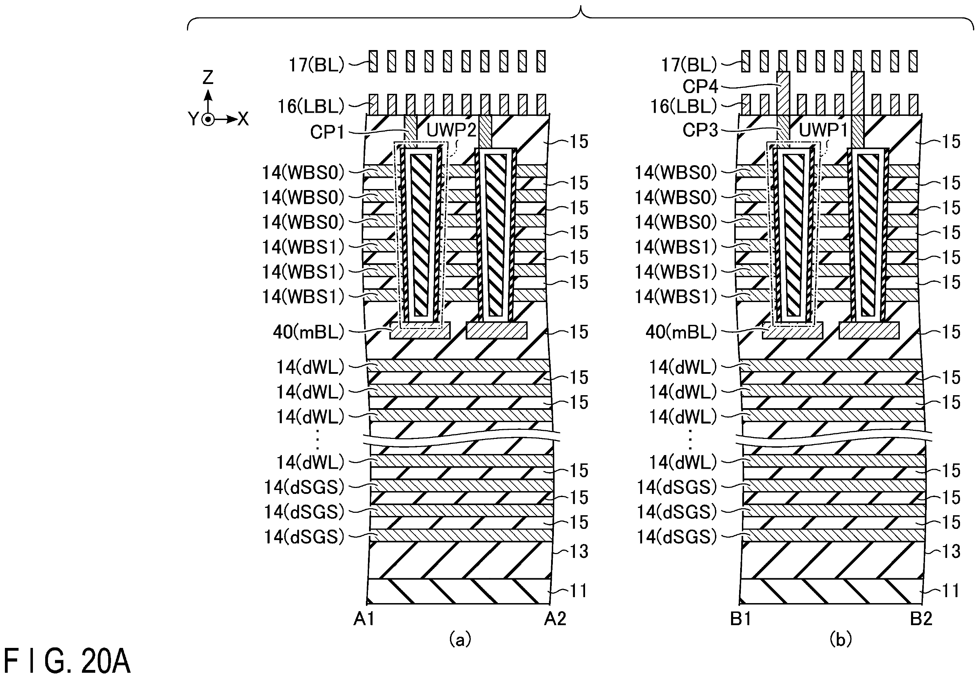

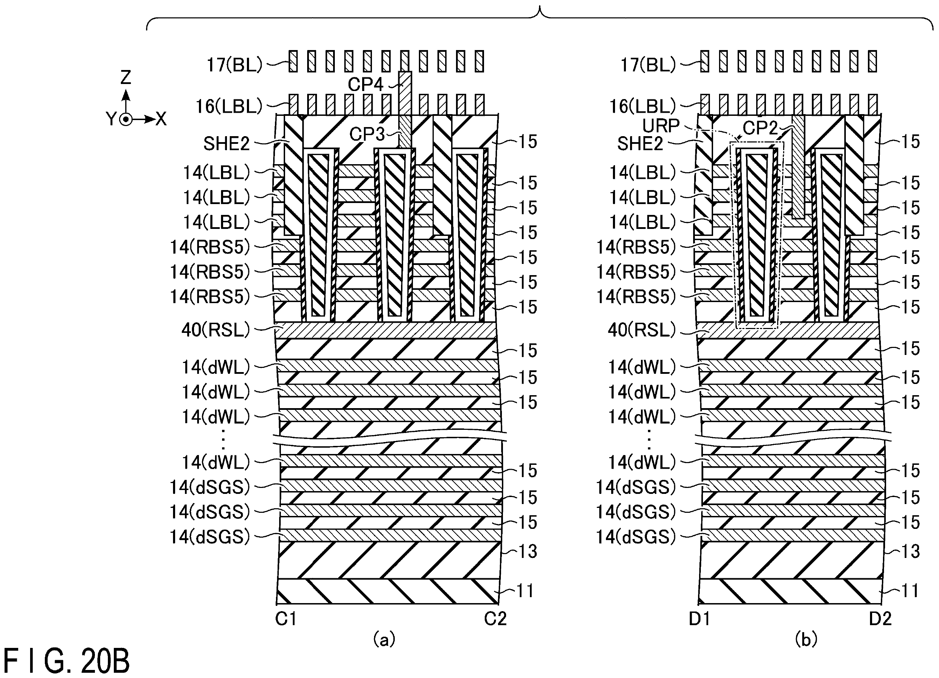

An example of a configuration of a gain block gBK according to the fourth embodiment will now be described with reference to FIGS. 18, 19, 20A, and 20B. FIG. 18 illustrates an example of an equivalent circuit diagram of the gain block gBK according to the fourth embodiment. FIG. 18 illustrates an example of a cell block CB that includes a plurality of memory cell strings MSR coupled to a local bit line LBL, a write port block WPB for transmitting a potential of the bit line BL to the local bit line LBL, and a read port block RPB for amplifying a potential of the local bit line LBL and transmitting it to the bit line BL. FIG. 19 illustrates an example of a cross-sectional view of the gain block gBK in the bit line direction (Y direction) according to the fourth embodiment. FIG. 19 illustrates an example of a cross-sectional structure of a part of the cell block CB that includes a plurality of memory cell strings MSR coupled to the local bit line LBL, the write port block WPB for transmitting the potential of the bit line BL to the local bit line LBL, and the read port block RPB for amplifying the potential of the local bit line LBL and transmitting it to the bit line BL. The parts (a) and (b) of FIG. 20A illustrate cross-sectional views in the word line direction (X direction) of the write port block WPB according to the fourth embodiment. The parts (a) and (b) of FIG. 20B illustrate cross-sectional views in the word line direction of the read port block RPB according to the fourth embodiment.

As illustrated in FIG. 18, a circuit configuration of the cell block CB is similar to that of the first embodiment.

The difference from the configuration described using FIG. 15 of the third embodiment is that the dummy cells DC and dummy transistors DT are eliminated in the write port block WPB and read port block RPB.

As illustrated in FIGS. 19 and 20A, in the present embodiment, the lower pillars LWP1 and LWP2 described using FIGS. 16 and 17A of the third embodiment are eliminated in the write port block WPB.

As illustrated in FIGS. 19 and 20B, in the present embodiment, the lower pillar LRP of the pillar RP described using FIGS. 16 and 17B of the third embodiment is eliminated in the read port block RPB.

The other configurations are similar to those of the third embodiment.

The fourth embodiment provides the same effect as the first embodiment, and like the third embodiment, the interconnect layer 40 can be used as a coupling interconnect of the write port block WPB and as a sink power supply for a current flowing through the amplification transistor APT. The difference from the third embodiment is the removal of the floating and unnecessary pillars formed in the dummy holes below the interconnect layer 40.

### 5. Fifth Embodiment

The following describes a fifth embodiment. In the fifth embodiment, an example of a write operation and a read operation is described. The following description focuses on differences from the first through fourth embodiments.

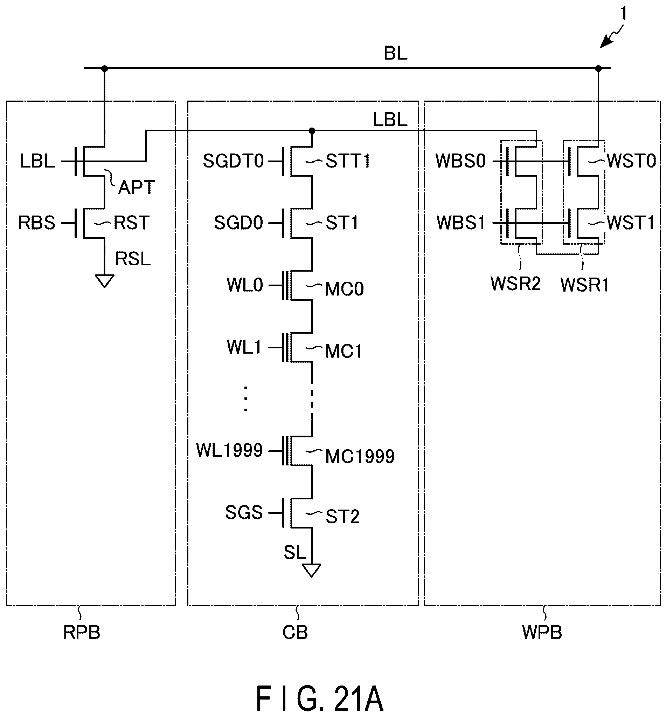

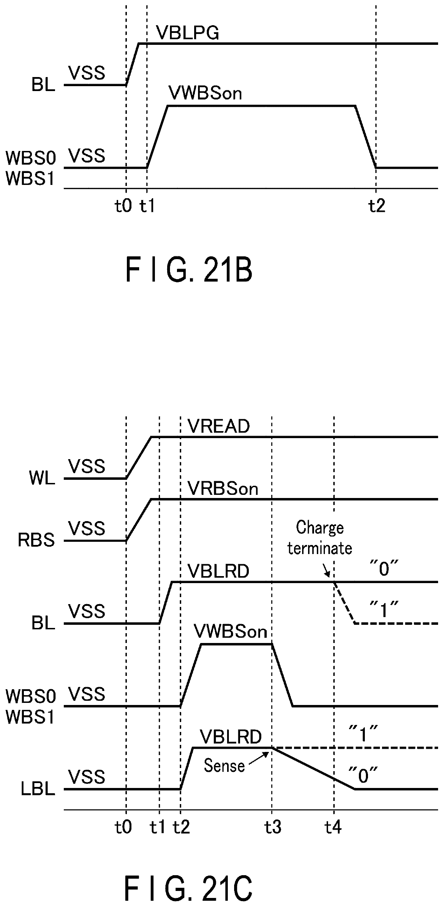

The fifth embodiment is described with reference to FIGS. 21A, 21B, and 21C. FIG. 21A is a simplified equivalent circuit diagram of a gain block gBK according to the fifth embodiment. FIG. 21B is a timing chart illustrating an example of a voltage of each interconnect in a write operation of a non-volatile semiconductor memory device 1 according to the fifth embodiment. FIG. 21C is a timing chart illustrating an example of a voltage of each interconnect in a read operation of the non-volatile semiconductor memory device 1 according to the fifth embodiment.

As illustrated in FIG. 21A, in a write port block WPB, a bit line BL is coupled to a local bit line LBL via four transistors WSTO, WST1, WST1, and WSTO coupled in series. The two transistors WSTO have their gates coupled with a write control signal line WBS0. The two transistors WST1 have their gates coupled with a write control signal line WBS1.

In a cell block CB, a memory cell string MSR (memory pillar MP) is coupled to the local bit line LBL. The memory cell string MSR includes string selection transistors STT1, ST1, and ST2, and 2000 memory cells MCO to MC1999. The electrical current paths of the string selection transistors STT1 and ST1, the memory cells MCO to MC1999, and the string selection transistor ST2 in the memory cell string MSR are coupled in series in this order. A string selection signal line SGDTO is coupled to a gate of the string selection transistor STT1. A string selection signal line SGD0 is coupled to a gate of the string selection transistor ST1. Word lines WL0 to WL1999 are coupled to control gates of the memory cells MCO to MC1999, respectively. A string selection signal line SGS is coupled to a gate of the string selection transistor ST2.

In the read port block RPB, transistors APT and RST are coupled in series. A drain of the transistor APT is coupled to the bit line BL, its source is coupled to a drain of the transistor RST, and its gate is coupled to the local bit line LBL. A source of the transistor RST is coupled to a read source line RSL, and its gate is coupled to a read control signal line RBS.

The write operation is described with reference to FIG. 21B.

As illustrated in FIG. 21B, first, at time t0, a page buffer PB applies a voltage VBLPG to the bit line BL. The voltage VBLPG is a positive voltage higher than a ground voltage VSS.

Subsequently, at time t1, in the write port block WPB, a voltage VWBSon is applied to the write control signal lines WBS0 and WBS1. The voltage VWBSon is a high-level voltage that turns on the transistors WSTO and WST1. Applying the high-level voltage VWBSon to the write control signal lines WBS0 and WBS1 causes the transistors WSTO and WST1 to be turned on. A potential of the bit line BL is transmitted to the local bit line LBL via the transistors WSTO and WST1. Bit information from the page buffer PB (including a sense amplifier circuit and a write circuit) is transmitted to the local bit line LBL and the memory cell string MSR via the transistors WSTO and WST1. The local bit line LBL is shorter than the bit line BL and has a smaller load than the bit line BL, so the non-volatile semiconductor memory device 1 can achieve a write speed comparable to that of the conventional memory cell.

During a period from time t1 to t2, the write operation is performed on the memory cell MC selected as the write target (hereinafter also referred to as "selected memory cell MC") in the cell block CB.

For example, during the period from time t1 to t2, the word line WL corresponding to the selected memory cell MC (hereinafter also referred to as "selected word line WL") is boosted. In this time, if the potential (voltage VBLPG) of the local bit line LBL is at a low level, the string selection transistors STT1 and ST1 are turned on. In this case, the potential of the local bit line LBL is transmitted to a silicon channel layer 21 of the selected memory cell MC to be written, and electrons are injected into a charge-trapping layer 222. This type of write operation is hereinafter referred to as a "program operation". On the other hand, in a case where the potential of the local bit line LBL (voltage VBLPG) is at a high level, a source potential is high, so the string selection transistors STT1 and ST1 are turned off. The silicon channel layer 21 is in a floating state, and the silicon channel layer 21 is also boosted with the boost of the word line WL. For this reason, almost no electrons are injected into the charge-trapping layer 222. This type of operation is hereinafter referred to as a "program inhibit". A write speed follows the FN-tunnel current rule, so it does not deteriorate even if the number of series cells in the memory cell string MSR increases.

Subsequently, at time t2, after the write operation in the cell block CB is completed, the voltage VSS is applied to the write control signal lines WBS0 and WBS1.

Referring to FIG. 21C, the read operation is described.

As illustrated in FIG. 21C, in the read operation, first, at time t0, a voltage VREAD is applied to non-selected word lines. The voltage VREAD is a voltage that turns on the memory cell MC regardless of its threshold voltage. In addition, a voltage VRBSon is applied to the read control signal line RBS. The voltage VRBSon is a voltage that turns on the transistor RST. The voltages VREAD and VRBSon are positive voltages higher than the ground voltage VSS. The voltages VREAD and VRBSon can be the same voltage value or different voltage values.

Subsequently, at time t1, a voltage VBLRD is applied to the bit line BL. The voltage VBLRD is a positive voltage higher than the ground voltage VSS.

Subsequently, at time t2, the voltage VWBSon is applied to the write control signal lines WBS0 and WBS1. By turning on the transistors WSTO and WST1, the potential of the bit line BL is transmitted to the local bit line LBL. For example, the voltage VBLRD is applied to the local bit line LBL.

Subsequently, at time t3, in a case where the voltage VSS is applied to the write control signal lines WBS0 and WBS1 as a low-level voltage, the transistors WSTO and WST1 are turned off. As a result, the local bit line LBL is placed in a floating state and is precharged to the voltage VBLRD.

At this time, a potential of the selected word line WL is gradually increased or is already set to a determined potential. In other words, a read voltage is applied to the selected word line WL. If the potential of the selected word line WL is lower than a threshold voltage Vt of the selected memory cell MC, the selected memory cell MC is turned off, so no current flows from the local bit line LBL to the memory cell string MSR. Thus, the potential of the local bit line LBL is maintained (LBL "1" in FIG. 21C). On the other hand, in a case where the potential of the selected word line WL is higher than the threshold voltage Vt of the selected memory cell MC, the selected memory cell MC is turned on, causing the cell current Icell to flow through the memory cell string MSR. Thus, the potential of the local bit line LBL drops to the ground voltage VSS (LBL "0" in FIG. 21C). In this manner, the writing information (hereinafter also referred to as a "cell signal") to the memory cell MC is read (sensed) to the local bit line LBL. At this time, a capacitance of the local bit line LBL is relatively small, so the potential of the local bit line LBL is determined at a relatively high speed. This result is transmitted to the amplification transistor APT of the read port block RPB. A gate of the amplification transistor APT is coupled to the local bit line LBL, and its drain is coupled to the bit line BL. A source of the amplification transistor APT is coupled to the transistor RST which has a gate coupled to the read control signal line RBS. A source of the transistor RST is coupled to the read source line RSL. In a case where the high-level voltage VRBSon is applied to the read control signal line RBS, the amplification transistor APT drives the bit line BL, which has a relatively large load capacitance, and the potential of the bit line BL is transmitted to the page buffer PB.

Subsequently, at time t4, the precharging of the bit line BL by the page buffer PB is terminated (completed). For example, in a case where the potential of the local bit line LBL is maintained (LBL "1" in FIG. 21C), the amplification transistor APT is turned on, and the potential of the bit line BL drops (BL "1" in FIG. 21C). In contrast, in a case where the potential of the local bit line LBL drops (LBL "0" in FIG. 21C), the amplification transistor APT is turned off, and the potential of the bit line BL is maintained (BL "0" in FIG. 21C).

In practice, the potential of the bit line BL is read out as a signal corresponding to the cell signal in a case where the precharging of the bit line BL is terminated (completed) (i.e., the precharging signal is turned off). The number of series couplings of the amplification transistor APT and the transistor RST, which receives the read control signal line RBS as a gate input, is a few transistors, and this allows for more than a tenfold increase in speed compared to the conventional approach of driving bit lines BL using 150 to 250 memory cell strings MSR coupled in series, enabling high-speed operation regardless of the number of cells coupled in series.

### 6. Sixth Embodiment

The following describes a sixth embodiment. In the sixth embodiment, an example of a read operation different from that of the fifth embodiment is described. The following description focuses on differences from the first through fifth embodiments.

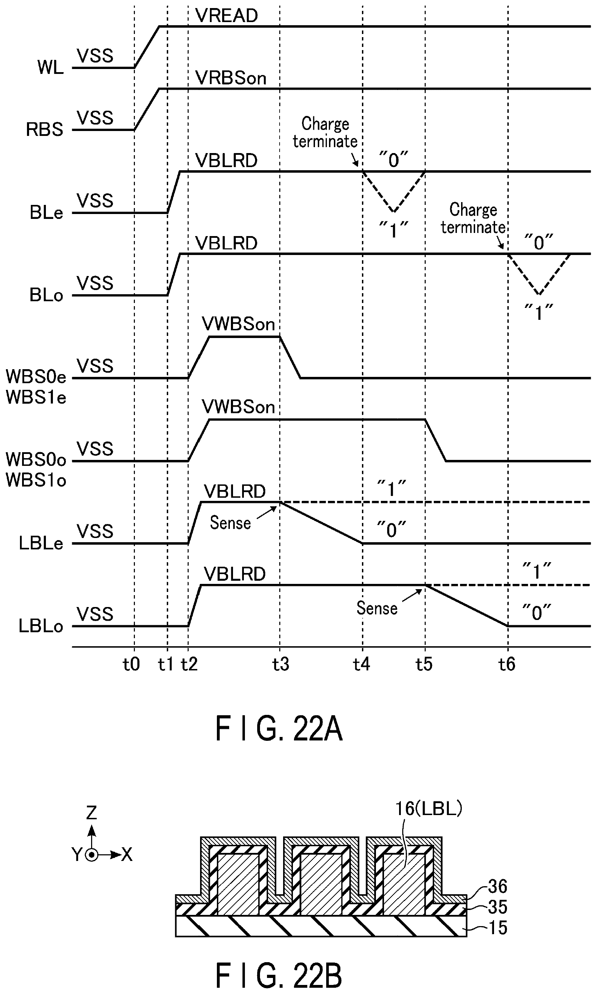

The sixth embodiment is described with reference to FIGS. 22A and 22B. FIG. 22A is a timing chart illustrating an example of a voltage of each interconnect in a case where a read operation is performed with reduced coupling noise between local bit lines LBL in a non-volatile semiconductor memory device 1 according to the sixth embodiment. FIG. 22B is a cross-sectional view illustrating an example of a cross-sectional structure that reduces coupling noise between local bit lines LBL in a non-volatile semiconductor memory device 1 according to the sixth embodiment.

For example, as described using FIGS. 32C and 32D, in a case where one of the string selection signal lines SGD separated by the member SHE1 is selected, information of the memory cells MC is read from all of the memory pillars MP (memory cell strings MSR) coupled to the string selection signal line SGD. For this reason, in a case where multiple local bit lines LBL respectively coupled to these multiple memory pillars MP are operated simultaneously, a problem occurs in which the local bit lines LBL receive noise derived from the signals of the adjacent memory cell strings MSR due to capacitive coupling with the adjacent local bit lines LBL.

As illustrated in FIG. 22B, as a solution to deal with the problem mentioned above, a method to cover the lateral and upper surfaces of the interconnect layer 16 that functions as the local bit line LBL with a thin shield metal layer 36 via an insulating layer 35 can be applied. More specifically, the thin insulating layer 35 is formed to cover a plurality of interconnect layers 16. The insulating layer 35 has a thickness that does not fill a space between the interconnect layers 16. The insulating layer 35 includes, for example, silicon oxide. Then, the shield metal layer 36 is formed on the insulating layer 35. At this time, it is preferable that the shield metal layer 36 is also formed on the lateral sides of the local bit line LBL (interconnect layer 16). In a case where the shield metal layer 36 is covered on the interconnect layer 16, the inter-interconnect capacitance of the local bit line LBL increases. However, in the present embodiment, the length of the local bit line LBL is sufficiently short compared to the length of the bit line BL, so it is possible for the inter-interconnect capacitance of the local bit line LBL to be reduced by providing a large number of gain blocks gBK, effectively eliminating problems in terms of power consumption and operational speed.

Another method is to read out a potential of the selected local bit line LBL without using the adjacent local bit lines LBL.

As illustrated in FIG. 22A, odd-numbered bit lines BLo and even-numbered bit lines BLe are selected alternately.

More specifically, first, at time t0, a voltage VREAD is applied to the non-selected word lines WL. In addition, the voltage VRBSon is applied to the read control signal line RBS.

Subsequently, at time t1, the voltage VBLRD is applied to bit lines BLo and BLe.

Subsequently, at time t2, the voltage VWBSon is applied to both even and odd write control signal lines WBS0e, WBS1e, WBS0o, and WBS1o. Turning on odd-numbered transistors WSTOo and WST1o corresponding to the bit line BLo causes a potential of the bit line BLo to be transmitted to the odd-numbered local bit line LBLo. Similarly, even-numbered transistors WST0e and WST1e corresponding to the bit line BLe are turned on, so a potential of the bit line BLe is transmitted to the even-numbered local bit line LBLe. As a result, the voltage VLBLRD is applied (precharged) to the local bit lines LBLo and LBLe.

Subsequently, at time t3, potentials of the write control signal lines WBS0o and WBSlo are maintained at a high level (voltage VWBSon) and the potential of the local bit line LBLo is fixed at a high level (voltage VBLRD), and a ground voltage VSS (low-level voltage) is applied to the write control signal lines WBS0e and WBS1e. As a result, the transistors WST0e and WST1e are turned off. At this time, a cell signal is read out to the local bit line LBLe. The potential of the adjacent local bit line LBLo is fixed at a high level, so the coupling noise of the cell signal read out to the local bit line LBLe is suppressed.

Subsequently, at time t4, the precharging of the bit line BLe by the page buffer PB is terminated. Based on the potential of the local bit line LBLe, the potential of the bit line BLe is either maintained or reduced. The page buffer PB determines the voltage of the bit line BLe and reads out the data of the bit line BLe.

Subsequently, at time t5, the bit line BLe is precharged again. The ground voltage VSS (low-level voltage) is applied to the write control signal lines WBS0o and WBS1o. This turns off the transistors WST0o and WST1o. At this time, the cell signal is read out to the local bit line LBLo.

Subsequently, at time t6, the precharging of the bit line BLo by the page buffer PB is terminated. The potential of the bit line BLo is either maintained or decreased based on the potential of the local bit line LBLo. The page buffer PB determines the voltage of the bit line BLo and reads out the data of the bit line BLo.

The signals of the local bit lines LBLo and LBLe can be read out to the bit line BL after the precharging of the bit line BL is terminated by applying the high-level voltage (voltage VRBSon) to the read control signal line RBS and amplifying it with the amplification transistor APT. It is possible for the coupling between the signals of the bit line BL to be suppressed by reading the electrical current while keeping the potential of the bit line BL constant, such as with a charge transfer technique. A high-level voltage can be applied to the read control signal line RBS from the beginning, or a high-level voltage can be applied in a case where the potential of the local bit line LBL is determined and amplified by the amplification transistor APT to transmit the signal to the bit line BL. Furthermore, in a case where the local bit lines LBLe and LBLo are separated and operated at different timings, the even-numbered read control signal lines RBSe and the odd-numbered read control signal lines RBSo can be correspondingly separated and operated at different timings accordingly.

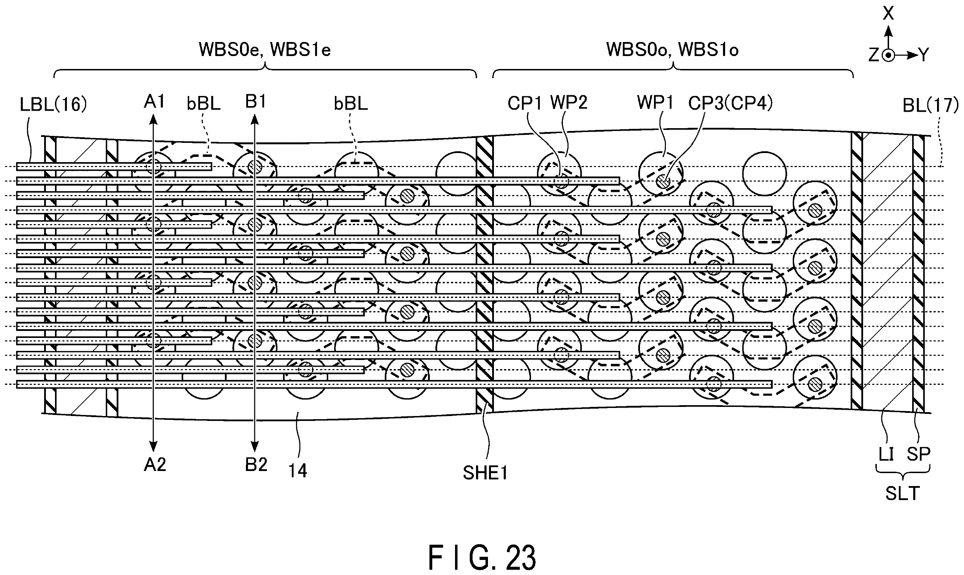

Referring FIG. 23, an example of a planar layout of the write port block WPB will now be described. FIG. 23 is a plan view illustrating an example of a planar layout of the write port block WPB according to the sixth embodiment. FIG. 23 corresponds to the description using FIG. 22A and illustrates a plan view of the write port block WPB for shielding adjacent local bit lines LBL by alternately inputting write control signal lines WBS0o and WBSlo and write control signal lines WBS0e and WBS1e.

As illustrated in FIG. 23, in the present embodiment, in the write port block WPB, a plurality of interconnect layers 14 that function as write control signal lines WBS0e or WBS1e and a plurality of interconnect layers 14 that function as write control signal lines WBS0o or WBSlo are separated in the Y direction (bit line direction) by the member SHE1.

The coupling positions of the local bit line LBL (interconnect layer 16) and the bit line BL (interconnect layer 17) are divided into even and odd positions for the write control signal lines WBS0e and WBS1e and the write control signal lines WBS0o and WBSlo for adjacent local bit lines LBL. This arrangement makes it easy to set the adjacent local bit lines LBL to a fixed potential or to remain floating, enabling the cell current Icell to be accessed from the local bit line LBL.

### 7. Seventh Embodiment

The following describes a seventh embodiment. In the seventh embodiment, an example of a read operation different from the fifth and sixth embodiments is described. The following description focuses on differences from the first through sixth embodiments.

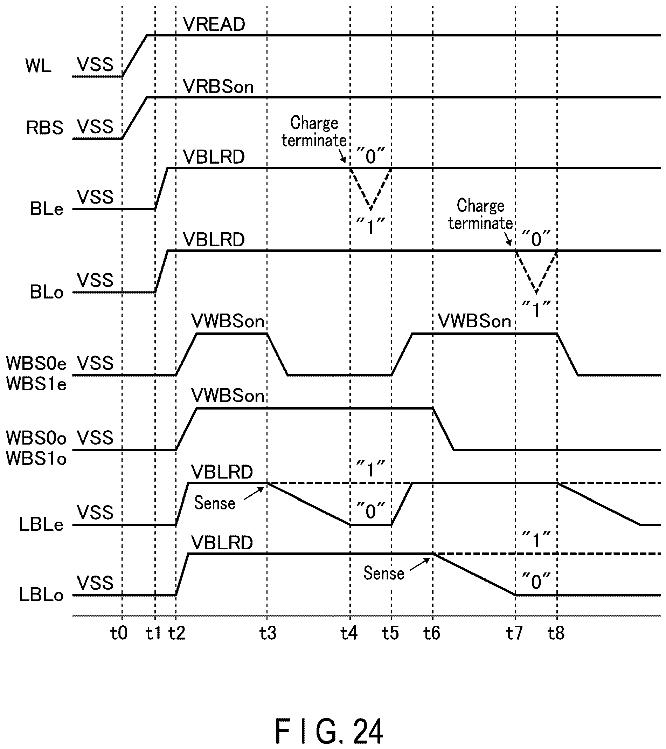

The seventh embodiment is described with reference to FIG. 24. FIG. 24 is a timing chart illustrating an example of a voltage of each interconnect in a case where the read operation is performed with reduced coupling noise between local bit lines LBL in a non-volatile semiconductor memory device 1 according to the seventh embodiment.

In the example illustrated in FIG. 22A of the sixth embodiment, the cell current Icell of the local bit line LBLe was read first, and after the voltage of the bit line BLe was determined, the cell current Icell of the local bit line LBLo was read. For example, if the local bit line LBLe remains in a floating state even after the voltage of the bit line BLe is determined, there is a problem that the signal of the local bit line LBLo is subject to coupling noise from the nearby local bit line LBLo via the floating local bit line LBLe.

As illustrated in FIG. 24, the operation from time t1 to t4 is similar to the operation from time t1 to t4 in FIG. 22A. At time t3, a low-level voltage (voltage VSS) is applied to the write control signal lines WBS0e and WBS1e to turn off the transistors WST0e and WST1e, and the cell signal is read out to the local bit line LBLe. Subsequently, during the period from time t4 to t5, the amplification transistor APT transmits the cell signal to the bit line BLe, and the result is stored in the page buffer PB.

Subsequently, at time t5, a high-level voltage (voltage VWBSon) is applied to the write control signal lines WBS0e and WBS1e. This turns on the transistors WST0e and WST1e, and the local bit line LBLe is fixed to the voltage VBLRD.

Subsequently, at time t6, a low-level voltage (voltage VSS) is applied to the write control signal lines WBS0o and WBSlo to turn off the transistors WSTOo and WST1o, and the cell signal is read out to the local bit line LBLo.

Subsequently, during the period from time t7 to t8, the amplification transistor APT transmits the cell signal to the bit line BLo, and the result is stored in the page buffer PB.

Subsequently, at time t8, a low-level voltage (voltage VSS) is applied to the write control signal lines WBS0e and WBS1e.

The procedure mentioned above makes it possible to suppress coupling noise in the local bit line LBL. In this manner, even if the word lines WL operate simultaneously, the operation becomes slow in a case where the bit line BL system is read out in two separate steps, but according to the present embodiment, the operating speed of the local bit line LBL and the bit line BL can be dramatically increased by increasing the number of gain blocks gBK, so this does not pose a problem. A potential range of the bit line BL and the local bit line LBL can be from 0 to 0.7 V, from 0.3 V to 1.0 V, or from -0.2 V to 1.2 V. Furthermore, to detect a memory cell MC with a low threshold voltage, the potential range of the bit line BL and the local bit line LBL can be increased to 0.7 V through 1.4 V with the potential of the source line SL at 0 V, and in this case, the potential of the read source line RSL can be set to approximately 0.7 V, or the potential of the read source line RSL can be set to approximately 0 V by increasing the threshold voltage of the amplification transistor APT. By adjusting the threshold voltage and margin of the amplification transistor APT, the potential range of the bit line BL and the local bit line LBL can be customized.

### 8. Eighth Embodiment

The following describes an eighth embodiment. In the eighth embodiment, two examples of a method to control a threshold voltage Vt of an amplification transistor APT are described. The following description focuses on differences from the first through seventh embodiments.

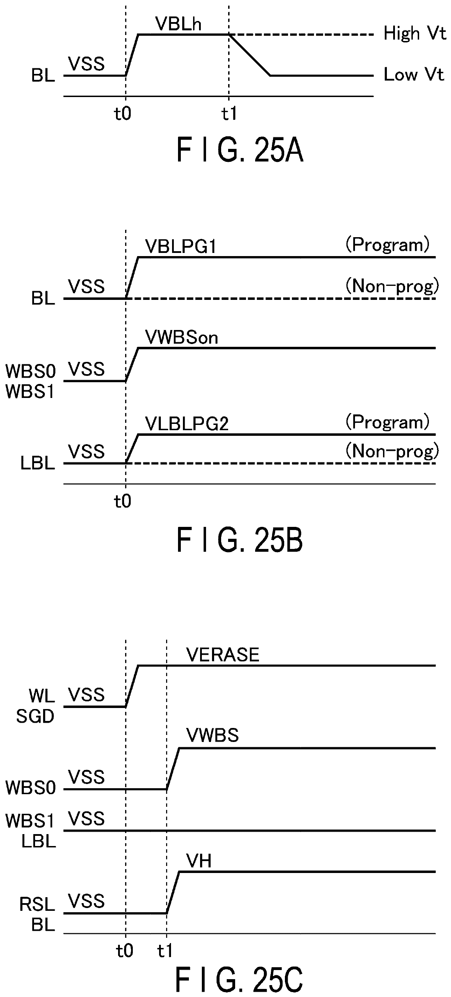

The eighth embodiment is described with reference to FIGS. 25A, 25B, and 25C. FIG. 25A is a timing chart illustrating an example of a method to measure a threshold voltage Vt of an amplification transistor APT according to the eighth embodiment. FIG. 25B is a timing chart illustrating a trimming method to increase the threshold voltage Vt of the amplification transistor APT according to the eighth embodiment. FIG. 25C is a timing chart illustrating a trimming method to decrease the threshold voltage Vt of the amplification transistor APT according to the eighth embodiment.

For example, in a case where the potential of the read source line RSL is 0 V, if the potential of the local bit line LBL corresponding to data "1" is 0.7 V, the amplification transistor APT needs to be turned on (Vgs - Vt = 0.7 V - Vt > 0 V), and if the potential of the local bit line LBL corresponding to data "0" is 0 V, the amplification transistor APT needs to be turned off (Vgs - Vt = 0 V - Vt < 0 V). Thus, in order for the amplification transistor APT, which uses the local bit line LBL as its gate, to operate correctly, the operating condition is 0 V < Vt < 0.7 V. Varying the potential (voltage VRSL) of the read source line RSL makes it possible to adjust a gate-source voltage Vgs of the amplification transistor APT. In this case, the operating condition is 0 V < Vt + VRSL < 0.7 V. That is, if the threshold voltage Vt is high, the voltage VRSL needs only to be negative, and if it is low, the voltage VRSL needs only to be positive. It is possible to adjust the threshold voltage Vt by an annealing process after ion implantation of impurities into the silicon channel layer 21, or by adjusting the potential of the read source line RSL. On the other hand, in the present embodiment, the string selection signal layer of the 3D-NAND flash memory can be used as the gate electrode of the amplification transistor APT, so it is possible to adjust the threshold voltage Vt by injecting or emitting electrons into or from the charge-trapping layer 222 or the floating gate film. The amplification transistor APT formed by the pillar RP has a relatively small size, so the variation in the threshold voltage Vt is relatively large. For this reason, it is most desirable to measure the threshold voltage Vt of each amplification transistor APT, and if there is a deviation from the desired threshold voltage (Vt), adjust it individually by injecting or emitting electrons for each amplification transistor (APT) through a program operation, a verify operation, and an erase operation (this type of adjustment is also referred to as "trimming"). Using multiple layers of a plurality of string selection signal layers (the interconnect layers 14 that function as the local bit line LBL) to increase the effective channel area makes it also possible to suppress the variation.

FIG. 25A is a timing chart illustrating a method to measure the variation in the threshold voltage Vt of the amplification transistor APT. A condition for the amplification transistor APT to switch from an off state to an on state is "(potential of the local bit line LBL) - (potential of the read source line RSL) - threshold voltage Vt = 0 V". Thus, the measurement of the relationship between the potentials of the local bit line LBL and the read source line RSL and the on/off operation of the amplification transistor APT makes it possible to measure the threshold voltage Vt.

As illustrated in FIG. 25A, at time t0, a voltage VBLh is applied to the bit line BL. The voltage VBLh is a positive voltage. In this condition, if the potential of the local bit line LBL and the potential of the read source line RSL are set in advance, then in a case where the potential of the local bit line LBL is less than the threshold voltage Vt of the amplification transistor APT, the amplification transistor APT is turned off, and in a case where it is equal to or greater than the threshold voltage Vt, the amplification transistor APT is turned on. At time t1, the precharging to the bit line BL is terminated. If "potential of the local bit line LBL - read source potential - threshold voltage Vt" is positive (0 V or more), the amplification transistor APT is turned on, and the potential of the bit line BL drops. On the other hand, if it is negative (0 V or less), the amplification transistor APT is turned off and the potential of the bit line BL is maintained. Performing measurements while changing the potential of the local bit line LBL and the potential of the read source line RSL makes it possible to measure the threshold voltage Vt of the amplification transistor APT. For example, in a case where the RSL potential is swept from 0 V to negative while the potential of the local bit line LBL is kept at 0 V, if the threshold voltage Vt is 0.3 V, the potential of the bit line BL drops due to discharge once the RSL potential drops below -0.3 V, indicating that the threshold voltage Vt of the amplification transistor is currently 0.3 V.

If the desired threshold voltage Vt is higher than the measured threshold voltage Vt, it is necessary only to inject electrons into the charge-trapping layer 222 of the amplification transistor APT, and if the desired threshold voltage Vt is lower, it is necessary only for electrons to be emitted from the charge-trapping layer 222 of the amplification transistor APT. Any method can be used to adjust the threshold voltage Vt, and the following methods are included: the FN tunneling method to lower the threshold voltage Vt, by increasing a source voltage and a drain voltage by, for example, 15 V or higher than a gate voltage of the amplification transistor APT to emit electrons from the charge-trapping layer 222, the FN tunneling method to raise the threshold voltage Vt, by increasing the gate voltage by, for example, 15 V or higher than the source voltage and the drain voltage to inject electrons into the charge-trapping layer 222, and a method by a hot carrier effect to raise the threshold voltage Vt, by increasing the gate voltage higher than the source voltage and increasing the drain voltage higher than the gate voltage to inject electrons into the charge-trapping layer 222. These methods make it possible to adjust the threshold voltage Vt before product shipping out.

Referring to FIG. 25B, a method to increase the threshold voltage Vt of the amplification transistor APT for trimming is described. FIG. 25B is a timing chart illustrating a method to trim the threshold voltage Vt of the amplification transistor APT by injecting electrons using the hot carrier effect. In the description of FIG. 25B, the bit line BL and local bit line LBL corresponding to the amplification transistor APT into which electrons are injected to increase the threshold voltage Vt are referred to as "Program", and the bit line BL and local bit line LBL corresponding to the amplification transistor APT into which electrons are not injected to increase the threshold voltage Vt are referred to as "Non-prog".

As illustrated in FIG. 25B, at time t0, a voltage VBLPG1 (e.g., such as 15 V) is applied to the bit line BL ("Program"), and a voltage VWBSon (e.g., such as 10 V) is applied to the write control signal lines WBS0 and WBS1. The transistors WSTO and WST1 are turned on, and a voltage VLBLPG2 (e.g., 7 V) that is the threshold voltage drop of the transistors WSTO and WST1 is applied to the local bit line LBL ("Program"). As a result, for example, a drain-source voltage Vds of 15 V and a gate-source voltage Vgs of 7 V are applied to the amplification transistor APT corresponding to "Program", making it possible to inject electrons into the charge-trapping layer 222 by the hot carrier effect. In other words, a voltage higher than a source is applied to a gate of the amplification transistor APT corresponding to "Program", and a voltage higher than the gate is applied to a drain, making it possible to inject electrons into the charge-trapping layer 222 by the hot carrier effect. For non-selected bit lines BL ("Non-prog"), it is necessary only to apply a voltage VSS (e.g., 0 V), and in unselected gain blocks gBK, it is necessary only for the read control signal line RBS to be set to a low-level voltage (e.g., 0 V) to stop hot carriers.

Referring to FIG. 25C, a method to lower the threshold voltage Vt of the amplification transistor APT for trimming is described. FIG. 25C is a timing chart illustrating a method to trim all the amplification transistors APT by lowering their threshold voltages Vt using the Fowler-Nordheim (FN) tunneling technique during an erase operation, which emits electrons.

As illustrated in FIG. 25C, at time t0, a voltage VERASE is applied to the word lines WL and the string selection signal lines SGDT, SGD, and SGS. The voltage VERASE is a voltage that turns on the memory cells MC and the string selection transistors STT1, ST1, and ST2. This causes electrons in the local bit line LBL to be emitted to the source line SL. At this time, the potential of the local bit line LBL is, for example, 0 V.

Subsequently, at time t1, a voltage VH (e.g., 20 V) is applied to the read source line RSL to inject holes from the read source line RSL to the bit line BL through band-to-band tunneling, or the potential of the bit line BL is raised to the voltage VH (e.g., 20 V) to raise a source potential and a drain potential of the amplification transistor APT to the voltage VH (e.g., 20 V) higher than the gate potential (e.g., 0 V), thereby performing an erase operation that emits electrons from the charge-trapping layer 222 of the amplification transistor APT and lowering the threshold voltage Vt. For example, in a case where the potential of the local bit line LBL is 0 V and the potential of the bit line BL is 20 V, the high electric field difference between the bit line BL and the local bit line LBL can be gradually relaxed by applying a voltage VWBS of, for example, 10 V to the write control signal line WBS0 and the voltage VSS (e.g., 0 V) to the write control signal line WBS1.

### 9. Ninth Embodiment

The following describes a ninth embodiment. In the ninth embodiment, two examples of the method to perform trimming by raising the threshold voltage Vt of the amplification transistor APT, which differs from the eighth embodiment, are described. The following description focuses on differences from the first through eighth embodiments.

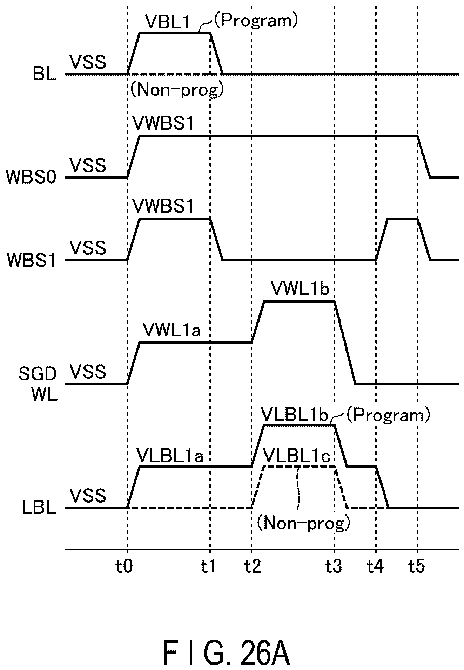

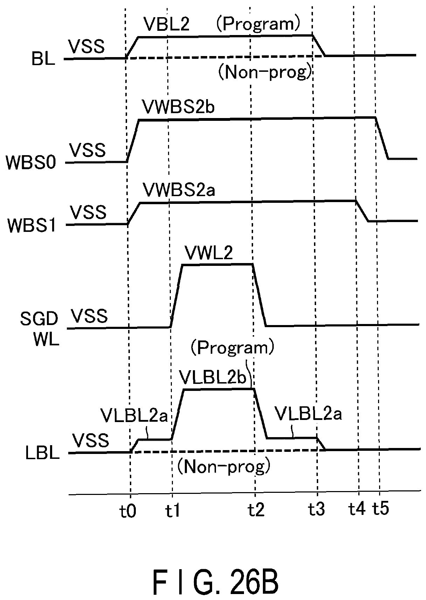

Referring to FIGS. 26A and 26B, the ninth embodiment is described. In the description of FIGS. 26A and 26B, the bit line BL and local bit line LBL corresponding to the amplification transistor APT that injects electrons to increase the threshold voltage Vt are referred to as "Program", and the bit line BL and local bit line LBL corresponding to the amplification transistor APT, which does not have its threshold voltage Vt increased without the injection of electrons, are referred to as "Non-prog".

Referring to FIG. 26A, a first example of the method to trim the threshold voltage Vt will now be described. FIG. 26A is a timing chart illustrating the first example of the trimming method to increase the threshold voltage Vt of the amplification transistor APT according to the ninth embodiment.

As illustrated in FIG. 26A, at time t0, a voltage VBL1 (e.g., 10 V) is applied to the bit line BL ("Program"). A voltage VWBS1 (e.g., 10 V) is applied to the write control signal lines WBS0 and WBS1. This causes the transistors WSTO and WST1 to be turned on. Furthermore, a voltage VWL1a (e.g., 10 V) is applied to the word lines WL and the string selection signal lines SGDT and SGD of the cell block CB. This turns on the memory cells MC and the string selection transistors STT1 and ST1. A voltage VLBL1a (e.g., an intermediate potential of approximately 10 V) is applied to the local bit line LBL ("Program") (and the silicon channel layer 21 coupled thereto). The voltage VLBL1a is a positive voltage lower than the voltage VWBS1.

Subsequently, at time t1, the voltage VSS is applied to the bit line BL ("Program"). The voltage VSS is applied to the write control signal line WBS1. This turns off the transistor WST1, suppressing the backflow of the charge precharged from the bit line BL to the local bit line LBL ("Program").

Subsequently, at time t2, a voltage VWL1b (e.g., 20 V) is applied to the word lines WL and the string selection signal lines SGDT and SGD of the cell block CB to boost them. The voltage VWL1b is higher than the voltage VWL1a. Using a gate-channel capacitance of the memory cell string MSR, the voltage of the local bit line LBL ("Program") is boosted to a voltage VLBL1b (e.g., approximately 19 V) by self-boosting. At this time, the voltage of the local bit line LBL ("Non-prog") is boosted to a voltage VLBL1c (e.g., approximately 9 V). The voltage VLBLlc is lower than the voltage VLBL1b. The voltage VSS (e.g., 0 V) is applied to the write control signal line WBS1. The voltage VSS is applied to the bit line BL and the read source line RSL. In this condition, a voltage VLBL1b (e.g., 19 V) is applied to a gate of the amplification transistor APT corresponding to the local bit line LBL ("Program"), and a voltage VSS (e.g., 0 V) is applied to a source and a drain. This allows the trimming to increase the threshold voltage Vt of the amplification transistor APT by electron injection using FN tunneling.

Subsequently, at time t3, after trimming is completed, the voltage VSS is applied to the word lines WL and the string selection signal lines SGDT and SGD. This also reduces the voltage of the local bit line LBL, which had been boosted by self-boosting.

Subsequently, at time t4, the voltage VWBS1 is applied to the write control signal line WBS1. This turns on the transistor WSTO, and electrons on the local bit line LBL are emitted to the bit line BL.

Subsequently, at time t5, the voltage VSS is applied to the write control signal lines WBS0 and WBS1.

Referring to FIG. 26B, a second example of the method to trim the threshold voltage Vt will now be described. FIG. 26B is a timing chart illustrating the second example of the trimming method to increase the threshold voltage Vt of the amplification transistor APT according to the ninth embodiment.

As illustrated in FIG. 26B, at time t0, a voltage VBL2 (e.g., 2 V) is applied to the bit line BL ("Program"), and the voltage VSS (e.g., 0 V) is applied to the bit line BL ("Non-prog"). A voltage VWBS2a (e.g., 2 V) and a voltage VWBS2b (e.g., 10 V) are applied to the write control signal lines WBS1 and WBS0, respectively. The voltage VWBS2a is, for example, the same voltage as the voltage VBL2. The voltage VWBS2b is a voltage higher than the voltage VWBS2a. As a result, a voltage VLBL2a is applied to the local bit line LBL ("Program"). The voltage VLBL2a is a voltage lower than the voltage VWBS2a.

Subsequently, at time t1, similar to the description of FIG. 26A, a voltage VWL2 (e.g., 20 V) is applied to a plurality of word lines WL and string selection signal lines SGDT and SGD of cell block CB to boost them. In a case of the bit line BL ("Non-prog"), the potential of local bit line LBL ("Non-prog") passes through to the bit line BL ("Non-prog"), so the potential of the local bit line LBL ("Non-prog") maintains the voltage VSS (e.g., 0 V). In contrast, in a case of the bit line BL ("Program"), for example, the voltage VBL2 and the voltage VWBS2a have the same value, so a gate-source voltage Vgs of the transistor WST1 becomes 0 V. Thus, in the transistor WST1, the backflow of charges from the local bit line LBL ("Program") to the bit line BL ("Program") is stopped. The local bit line LBL ("Program") is boosted to a voltage VBL2b (e.g., 18 V) by the self-boosting of the memory cell string MSR. In this condition, the voltage VBL2b (e.g., 18 V) is applied to a gate of the amplification transistor APT corresponding to the local bit line LBL ("Program"), the voltage VSS (e.g., 0 V) is applied to a source, and the voltage VBL2 (e.g., 2 V) is applied to a drain. This allows the trimming to increase the threshold voltage Vt of the amplification transistor APT by electron injection using FN tunneling. If it is desired to apply the voltage VBL2 (e.g., 2 V) to a drain of the amplification transistor APT corresponding to the local bit line LBL ("Non-prog"), a low-level voltage that turns off the transistor RST is applied to the read control signal line RBS, which turns off the transistor RST and the electrons in the bit line BL ("Non-prog") become blocked, causing a source of the amplification transistor APT to reach the same potential as a gate.

Subsequently, at time t2, after trimming is completed, the voltage VSS is applied to the word lines WL and the string selection signal lines SGDT and SGD. This also lowers the voltage of the local bit line LBL ("Program"), which had been boosted by self-boosting.

Subsequently, at time t3, the voltage VSS is applied to the bit line BL ("Program"). This also lowers the voltage of the local bit line LBL ("Program") to the voltage VSS.

Subsequently, at time t4, the voltage VSS is applied to the write control signal line WBS1.

Subsequently, at time t5, the voltage VSS is applied to the write control signal line WBS0.

### 10. Tenth Embodiment

The following describes a tenth embodiment. In the tenth embodiment, two examples of a method for trimming the threshold voltage Vt of the amplification transistor APT that differs from the eighth and ninth embodiments will be described. The following description focuses on differences from the first through ninth embodiments.

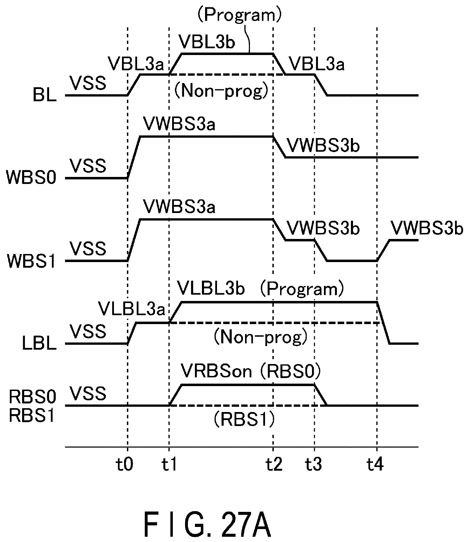

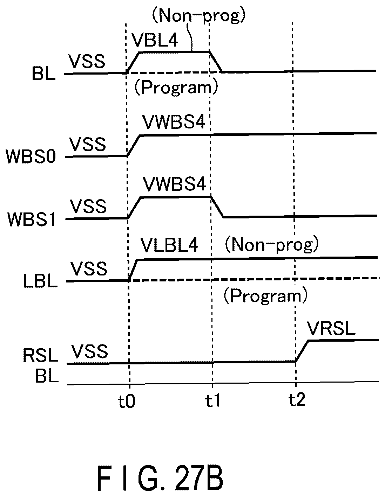

The tenth embodiment is described with reference to FIGS. 27A and 27B. In the description of FIGS. 27A and 27B, the bit line BL and local bit line LBL corresponding to the amplification transistor APT that injects electrons to increase the threshold voltage Vt are referred to as "Program", and the bit line BL and local bit line LBL corresponding to the amplification transistor APT, which does not have its threshold voltage Vt increased without the injection of electrons, are referred to as "Non-prog".

Referring to FIG. 27A, the method to perform trimming by increasing the threshold voltage Vt will now be described. FIG. 27A is a timing chart illustrating a trimming method to increase the threshold voltage Vt of the amplification transistor APT according to the tenth embodiment.

As illustrated in FIG. 27A, first, at time t0, a voltage VBL3a (e.g., 10 V) is applied to the bit lines BL ("Program") and BL ("Non-prog"). A voltage VWBS3a (e.g., 20 V) is applied to the write control signal lines WBS0 and WBS1. For example, the voltage VWBS3a is higher than the voltage VBL3a. The transistors WSTO and WST1 are turned on. As a result, a voltage VLBL3a is applied to the local bit lines LBL ("Program") and LBL ("Non-prog"). For example, the voltage VLBL3a has the same voltage value as the voltage VBL3a.

Subsequently, at time t1, a voltage VBL3b (e.g., 20 V) is applied to the bit line BL ("Program"). The voltage VBL3b is higher than the voltage VBL3a. As a result, a voltage VLBL3b (e.g., 19 V) is applied to the local bit line LBL ("Program"). The voltage VLBL3b is higher than the voltage VLBL3a. That is, a boosted potential is written from the bit line BL ("Program") to the local bit line LBL ("Program"). In addition, to maintain the bit line BL at 20 V (voltage VBL3b), the RST transistor needs to be turned off, but to maintain the withstand voltage of the transistor, two RST transistors controlled by read control signal lines RBS0 and RBS1 in series can be coupled below the APT transistor as illustrated in FIG. 27A. This allows the two series-coupled transistors RST to be turned off while gradually relaxing the potential difference of 20 V.

Subsequently, at time t2, the voltage VBL3a is applied to the bit line BL ("Program"). A voltage VWBS3b (e.g., 10 V) is applied to the write control signal lines WBS0 and WBS1. The voltage VWBS3b is lower than the voltage VWBS3a. The transistors WSTO and WST1 corresponding to the local bit line LBL ("Program") are set to a cut off state, so the local bit line LBL ("Program") maintains the voltage VLBL3b.

Subsequently, at time t3, the voltage VSS (e.g., 0 V) is applied to the bit lines BL ("Program") and BL ("Non-prog"), the write control signal line WBS1, and the read control signal lines RBS0 and RBS1. In this condition, the voltage VLBL3b (e.g., 19 V) is applied to a gate of the amplification transistor APT corresponding to the local bit line LBL ("Program"), the voltage VSS (e.g., 0 V) is applied to a source, and the voltage VSS (e.g., 0 V) is applied to a drain. This allows the trimming to increase the threshold voltage Vt of the amplification transistor APT by electron injection using FN tunneling. The write control signal lines WBS0 and WBS1 are adjusted stepwise at times t2 and t3 to relax the electric field, for example, so that a stress of 10 V or more is not applied.

Subsequently, at time t4, the voltage VWBS3b is applied to the write control signal line WBS1. This causes electrons on the local bit line LBL to be emitted to the bit line BL.

The following describes a trimming method to lower the threshold voltage Vt with reference to FIG. 27B. FIG. 27B is a timing chart illustrating the trimming method to lower the threshold voltage Vt of the amplification transistor APT according to the tenth embodiment.

As illustrated in FIG. 27B, first, at time t0, a voltage VBL4 (e.g., 10 V) is applied to the bit line BL ("Non-prog"). A voltage VWBS4 (e.g., 10 V) is applied to the write control signal lines WBS0 and WBS1. The transistors WSTO and WST1 are turned on. As a result, a voltage VLBL4 (e.g., 10 V) is applied to the local bit line LBL ("Non-prog"). The voltage VLBL4 can be the same voltage value as the voltage VBL4, or can be a voltage lower than the voltage VBL4.

Subsequently, at time t1, the voltage VSS (e.g., 0 V) is applied to the bit line BL ("Non-prog") and the write control signal line WBS1. The transistor WST1 is turned off. The local bit line LBL ("Program") holds the voltage VSS (e.g., 0 V), and the local bit line LBL ("Non-prog") holds the voltage VLBL4 (approximately 10 V).

Subsequently, at time t2, a voltage VRSL (e.g., approximately 20 V) is applied to the read source line RSL and the bit line BL. The threshold voltage Vt of the amplification transistor APT corresponding to the local bit line LBL ("Program") can be selectively lowered and trimmed by electron emission using FN tunneling. For example, the potential of the local bit line LBL is shifted in a range of 0 V to 10 V, so a boost trap is not required. In other words, in the method illustrated in FIG. 26B, for example, 0 V is applied to the bit line BL ("Program"), and for example, 2 V is applied to the bit line BL ("Non-prog"). Then, the word lines WL and the string selection signal lines SGDT and SGD are boosted, so the voltage of the local bit line LBL ("Program") is set to, for example, 0 V, and the voltage of the local bit line LBL ("Non-prog") is set to, for example, 10 V. In this condition, the read source line RSL and the bit line BL can be boosted to 20 V to selectively emit electrons from the charge-trapping layer 222, thereby lowering the threshold voltage Vt of the amplification transistor APT. For example, instead of 10 V, 2 V can be applied to the bit line BL, and as illustrated in FIG. 26B, the voltage of the local bit line LBL ("Non-prog") can be set to, for example, 10 V and the voltage of the local bit line LBL ("Program") can be set to, for example, 0 V by self-boosting.

### 11. Eleventh Embodiment

The following describes an eleventh embodiment. In the eleventh embodiment, two examples of a planar layout of a read port block RPB are described. The following description focuses on differences from the planar layout of the read port block RPB described using FIG. 5A and FIG. 5B in the first embodiment.

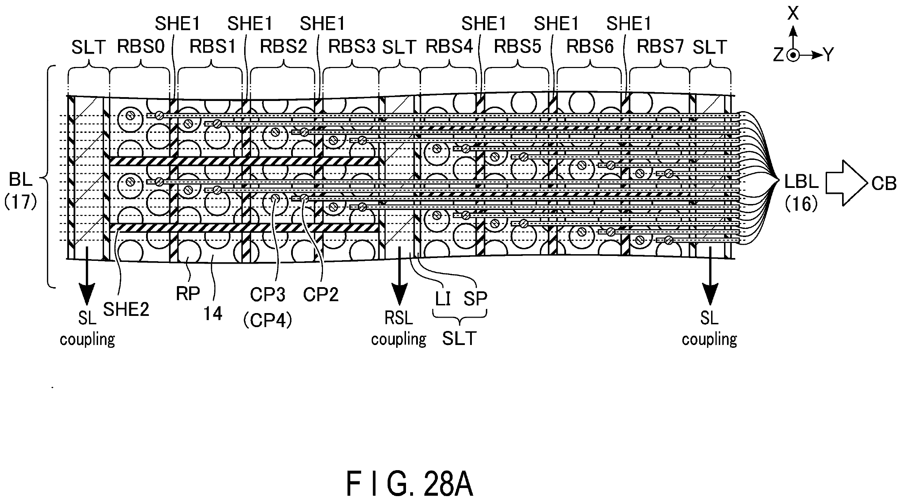

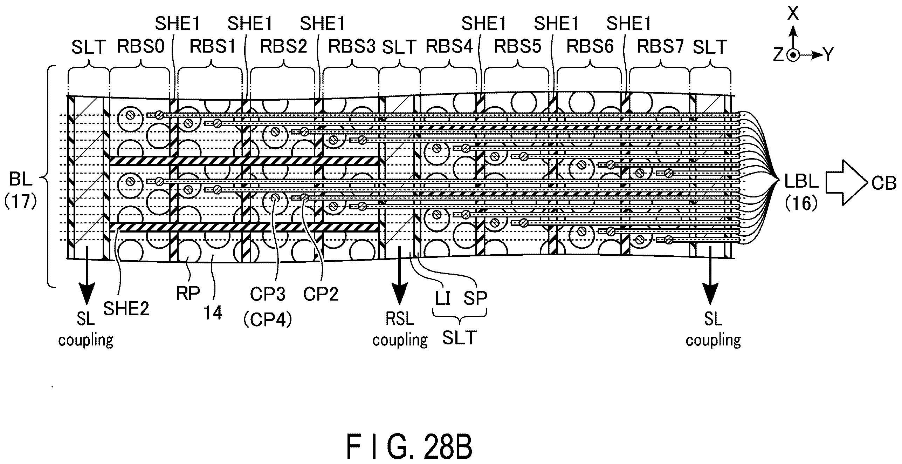

The eleventh embodiment is described with reference to FIG. 28A and FIG. 28B.

Referring to FIG. 28A, a first example of the planar layout of the read port block RPB will now be described. FIG. 28A is a plan view illustrating the first example of the planar layout of the read port block RPB according to the eleventh embodiment.

As illustrated in FIG. 28A, in the present embodiment, in the region between two members SLT adjacent in the Y direction, a plurality of pillars RP are arranged side by side in the X direction, for example, with a width of nine columns. The nine columns of memory pillars MP are arranged in a staggered manner such that the positions in the X direction of the memory pillars MP adjacent in the Y direction are different from each other. Three members SHE1 are provided between the two members SLT. That is, six members SHE1 are provided in the read port block RPB. As in FIG. 5A of the first embodiment, the six upper interconnect layers 14 that function as the local bit lines LBL or the read control signal lines RBS of the read port block RPB are divided into eight parts in the Y direction by the members SLT and SHE1. That is, the interconnect layers 14, which function as the local bit lines LBL or the read control signal lines RBS, are divided into eight in the Y direction. In the present embodiment, the eight read control signal lines RBS0 to RBS7 are arranged, for example, in the order of the read control signal lines RBS0 to RBS7 from the left side of the figure.

In the example illustrated in FIG. 28A, the first, third, fourth, and sixth members SHE1 from the left side of the figure are provided between two pillars RP adjacent in the Y direction. More specifically, the first member SHE1 from the left side of the figure is provided between the pillar RP in the second column and the pillar RP in the third column from the left side of the figure. The third member SHE1 from the left side of the figure is provided between the pillar RP in the seventh column and the pillar RP in the eighth column from the left side of the figure. The fourth member SHE1 from the left side of the figure is provided between the pillar RP in the 11th column and the pillar RP in the 12th column from the left side of the figure. The sixth member SHE1 from the left side of the figure is provided between the pillar RP in the 16th column and the pillar RP in the 17th column from the left side of the figure. The second and fifth members SHE1 from the left side of the figure are provided to divide the upper parts of the pillars RP in the 5th and 14th columns from the left side of the figure, respectively.

A plurality of interconnect layers 17 that function as the bit lines BL are electrically coupled to any of the pillars RP in the 1st, 3rd, 6th, 8th, 10th, 12th, 15th, and 17th columns from the left side of the figure.

The other configurations are similar to those of the first embodiment.

Referring to FIG. 28B, a second example of the planar layout of the read port block RPB will now be described. FIG. 28B is a plan view illustrating a second example of the planar layout of the read port block RPB according to the eleventh embodiment. The following description focuses on differences from the first example described with reference to FIG. 28A.

As illustrated in FIG. 28B, in this example, similar to FIG. 5B of the first embodiment, the pillar RP located near the contact plug CP2 in FIG. 28A is removed to make it easier to couple the contact plug CP2 to the interconnect layer 14 that functions as the local bit line LBL.

The present embodiment is similar to FIGS. 5A and 5B of the first embodiment, and has the same main effects. The difference is that in FIGS. 5A and 5B, the separation of the string selection signal layer (the interconnect layer 14 that functions as the local bit line LBL or the read control signal line RBS) using the member SHE1 is performed at the center of the pillars RP arranged side by side in the X direction. In contrast, in FIGS. 28A and 28B, some of the members SHE1 are provided between the pillars RP adjacent to each other in the Y direction. This has the effect of reducing a gate area of the amplification transistor APT and reducing a size of the read port block RPB.

### 12. Twelfth Embodiment

The following describes a twelfth embodiment. In the twelfth embodiment, a cross-sectional structure of the gain block gBK different from those of the first to eleventh embodiments is described. The following description focuses mainly on differences from the first to eleventh embodiments.

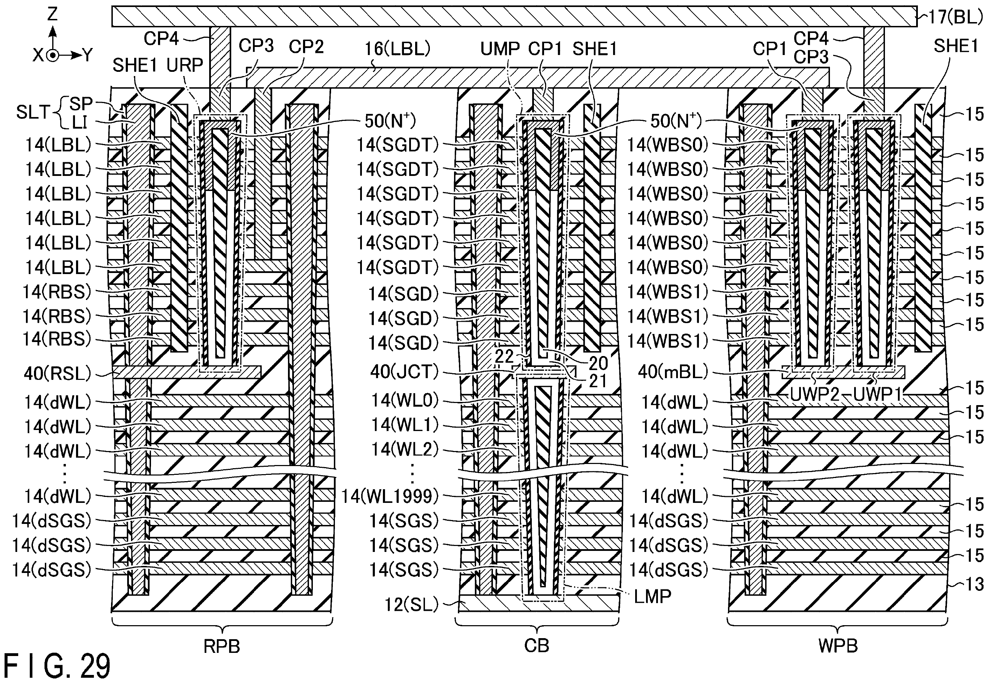

Referring to FIG. 29, the twelfth embodiment is described. FIG. 29 illustrates an example of a cross-sectional view of a gain block gBK according to the twelfth embodiment in the bit line direction (Y direction). FIG. 29 illustrates an example of a cross-sectional structure of a part of a cell block CB including a plurality of memory cell strings MSR coupled to one local bit line LBL, a write port block WPB that transmits the potential of a bit line BL to the local bit line LBL, and a read port block RPB that amplifies the potential of the local bit line LBL and transmits it to the bit line BL.

As illustrated in FIG. 29, in this example, three additional interconnect layers 14 (dummy string selection signal layers) are provided above the stacked layer (2009 interconnect layers 14) of the cell block CB, the read port block RPB, and the write port block WPB described using FIG. 19 of the fourth embodiment. More specifically, in the description using FIG. 19, six interconnect layers 14 are provided above the interconnect layer 40, but in this example, as illustrated in FIG. 29, nine interconnect layers 14 are provided above the interconnect layer 40. In other words, nine interconnect layers 14 (string selection signal layers) are provided above the interconnect layers 14 (word line layers) that function as the word lines WL or dummy word lines dWL.

In the cell block CB, the nine interconnect layers 14 provided above the interconnect layer 40 (JCT) function, from the upper layer side, as six string selection signal lines SGDT and three string selection signal lines SGD. The nine upper interconnect layers 14 that function as the string selection signal lines SGDT or the string selection signal lines SGD are divided for each string unit SU by the member SHE1 extending in the X direction. An upper memory pillar UMP is provided that penetrates the nine upper interconnect layers 14 and has a lower surface in contact with the interconnect layer 40. As in FIG. 19, the lower memory pillar LMP is provided under the interconnect layer 40. The lower memory pillar LMP penetrates 2000 interconnect layers 14 that function as word lines WL0 to WL1999 and three interconnect layers 14 that function as string selection signal lines SGS. In the present embodiment, an N⁺ diffusion layer 50 (diffusion layer region) is formed on the upper part of the silicon channel layer 21 in the upper memory pillar UMP. For example, in the N⁺ diffusion layer 50, phosphorus (P) or arsenic (As) is injected as an impurity into the silicon channel layer 21. For example, the N⁺ diffusion layer 50 is formed from a position near the same layer as the third interconnect layer 14 (string selection signal line SGDT) from the uppermost layer toward the top. That is, the N⁺ diffusion layer 50 is formed in the same layer as the three upper interconnect layers 14 (string selection signal line SGDT). The lower side of the N⁺ diffusion layer 50 can be located above the third interconnect layer 14 (string selection signal line SGDT) from the uppermost layer.

In the write port block WPB, the nine interconnect layers 14 provided above the interconnect layer 40 (mBL) function as six write control signal lines WBS0 and three write control signal lines WBS1 from the top. The nine upper interconnect layers 14 that function as the write control signal line WBS0 or the write control signal line WBS1 are divided by the member SHE1 extending in the X direction. The upper pillars UWP1 and UWP2 are provided, which penetrate the nine upper interconnect layers 14 and have their lower surfaces in contact with the interconnect layer 40. As with the upper memory pillar UMP, the N⁺ diffusion layer 50 is formed on the upper part of the silicon channel layer 21 in the upper pillars UWP1 and UWP2.

In the read port block RPB, the nine interconnect layers 14 provided above the interconnect layer 40 (RSL) function as six local bit lines LBL and three read control signal lines RBS from the top. The nine upper interconnect layers 14 that function as the local bit lines LBL or the read control signal lines RBS are separated by the member SHE1 extending in the X direction. In addition, the six upper interconnect layers 14 that function as the local bit lines LBL are electrically coupled to the interconnect layer 16 that functions as the local bit lines LBL via the contact plugs CP2. As with the upper memory pillars UMP and upper pillars UWP, the N⁺ diffusion layer 50 is formed on the top of the silicon channel layer 21 in the upper pillar URP.

In a case where the N⁺ diffusion layer 50 is formed at the contact portion with the local bit line LBL or the bit line BL by adding three interconnect layers 14 (dummy string selection signal layers) on the upper layer, it is not a problem even if the diffusion layer length of the N⁺ diffusion layer 50 varies and the lower end of the N⁺ diffusion layer 50 is located somewhere between the top layer and the first to third layers. This is because, in the memory pillar MP and the pillars WP and RP provided with the N⁺ diffusion layer 50, the threshold voltages Vt of the string selection transistor STT1, the transistor WSTO, and the amplification transistor APT corresponding to the interconnect layer 14 in the same layer as the N⁺ diffusion layer 50 are low and always in the ON state. Then, in practice, a control threshold voltages Vt of the string selection transistor STT1, the transistor WSTO, and the amplification transistor APT are respectively determined by the string selection transistor STT1, the transistor WSTO, and the amplification transistor APT corresponding to the interconnect layer 14 in the same layer as the non-doped silicon channel layer 21 in which the N⁺ diffusion layer 50 is not provided. This additional dummy string selection signal layer (interconnect layer 14) is applicable to all other embodiments. In the present embodiment, examples mentioned above are illustrated in which the read control signal line RBS and the write control signal lines WBS0 and WBS1 are all configured with three string selection signal layers (interconnect layers 14), but each signal line can be configured with one or two layers or can be configured with more than three layers.

### 13. Thirteenth Embodiment

The following describes a thirteenth embodiment. In the thirteenth embodiment, a cross-sectional structure of the gain block gBK different from that of the first through twelfth embodiments is described. The following description focuses on differences from the first through twelfth embodiments.

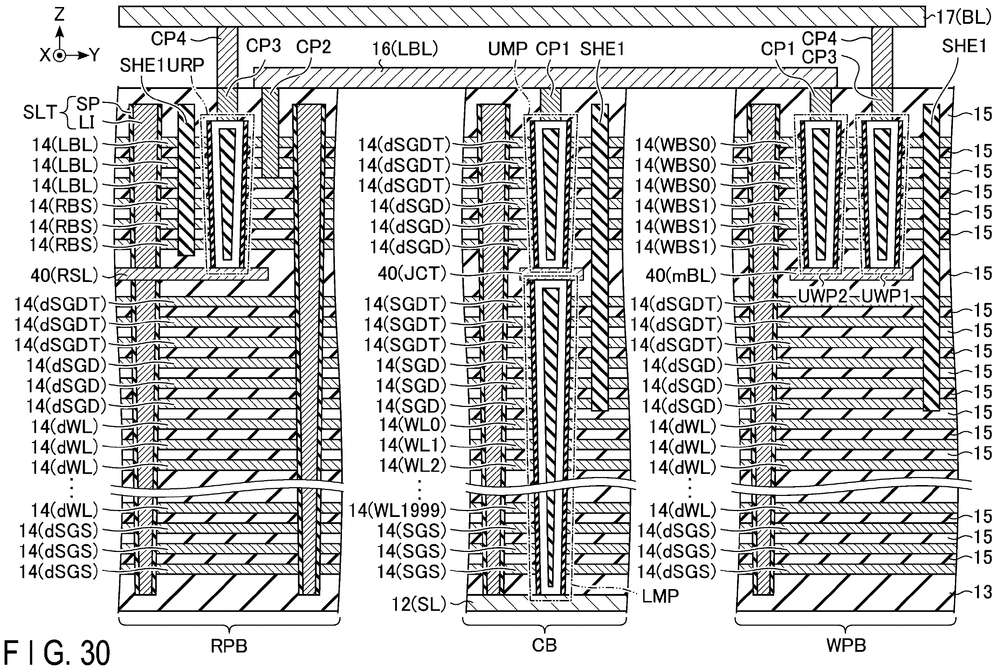

Referring to FIG. 30, the thirteenth embodiment is described. FIG. 30 illustrates an example of a cross-sectional view of a gain block gBK according to the thirteenth embodiment in the bit line direction (Y direction). FIG. 30 illustrates an example of a cross-sectional structure of a part of a cell block CB including a plurality of memory cell strings MSR coupled to one local bit line LBL, a write port block WPB that transmits the potential of a bit line BL to the local bit line LBL, and a read port block RPB that amplifies the potential of the local bit line LBL and transmits it to the bit line BL.

As illustrated in FIG. 30, in the present embodiment, a plurality of interconnect layers 14 that function as dummy string selection signal lines dSGD or dSGDT are additionally provided above the interconnect layer 14 that functions as the string selection signal line SGDT or SGD of the cell block CB. In the example illustrated in FIG. 30, the added six interconnect layers 14 are used for the dummy string selection signal line dSGDT or dSGD in the cell block CB, but in the write port block WPB, they are used for the write control signal line WBS0 or WBS1, and in the read port block RPB, they are used for the local bit line LBL or the read control signal line RBS.

More specifically, for example, in the cell block CB, the interconnect layer 40 is provided as a junction JCT above the interconnect layer 14 that functions as the string selection signal line SGDT. Above the interconnect layer 40, six interconnect layers 14 are provided, apart from each other in the Z direction. Of these six interconnect layers 14, the three upper layers function as the dummy string selection signal line dSGDT, and the lower three layers function as the dummy string selection signal line dSGD. The memory pillar MP includes an upper memory pillar UMP and a lower memory pillar LMP. The upper memory pillar UMP penetrates the six interconnect layers 14 that function as the dummy string selection signal line dSGDT or dSGD, and its lower surface is in contact with the interconnect layer 40. The lower memory pillar LMP penetrates the six interconnect layers 14 that function as the string selection signal line SGDT or SGD, 2000 interconnect layers 14 that function as the word lines WL0 to WL1999, and the three interconnect layers 14 that function as the string selection signal line SGS. The lower surface of the lower memory pillar LMP is in contact with the semiconductor layer 12, and the upper surface is in contact with the interconnect layer 40.

The member SHE1 divides the six interconnect layers 14 that function as the dummy string selection signal line dSGDT or dSGD and the six interconnect layers 14 that function as the string selection signal line SGDT or SGD in the Y direction.

In the write port block WPB, six interconnect layers 14 are provided above the interconnect layer 40 that functions as the middle bit line mBL, apart from each other in the Z direction. Of these six interconnect layers 14, the three top layers function as the write control signal line WBS0, and the three bottom layers function as the write control signal line WBS1. The pillars WP1 and WP2 each include upper pillars UWP1 and UWP2. The upper pillars UWP1 and UWP2 penetrate the six interconnect layers 14 that function as the write control signal line WBS0 or WBS1, and their lower surfaces contact the interconnect layer 40 (mBL). The lower pillars LWP1 and LWP2 are not provided. The six interconnect layers 14, which serve as the string selection signal line dSGDT or dSGD in the cell block CB, function as the write control signal line WBS0 or WBS1 in the write port block WPB. That is, each of the 2009 interconnect layers 14 located below the interconnect layer 40 (mBL) is treated as a dummy layer.

In the read port block RPB, six interconnect layers 14 are provided above the interconnect layer 40 that functions as the read source line RSL, apart from each other in the Z direction. Of these six interconnect layers 14, the three top layers function as the local bit line LBL, and the three bottom layers function as the read control signal line RBS. The pillars RP include upper pillars URP. The upper pillars URP penetrate the six interconnect layers 14 that function as the local bit line LBL or the read control signal line RBS, and their lower surfaces contact the interconnect layer 40 (RSL). No lower pillars LRP are provided. As in the write port block WPB, the six interconnect layers 14 that function as the string selection signal line dSGDT or dSGD in the cell block CB function as the local bit line LBL or the read control signal line RBS in the read port block RPB. That is, each of the 2009 interconnect layers 14 located below the interconnect layer 40 (RSL) is treated as a dummy layer.

In the write port block WPB, the interconnect layer 14 used as the write control signal line WBS0 or WBS1 can be selected optionally. Any layer of the stacked layer of a plurality of interconnect layers 14 can be used as the write control signal line WBS0 or WBS1. Additionally, in the read port block RPB, the interconnect layer 14 used as the local bit line LBL or the read control signal line RBS can be selected optionally. Any layer of the stacked layer of a plurality of interconnect layers 14 can be used as a gate electrode of the amplification transistor APT. The stacked layer is separated collectively by members such as SLT and SHE1, so even if the number of layer of stacked layer increases, the process cost does not increase significantly. By configuring the device in this manner, even if the number of stacked word lines is doubled, there is no decrease in the read speed and write speed, and furthermore, additional transistors dedicated to the read port block RPB and the write port block WPB are not required, so the bit cost can be significantly reduced as the number of stacked word lines is increased, enabling the implementation of faster 3D-NAND flash memory.

### 14. Fourteenth Embodiment

The following describes a fourteenth embodiment. In the fourteenth embodiment, a configuration of the non-volatile semiconductor memory device 1 different from the first through thirteenth embodiments is described. The following description focuses on differences from the first through thirteenth embodiments.

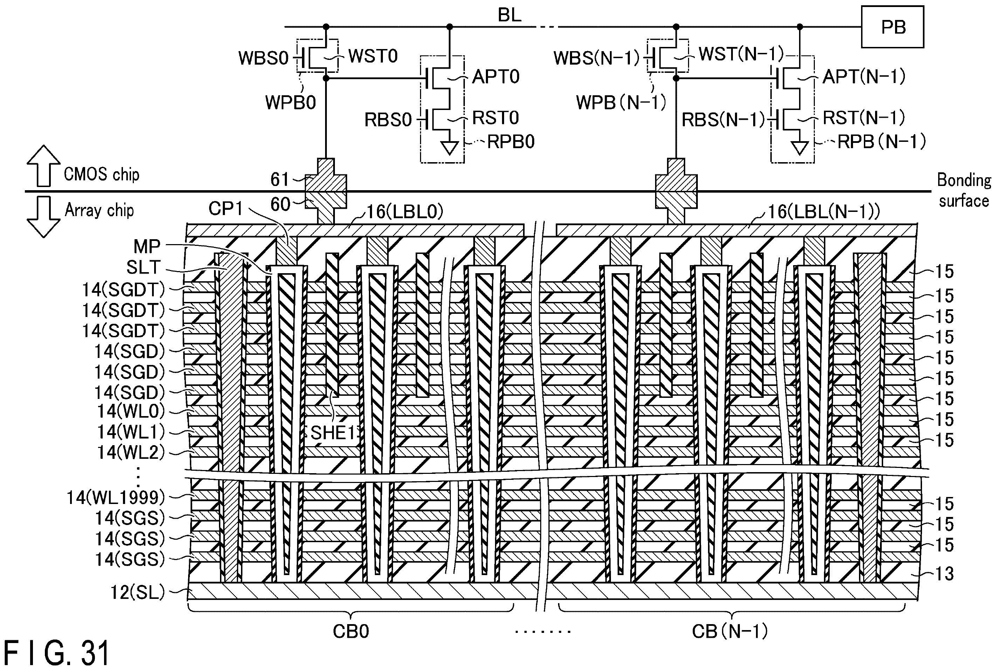

Referring to FIG. 31, the fourteenth embodiment is described. FIG. 31 illustrates an example of a cross-sectional structure of a gain block gBK in an array chip in the bit line direction (Y direction) and an example of a circuit configuration of a CMOS chip coupled to a local bit line LBL.

As illustrated in FIG. 31, the array chip includes a memory cell array MA. The memory cell array MA includes a plurality of cell blocks CB. Each cell block CB includes a plurality of interconnect layers 16 that function as local bit lines LBL and a plurality of memory pillars MP coupled to the respective interconnect layers 16. In other words, the memory cell array MA includes a plurality of cell blocks CB including a plurality of memory cell strings MSR coupled to the local bit lines LBL. The configuration of each cell block CB is similar to that described with reference to FIG. 3 of the first embodiment. In the example illustrated in FIG. 31, the memory cell array MA includes N (N is a natural number) cell blocks CB0 to CB(N-1). For example, the cell block CB0 includes a plurality of interconnect layers 16 that functions as the local bit line LBL0. Similarly, the cell block CB(N-1) includes a plurality of interconnect layers 16 that functions as the local bit line LBL(N-1).

The CMOS chip includes a write port block WPB that transmits the potential of the bit line BL to the local bit line LBL, and a read port block RPB that amplifies the potential of the local bit line LBL and transmits it to the bit line BL. In the example illustrated in FIG. 31, the CMOS chip includes N write port blocks WPB0 to WPB(N-1) and N read port blocks RPBO to RPB(N-1) corresponding to cell blocks CB0 to CB(N-1).

The write port block WPB0 includes a transistor WSTO. A drain of the transistor WSTO is coupled to the bit line BL. A source of the transistor WSTO is electrically coupled to a gate of the amplification transistor APT0 and the local bit line LBL0 of the cell block CB0. A gate of the transistor WSTO is coupled to a write control signal line WBS0. Similarly, the write port block WPB(N-1) includes a transistor WST(N-1). A drain of the transistor WST(N-1) is coupled to the bit line BL. A source of the transistor WST(N-1) is electrically coupled to a gate of the amplification transistor APT(N-1) and the local bit line LBL(N-1) of the cell block CB(N-1). A write control signal line WBS(N-1) is coupled to a gate of the transistor WST(N-1) .

The read port block RPB0 includes an amplification transistor APT0 and a transistor RST0. The amplification transistor APT0 and the transistor RST0 are coupled in series. A drain of the amplification transistor APT0 is coupled to the bit line BL. A source of the transistor RST0 is coupled to a specific power supply such as a read source line RSL, or is grounded. Similarly, the read port block RPB(N-1) includes an amplification transistor APT(N-1) and a transistor RST(N-1). The amplification transistor APT(N-1) and the transistor RST(N-1) are coupled in series. A drain of the amplification transistor APT(N-1) is coupled to the bit line BL. A source of the transistor RST(N-1) is coupled to a specific power supply such as the read source line RSL, or is grounded.

In the example illustrated in FIG. 31, the non-volatile semiconductor memory device 1 has a bonding structure in which an array chip and a CMOS chip are bonded together. More specifically, the array chip includes a plurality of electrode pads 60 provided on a surface facing the CMOS chip. The CMOS chip includes a plurality of electrode pads 61 provided on a surface facing the array chip. In the bonding structure, the electrode pads 60 and 61 are bonded together to form one bonding pad. In other words, a conductor included in the electrode pad 60 and a conductor included in the electrode pad 61 are bonded together. The bonding pad functions as an electrical current path between the array chip and the CMOS chip. The surface on which the array chip and the CMOS chip are bonded is also referred to as a "bonding surface". The non-volatile semiconductor memory device 1 does not need to have a bonding structure. The above-mentioned circuit on the CMOS chip side (including the write port block WPB and the read port block RPB) can be provided on the side of FEOL (transistor unit) of the same silicon substrate as the array chip. In this case, the local bit line LBL can be pulled down from the memory cell array MA to the side of FEOL, and the read port block RPB and the write port block WPB can be configured using bulk transistors formed on the silicon substrate.

The configuration according to the present embodiment eliminates the need to form the read port block RPB and the write port block WPB in the memory cell array MA, which leads to the suppression of the increase in the size of the memory cell array MA. In this case, in the CMOS chip (side of FEOL), the bit line BL with a fine interconnect pitch similar to that of the memory cell array MA is required, high-voltage transistors are required for the amplification transistor APT, a triple well configuration is required because each transistor in the write port block WPB and the read port block RPB is boosted during an erase operation, and a relatively large amplification transistor APT needs to be used or the threshold voltage Vt of the amplification transistor APT needs to be trimmed to suppress variations in the threshold voltage Vt of the amplification transistor APT. The amplification transistor APT does not have a charge-trapping layer 222, so it takes time to adjust the threshold voltage Vt.

### 15. Others

Various modifications are possible, not limited to the above-mentioned embodiment.

Furthermore, in the above-mentioned embodiment, the term "coupling" also includes a state in which other components, such as transistors or resistors, are interposed, resulting in an indirect coupling.

While certain embodiments have been described, these embodiments have been presented by way of example only, and are not intended to limit the scope of the inventions. Indeed, the novel devices and methods described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

Some or all of the embodiments described above can be described as in the following supplementary notes, but is not limited thereto:
[Supplementary Note 1] A non-volatile semiconductor memory device comprising:
   a plurality of first interconnect layers (14 in CB) extending in a first direction (X direction) and stacked apart from each other in a second direction (Z direction) intersecting the first direction;
   a memory pillar (MP) extending in the second direction and passing through the plurality of first interconnect layers;
   a local bit line (LBL) provided apart from the plurality of first interconnect layers at one end side in the second direction of the plurality of first interconnect layers, extending in a third direction (Y direction) intersecting the first direction and the second direction, and electrically coupled to the memory pillar at the one end side in the second direction of the memory pillar;
   a bit line (BL) provided apart from the local bit line at the one end side in the second direction of the local bit line and extending in the third direction;
   a plurality of second interconnect layers (14 in WPB) extending in the first direction, stacked apart from each other in the second direction, and arranged side by side with the plurality of first interconnect layers in the third direction;
   a first pillar (WP2) extending in the second direction, passing through the plurality of second interconnect layers, and electrically coupled to the local bit line at the one end side in the second direction;
   a second pillar (WP1) extending in the second direction and passing through the plurality of second interconnect layers, the second pillar being electrically coupled to the bit line at the one end in the second direction and being electrically coupled to the first pillar;
   a plurality of third interconnect layers (14 in RPB) extending in the first direction, stacked apart from each other in the second direction, and arranged side by side with the plurality of first interconnect layers in the third direction; and
   a third pillar (RP) extending in the second direction, passing through the plurality of third interconnect layers, and electrically coupled to the bit line at the one end in the second direction, wherein
   at least one of the plurality of third interconnect layers is electrically coupled to the local bit line.
[Supplementary Note 2] The non-volatile semiconductor memory device according to Supplementary Note 1, wherein
   each of the memory pillar and the first to third pillars includes:
   an insulator (20) extending in the second direction;
   a silicon channel layer (21) extending in the second direction and provided to surround the insulator;
   a tunnel-insulating layer (221) extending in the second direction and surrounding a lateral side of the silicon channel layer;
   a charge-trapping layer (222) extending in the second direction and surrounding a lateral side of the tunnel-insulating layer; and
   a block-insulating layer (223) extending in the second direction and surrounding a lateral side of the charge-trapping layer.
[Supplementary Note 3] The non-volatile semiconductor memory device according to Supplementary Note 1, wherein
   the memory pillar includes:
      an insulator (20) extending in the second direction;
      a silicon channel layer (21) extending in the second direction and provided to surround the insulator;
      a tunnel-insulating layer (221) extending in the second direction and surrounding a lateral side of the silicon channel layer;
      a charge-trapping layer (222) extending in the second direction and surrounding a lateral side of the tunnel-insulating layer; and
      a block-insulating layer (223) extending in the second direction and surrounding a lateral side of the charge-trapping layer, and
   each of the first to third pillars includes:
      a conductor (30) extending in the second direction;
      the insulator (20) extending in the second direction and provided to be in contact with the one end side in the second direction of the conductor;
      the silicon channel layer (21) extending in the second direction and provided to surround the conductor and the insulator;
      the tunnel-insulating layer (221) extending in the second direction and surrounding the lateral side of the silicon channel layer;
      the charge-trapping layer (222) extending in the second direction and surrounding the lateral side of the tunnel-insulating layer; and
      the block-insulating layer (223) extending in the second direction and surrounding the lateral side of the charge-trapping layer.
[Supplementary Note 4] The non-volatile semiconductor memory device according to Supplementary Note 1, further comprising:
   a first semiconductor layer (12, SL) provided apart from the plurality of first interconnect layers at an other end side in the second direction of the plurality of first interconnect layers and being in contact with the memory pillar at the other end side in the second direction of the memory pillar;
   a second semiconductor layer (12, bBL) provided apart from the plurality of second interconnect layers at the other end side in the second direction of the plurality of second interconnect layers and being in contact with the first pillar at the other end side in the second direction of the first pillar and the second pillar at the other end side in the second direction of the second pillar; and
   a third semiconductor layer (12, RSL) provided apart from the plurality of third interconnect layers at the other end side in the second direction of the plurality of third interconnect layers, located in a layer identical to the second semiconductor layer, and being in contact with the third pillar at the other end side in the second direction of the third pillar.
[Supplementary Note 5] The non-volatile semiconductor memory device according to Supplementary Note 1, further comprising:
   a fourth interconnect layer (40, mBL) provided between any of layers of the plurality of second interconnect layers in the second direction; and
   a fifth interconnect layer (40, RSL) provided between any of layers of the plurality of third interconnect layers in the second direction and located in a layer identical to the fourth interconnect layer, wherein
   the memory pillar includes:
      a lower memory pillar (LMP) that extends in the second direction; and
      an upper memory pillar (UMP) that extends in the second direction, is provided at the one end side in the second direction of the lower memory pillar, and is electrically coupled to the lower memory pillar,
   the first pillar includes a fourth pillar (UWP2) that extends in the second direction, is electrically coupled to the local bit line at the one end side in the second direction, and is in contact with the fourth interconnect layer at an other end side in the second direction,
   the second pillar includes a fifth pillar (UWP1) that extends in the second direction, is electrically coupled to the bit line at the one end side in the second direction, and is in contact with the fourth interconnect layer at the other end side in the second direction, and
   the third pillar includes a sixth pillar (URP) that extends in the second direction, is electrically coupled to the bit line at the one end side in the second direction, and is in contact with the fifth interconnect layer at the other end side in the second direction.
[Supplementary Note 6] The non-volatile semiconductor memory device according to Supplementary Note 2, wherein
   the silicon channel layer includes a diffusion layer region (50) provided on the one end side in the second direction of the silicon channel layer.
[Supplementary Note 7] The non-volatile semiconductor memory device according to Supplementary Note 2, wherein
   the block-insulating layer includes a ferroelectric material and performs polarization operation.
[Supplementary Note 8] The non-volatile semiconductor memory device according to Supplementary Note 2, wherein
   the block-insulating layer and the charge-trapping layer are ferroelectric layers.
[Supplementary Note 9] A non-volatile semiconductor memory device comprising:
   a page buffer (PB);
   a bit line (BL) coupled to the page buffer; and
   a plurality of gain blocks (gBK) coupled to the bit line, wherein
   the gain block includes:
      a local bit line (LBL);
      a cell block (CB) including a memory cell string (MSR) that includes a first string selection transistor (ST1), a plurality of memory cells (MC), and a second string selection transistor (ST2) coupled in series, one end of the memory cell string being coupled to the local bit line, an other end of the memory cell string being coupled to a source line (SL);
      a write port block (WPB) configured to transmit a potential of the bit line to the local bit line; and
      a read port block (RPB) configured to amplify and transmit a potential of the local bit line to the bit line.
[Supplementary Note 10] The non-volatile semiconductor memory device according to Supplementary Note 9, wherein
   the write port block includes:
   a first transistor (WSTO of WSR1) coupled to the bit line;
   a second transistor (WSTO of WSR2) coupled to the local bit line; and
   a first control signal line (WSTO) coupled to gates of the first transistor and the second transistor.
[Supplementary Note 11] The non-volatile semiconductor memory device according to Supplementary Note 9, wherein
   the read port block includes:
   a fourth transistor (APT) with one end coupled to the bit line and a gate coupled to the local bit line; and
   a fifth transistor (RST) with one end coupled to an other end of the fourth transistor, an other end coupled to a read source line (RSL), and a gate coupled to a second control signal line (RBS).
[Supplementary Note 12] The non-volatile semiconductor memory device according to Supplementary Note 11, wherein
   the fourth transistor has a threshold voltage higher than 0 V and lower than 0.7 V.
[Supplementary Note 13] The non-volatile semiconductor memory device according to Supplementary Note 11, wherein
   the fourth transistor includes a charge-trapping layer (222), and
   in a case of decreasing a threshold voltage of the fourth transistor, a first voltage (VSS) is applied to a gate, and a second voltage (VH) higher than the first voltage is applied to a source and a drain, causing electrons to be emitted from the charge-trapping layer.
[Supplementary Note 14] The non-volatile semiconductor memory device according to Supplementary Note 11, wherein
   the fourth transistor includes a charge-trapping layer (222), and
   in a case of increasing a threshold voltage of the fourth transistor, a third voltage (VSS) is applied to a source and a drain, and a fourth voltage (VLBL1b) higher than the third voltage is applied to a gate, causing electrons to be injected into the charge-trapping layer.
[Supplementary Note 15] The non-volatile semiconductor memory device according to Supplementary Note 11, wherein
   the fourth transistor includes a charge-trapping layer (222), and
   in a case of increasing a threshold voltage of the fourth transistor, a fifth voltage is applied to a source, a sixth voltage (VLBLPG2) higher than the fifth voltage is applied to a gate, and a seventh voltage (VBLPG1) higher than the sixth voltage is applied to a drain, causing electrons to be injected into the charge-trapping layer by a hot carrier effect.
[Supplementary Note 16] The non-volatile semiconductor memory device according to Supplementary Note 11, wherein
   in a read operation of a selected memory cell among the plurality of memory cells,
   in a case where the selected memory cell has a threshold voltage higher than a reference potential, the selected memory cell is turned off, a voltage of the local bit line increases higher than a threshold voltage of the fourth transistor, the fourth transistor is turned on, and a precharging of the bit line is terminated, leading to a decrease in a voltage of the bit line,
   in a case where the selected memory cell has a threshold voltage lower than the reference potential, the selected memory cell is turned on, the voltage of the local bit line decreases lower than the threshold voltage of the fourth transistor, the fourth transistor is turned off, and the precharging of the bit line is terminated, leading to no decrease in the voltage of the bit line.
[Supplementary Note 17] A non-volatile semiconductor memory device comprising:
   a cell block (CB) including:
      a plurality of first interconnect layers (14 in CB) extending in a first direction (X direction) and stacked apart from each other in a second direction (Z direction) intersecting the first direction;
      a memory pillar (MP) extending in the second direction and passing through the plurality of first interconnect layers; and
      a local bit line (LBL) provided apart from the plurality of first interconnect layers at one end side in the second direction of the plurality of first interconnect layers, extending in a third direction (Y direction) intersecting the first direction and the second direction, and electrically coupled to the memory pillar at the one end side in the second direction of the memory pillar;
   a page buffer (PB);
   a bit line (BL) coupled to the page buffer;
   a write port block (WPB) configured to transmit a potential of the bit line to the local bit line;
   a read port block (RPB) configured to amplify and transmit a potential of the local bit line to the bit line, wherein
   the memory pillar includes:
      an insulator (20) extending in the second direction,
      a silicon channel layer (21) extending in the second direction and provided to surround the insulator;
      a tunnel-insulating layer (221) extending in the second direction and surrounding a lateral side of the silicon channel layer;
      a charge-trapping layer (222) extending in the second direction and surrounding a lateral side of the tunnel-insulating layer; and
      a block-insulating layer (223) extending in the second direction and surrounding a lateral side of the charge-trapping layer.
[Supplementary Note 18] The non-volatile semiconductor memory device according to Supplementary Note 17, wherein
   the write port block includes a first transistor (WSTO) with one end coupled to the bit line, an other end coupled to the local bit line, and a gate coupled to a first control signal line (WBS).
[Supplementary Note 19] The non-volatile semiconductor memory device according to Supplementary Note 18, wherein
   the read port block includes:
   a second transistor (APT) with one end coupled to the bit line, and a gate coupled to an other end of the first transistor and the local bit line; and
   a third transistor (RST) with one end coupled to an other end of the second transistor, an other end coupled to a dedicated power supply, and a gate coupled to a second control signal line (RBS).
[Supplementary Note 20] The non-volatile semiconductor memory device according to Supplementary Note 17, further comprising:
   a first chip (CMOS chip) that includes the page buffer, the bit line, the write port block, and the read port block; and
   a second chip (array chip) that includes the cell block, wherein
   the first chip and the second chip are bonded together.

## Claims

1. A non-volatile semiconductor memory device comprising:
a plurality of first interconnect layers (14 in CB) extending in a first direction (X direction) and stacked apart from each other in a second direction (Z direction) intersecting the first direction;
a memory pillar (MP) extending in the second direction and passing through the plurality of first interconnect layers;
a local bit line (LBL) provided apart from the plurality of first interconnect layers at one end side in the second direction of the plurality of first interconnect layers, extending in a third direction (Y direction) intersecting the first direction and the second direction, and electrically coupled to the memory pillar at the one end side in the second direction of the memory pillar;
a bit line (BL) provided apart from the local bit line at the one end side in the second direction of the local bit line and extending in the third direction;
a plurality of second interconnect layers (14 in WPB) extending in the first direction, stacked apart from each other in the second direction, and arranged side by side with the plurality of first interconnect layers in the third direction;
a first pillar (WP2) extending in the second direction, passing through the plurality of second interconnect layers, and electrically coupled to the local bit line at the one end side in the second direction;
a second pillar (WP1) extending in the second direction and passing through the plurality of second interconnect layers, the second pillar being electrically coupled to the bit line at the one end in the second direction and being electrically coupled to the first pillar;
a plurality of third interconnect layers (14 in RPB) extending in the first direction, stacked apart from each other in the second direction, and arranged side by side with the plurality of first interconnect layers in the third direction; and
a third pillar (RP) extending in the second direction, passing through the plurality of third interconnect layers, and electrically coupled to the bit line at the one end in the second direction, wherein
at least one of the plurality of third interconnect layers is electrically coupled to the local bit line.

2. The non-volatile semiconductor memory device according to claim 1, wherein
each of the memory pillar and the first to third pillars includes:
an insulator (20) extending in the second direction;
a silicon channel layer (21) extending in the second direction and provided to surround the insulator;
a tunnel-insulating layer (221) extending in the second direction and surrounding a lateral side of the silicon channel layer;
a charge-trapping layer (222) extending in the second direction and surrounding a lateral side of the tunnel-insulating layer; and
a block-insulating layer (223) extending in the second direction and surrounding a lateral side of the charge-trapping layer.

3. The non-volatile semiconductor memory device according to claim 1, wherein
the memory pillar includes:
an insulator (20) extending in the second direction;
a silicon channel layer (21) extending in the second direction and provided to surround the insulator;
a tunnel-insulating layer (221) extending in the second direction and surrounding a lateral side of the silicon channel layer;
a charge-trapping layer (222) extending in the second direction and surrounding a lateral side of the tunnel-insulating layer; and
a block-insulating layer (223) extending in the second direction and surrounding a lateral side of the charge-trapping layer, and
each of the first to third pillars includes:
a conductor (30) extending in the second direction;
the insulator (20) extending in the second direction and provided to be in contact with the one end side in the second direction of the conductor;
the silicon channel layer (21) extending in the second direction and provided to surround the conductor and the insulator;
the tunnel-insulating layer (221) extending in the second direction and surrounding the lateral side of the silicon channel layer;
the charge-trapping layer (222) extending in the second direction and surrounding the lateral side of the tunnel-insulating layer; and
the block-insulating layer (223) extending in the second direction and surrounding the lateral side of the charge-trapping layer.

4. The non-volatile semiconductor memory device according to claim 1, further comprising:
a first semiconductor layer (12, SL) provided apart from the plurality of first interconnect layers at an other end side in the second direction of the plurality of first interconnect layers and being in contact with the memory pillar at the other end side in the second direction of the memory pillar;
a second semiconductor layer (12, bBL) provided apart from the plurality of second interconnect layers at the other end side in the second direction of the plurality of second interconnect layers and being in contact with the first pillar at the other end side in the second direction of the first pillar and the second pillar at the other end side in the second direction of the second pillar; and
a third semiconductor layer (12, RSL) provided apart from the plurality of third interconnect layers at the other end side in the second direction of the plurality of third interconnect layers, located in a layer identical to the second semiconductor layer, and being in contact with the third pillar at the other end side in the second direction of the third pillar.

5. The non-volatile semiconductor memory device according to claim 1, further comprising:
a fourth interconnect layer (40, mBL) provided between any of layers of the plurality of second interconnect layers in the second direction; and
a fifth interconnect layer (40, RSL) provided between any of layers of the plurality of third interconnect layers in the second direction and located in a layer identical to the fourth interconnect layer, wherein
the memory pillar includes:
a lower memory pillar (LMP) that extends in the second direction; and
an upper memory pillar (UMP) that extends in the second direction, is provided at the one end side in the second direction of the lower memory pillar, and is electrically coupled to the lower memory pillar,
the first pillar includes a fourth pillar (UWP2) that extends in the second direction, is electrically coupled to the local bit line at the one end side in the second direction, and is in contact with the fourth interconnect layer at an other end side in the second direction,
the second pillar includes a fifth pillar (UWP1) that extends in the second direction, is electrically coupled to the bit line at the one end side in the second direction, and is in contact with the fourth interconnect layer at the other end side in the second direction, and
the third pillar includes a sixth pillar (URP) that extends in the second direction, is electrically coupled to the bit line at the one end side in the second direction, and is in contact with the fifth interconnect layer at the other end side in the second direction.

6. The non-volatile semiconductor memory device according to claim 2, wherein
the silicon channel layer includes a diffusion layer region (50) provided on the one end side in the second direction of the silicon channel layer.

7. The non-volatile semiconductor memory device according to claim 2, wherein
the block-insulating layer includes a ferroelectric material and performs polarization operation.

8. The non-volatile semiconductor memory device according to claim 2, wherein
the block-insulating layer and the charge-trapping layer are ferroelectric layers.

9. A non-volatile semiconductor memory device comprising:
a page buffer (PB);
a bit line (BL) coupled to the page buffer; and
a plurality of gain blocks (gBK) coupled to the bit line, wherein
the gain block includes:
a local bit line (LBL);
a cell block (CB) including a memory cell string (MSR) that includes a first string selection transistor (ST1), a plurality of memory cells (MC), and a second string selection transistor (ST2) coupled in series, one end of the memory cell string being coupled to the local bit line, an other end of the memory cell string being coupled to a source line (SL);
a write port block (WPB) configured to transmit a potential of the bit line to the local bit line; and
a read port block (RPB) configured to amplify and transmit a potential of the local bit line to the bit line.

10. The non-volatile semiconductor memory device according to claim 9, wherein
the write port block includes:
a first transistor (WSTO of WSR1) coupled to the bit line;
a second transistor (WSTO of WSR2) coupled to the local bit line; and
a first control signal line (WSTO) coupled to gates of the first transistor and the second transistor.

11. The non-volatile semiconductor memory device according to claim 9, wherein
the read port block includes:
a fourth transistor (APT) with one end coupled to the bit line and a gate coupled to the local bit line; and
a fifth transistor (RST) with one end coupled to an other end of the fourth transistor, an other end coupled to a read source line (RSL), and a gate coupled to a second control signal line (RBS).

12. The non-volatile semiconductor memory device according to claim 11, wherein
the fourth transistor has a threshold voltage higher than 0 V and lower than 0.7 V.

13. The non-volatile semiconductor memory device according to claim 11, wherein
the fourth transistor includes a charge-trapping layer (222), and
in a case of decreasing a threshold voltage of the fourth transistor, a first voltage (VSS) is applied to a gate, and a second voltage (VH) higher than the first voltage is applied to a source and a drain, causing electrons to be emitted from the charge-trapping layer.

14. The non-volatile semiconductor memory device according to claim 11, wherein
the fourth transistor includes a charge-trapping layer (222), and
in a case of increasing a threshold voltage of the fourth transistor, a third voltage (VSS) is applied to a source and a drain, and a fourth voltage (VLBL1b) higher than the third voltage is applied to a gate, causing electrons to be injected into the charge-trapping layer.

15. The non-volatile semiconductor memory device according to claim 11, wherein
the fourth transistor includes a charge-trapping layer (222), and
in a case of increasing a threshold voltage of the fourth transistor, a fifth voltage is applied to a source, a sixth voltage (VLBLPG2) higher than the fifth voltage is applied to a gate, and a seventh voltage (VBLPG1) higher than the sixth voltage is applied to a drain, causing electrons to be injected into the charge-trapping layer by a hot carrier effect.

16. The non-volatile semiconductor memory device according to claim 11, wherein
in a read operation of a selected memory cell among the plurality of memory cells,
in a case where the selected memory cell has a threshold voltage higher than a reference potential, the selected memory cell is turned off, a voltage of the local bit line increases higher than a threshold voltage of the fourth transistor, the fourth transistor is turned on, and a precharging of the bit line is terminated, leading to a decrease in a voltage of the bit line,
in a case where the selected memory cell has a threshold voltage lower than the reference potential, the selected memory cell is turned on, the voltage of the local bit line decreases lower than the threshold voltage of the fourth transistor, the fourth transistor is turned off, and the precharging of the bit line is terminated, leading to no decrease in the voltage of the bit line.

17. A non-volatile semiconductor memory device comprising:
a cell block (CB) including:
a plurality of first interconnect layers (14 in CB) extending in a first direction (X direction) and stacked apart from each other in a second direction (Z direction) intersecting the first direction;
a memory pillar (MP) extending in the second direction and passing through the plurality of first interconnect layers; and
a local bit line (LBL) provided apart from the plurality of first interconnect layers at one end side in the second direction of the plurality of first interconnect layers, extending in a third direction (Y direction) intersecting the first direction and the second direction, and electrically coupled to the memory pillar at the one end side in the second direction of the memory pillar;
a page buffer (PB);
a bit line (BL) coupled to the page buffer;
a write port block (WPB) configured to transmit a potential of the bit line to the local bit line;
a read port block (RPB) configured to amplify and transmit a potential of the local bit line to the bit line, wherein
the memory pillar includes:
an insulator (20) extending in the second direction,
a silicon channel layer (21) extending in the second direction and provided to surround the insulator;
a tunnel-insulating layer (221) extending in the second direction and surrounding a lateral side of the silicon channel layer;
a charge-trapping layer (222) extending in the second direction and surrounding a lateral side of the tunnel-insulating layer; and
a block-insulating layer (223) extending in the second direction and surrounding a lateral side of the charge-trapping layer.

18. The non-volatile semiconductor memory device according to claim 17, wherein
the write port block includes a first transistor (WSTO) with one end coupled to the bit line, an other end coupled to the local bit line, and a gate coupled to a first control signal line (WBS).

19. The non-volatile semiconductor memory device according to claim 18, wherein
the read port block includes:
a second transistor (APT) with one end coupled to the bit line, and a gate coupled to an other end of the first transistor and the local bit line; and
a third transistor (RST) with one end coupled to an other end of the second transistor, an other end coupled to a dedicated power supply, and a gate coupled to a second control signal line (RBS).

20. The non-volatile semiconductor memory device according to claim 17, further comprising:
a first chip (CMOS chip) that includes the page buffer, the bit line, the write port block, and the read port block; and
a second chip (array chip) that includes the cell block, wherein
the first chip and the second chip are bonded together.
